(19) Europäisches Patentamt
European Patent Office
Office européen des brevets

(11) EP 4 580 359 A1

(12) EUROPEAN PATENT APPLICATION

(43) Date of publication:
**02.07.2025 Bulletin 2025/27**

(21) Application number: **24223027.4**

(22) Date of filing: **23.12.2024**

(51) International Patent Classification (IPC):
***H10K 50/19*** *(2023.01)* ***H10K 59/32*** *(2023.01)*

(52) Cooperative Patent Classification (CPC):
**H10K 59/32; H10K 50/19**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.12.2023 KR 20230193389**

(71) Applicant: **Samsung Display Co., Ltd.**
**Yongin-si, Gyeonggi-do 17113 (KR)**

(72) Inventors:
- **KIM, Seulong**
**17113 Yongin-si (KR)**
- **KIM, Yunjeong**
**17113 Yongin-si (KR)**
- **KIM, Jinyeong**
**17113 Yongin-si (KR)**
- **IM, Jahyun**
**17113 Yongin-si (KR)**
- **JU, Jongkuk**
**17113 Yongin-si (KR)**

(74) Representative: **Walaski, Jan Filip et al**
**Venner Shipley LLP**
**200 Aldersgate**
**London EC1A 4HD (GB)**

(54) **LIGHT EMITTING DEVICE AND ELECTRONIC APPARATUS INCLUDING THE SAME**

(57) A light-emitting device that includes a first electrode, a second electrode facing the first electrode, and an interlayer which may be located between the first electrode and the second electrode and may include an emission layer, wherein the interlayer may include m emitting units and m-1 charge generation units located between two adjacent emitting units among the m emitting units, m may be an integer of at least 2, and at least one of the m emitting units may include a first subpixel and a second subpixel, wherein the first subpixel and the second subpixel may satisfy Inequality 1.

[Inequality 1]

$$V_{on2} - V_{on1} \leq 0.2\ V.$$

EP 4 580 359 A1

## Description

CROSS-REFERENCE TO RELATED APPLICATIONS

This application claims priority to Korean Patent Application No. 10-2023-0193389 filed on 27 December 2023 in the Korean Intellectual Property Office.

BACKGROUND

1. Technical Field

The disclosure relates to a light-emitting device and an electronic apparatus including the same.

2. Description of the Related Art

Organic light-emitting devices among light-emitting devices are self-emissive devices that have wide viewing angles, high contrast, short response times, and excellent characteristics in terms of luminance, driving voltage, and response speed.

The organic light-emitting devices may have a structure in which a first electrode may be located on a substrate, and a hole transport region, an emission layer, an electron transport region, and a second electrode may be sequentially formed on the first electrode. Holes provided from the first electrode may move toward the emission layer through the hole transport region, and electrons provided from the second electrode may move toward the emission layer through the electron transport region. Carriers, such as the holes and the electrons, may recombine in the emission layer to produce excitons. These excitons may transition from an excited state to a ground state, thereby generating light.

SUMMARY

One or more embodiments include a light-emitting device with reduced leakage current (e.g. lateral leakage current) inside the light-emitting device and improved efficiency, color purity, and lifetime characteristics, and an electronic apparatus and a consumer product including the light-emitting device.

Additional aspects will be set forth in part in the description which follows and, in part, will be apparent from the description, or may be learned by practice of the presented embodiments of the disclosure.

According to one or more embodiments, a light-emitting device may include a first electrode, a second electrode facing the first electrode, and an interlayer located between the first electrode and the second electrode,

wherein the interlayer may include m emitting units, and m-1 charge generation units located between two adjacent emitting units among the m emitting units,
m may be an integer of at least 2,
at least one of the m emitting units may include a first subpixel and a second subpixel, and
the first subpixel and the second subpixel may satisfy Inequality 1:

[Inequality 1]

$$V_{on2} - V_{on1} \leq 0.2\ V$$

wherein, in Inequality 1,
$V_{on1}$ may be a turn-on voltage of the first subpixel,
$V_{on2}$ may be a turn-on voltage of the second subpixel,
the turn-on voltage of the first subpixel may be a voltage applied to the subpixel in case that the luminance of the first subpixel is 1 nit, and
the turn-on voltage of the second subpixel may be a voltage applied to the subpixel in case that the luminance of the second subpixel is 1 nit.

A maximum emission wavelength of the first subpixel may be longer than a maximum emission wavelength of the second subpixel.

The first subpixel and the second subpixel may satisfy Inequality 2 of $V_{on2} - V_{on1} < 0.2$ V.

A distance between the first subpixel and the second subpixel may be in a range of about 10 μm to about 35 μm.

The at least one of the m emitting units may further include a third subpixel, and the second subpixel and the third

subpixel may satisfy Inequality 3 of $V_{on3} - V_{on2} \leq 0.2$ V, in Inequality 3, $V_{on2}$ may be a turn-on voltage of the second subpixel, $V_{on3}$ may be a turn-on voltage of the third subpixel, the turn-on voltage of the second subpixel may be a voltage applied to the second subpixel in case that a luminance of the second subpixel is 1 nit, and the turn-on voltage of the third subpixel may be a voltage applied to the third subpixel in case that a luminance of the third subpixel is 1 nit.

A maximum emission wavelength of the second subpixel may be longer than a maximum emission wavelength of the third subpixel.

The first subpixel may be a red subpixel, the second subpixel may be a green subpixel, and the third subpixel may be a blue subpixel.

The m emitting units may each include a first emitting unit and a second emitting unit, the first emitting unit may include a first light-emitting region, the second emitting unit may include a second light-emitting region, the first light-emitting region and the second light-emitting region may include the first subpixel and the second subpixel, respectively, the m-1 charge generation units may include a first charge generation unit, and the first charge generation unit may include a first n-type charge generation layer and a first p-type charge generation layer.

The first emitting unit may further include a first hole transport region located between the first electrode and the first light-emitting region, the first hole transport region and the first p-type charge generation layer may each include a charge-generating dopant, and the charge-generating dopant may satisfy Inequality 11 of LUMO(CGD) < -5.0 eV, in Inequality 11, LUMO(CGD) may be a lowest unoccupied molecular orbital (LUMO) energy level of the charge-generating dopant.

The first hole transport region may include a first hole injection layer in direct contact with the first electrode, and a content of the charge-generating dopant in the first hole injection layer may be at least twice a content of the charge-generating dopant in the first p-type charge generation layer.

The first hole transport region may include a first hole injection layer in direct contact with the first electrode, and a thickness of the first hole injection layer may be at least twice a thickness of the first p-type charge generation layer of the first charge generation unit.

The first subpixel of the second light-emitting region may include a second red emission layer, the second subpixel of the second light-emitting region may include a second green emission layer, and the second light-emitting region further may include a second emission auxiliary layer in direct contact with the second red emission layer.

The second emission auxiliary layer may be in direct contact with the first p-type charge generation layer.

The first subpixel and the second subpixel may each include an emission layer, the emission layer may include a host and a dopant, and a content of the host may be greater than a content of the dopant based on a weight of the emission layer.

The dopant may be a fluorescent dopant, a phosphorescent dopant, a delayed fluorescence dopant, or any combination thereof.

Each of the m emitting units may further include a hole transport region and/or an electron transport region, the hole transport region may include at least one selected from a hole injection layer, a hole transport layer, a buffer layer, an emission auxiliary layer, and an electron blocking layer, and the electron transport region may include at least one selected from a hole blocking layer, an electron transport layer, and an electron injection layer.

According to one or more embodiments, an electronic apparatus may include the light-emitting device.

The electronic apparatus may further include a thin-film transistor, the thin-film transistor may include a source electrode and a drain electrode, and the first electrode of the light-emitting device may be electrically connected to at least one of the source electrode and the drain electrode of the thin-film transistor.

According to one or more embodiments, a consumer product (e.g. an electronic equipment) may include the light-emitting device.

The consumer product may be a flat panel display, a curved display, a computer monitor, a medical monitor, a television, an advertisement board, an indoor light, an outdoor light, a signal light, a head-up display, a fully transparent display, a partially transparent display, a flexible display, a rollable display, a foldable display, a stretchable display, a laser printer, a telephone, a mobile phone, a tablet computer, a phablet, a personal digital assistant (PDA), a wearable device, a laptop, a digital camera, a camcorder, a viewfinder, a micro display, a three-dimensional (3D) display, a virtual reality display, an augmented reality display, a vehicle, a video wall with multiple displays tiled together, a theater screen, a stadium screen, a phototherapy device, or a signboard.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic view of an organic light-emitting device according to an embodiment;
FIG. 2 is a schematic view of an organic light-emitting device according to an embodiment;

FIG. 3 is a schematic view of an organic light-emitting device according to an embodiment;
FIG. 4 shows a schematic view of an electronic apparatus according to an embodiment;
FIG. 5 shows a schematic view of an electronic apparatus according to an embodiment;
FIG. 6 is a schematic perspective view of electronic equipment including an organic light-emitting device according to an embodiment;
FIG. 7 is a schematic view of the exterior of a vehicle as electronic equipment including an organic light-emitting device according to an embodiment; and
FIGS. 8A to 8C are schematic views of the interior of a vehicle according to various embodiments.

DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when

used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

A light-emitting device according to an aspect may include a first electrode; a second electrode facing the first electrode; and an interlayer located between the first electrode and the second electrode ,

wherein the interlayer may include m emitting units; and m-1 charge generation units located between two adjacent emitting units among the m emitting units,
m may be an integer of 2 or more,
at least one of the m emitting units may include a first subpixel and a second subpixel, and
the first subpixel and the second subpixel may satisfy Inequality 1:

[Inequality 1]

$$V_{on2} - V_{on1} \leq 0.2 \text{ V}$$

wherein in Inequality 1,
$V_{on1}$ may be a turn-on voltage of the first subpixel,
$V_{on2}$ may be a turn-on voltage of the second subpixel,
the turn-on voltage of the first subpixel may be a voltage applied to the first subpixel in case that the luminance of the first subpixel is 1 nit, and
the turn-on voltage of the second subpixel may be a voltage applied to the second subpixel in case that the luminance of the second subpixel is 1 nit.

Generally, in the case of a light-emitting device including two or more subpixels, it may be desirable to control lateral leakage current between each subpixel to prevent it from occurring. The lateral leakage current between subpixels of the light-emitting device may be expressed by Equation L:

[Equation L]

$$I = \frac{V}{R} = \frac{VA}{\rho L}$$

(V: voltage, R: resistance, p: resistivity, L: distance between subpixels, A: area).

Referring to Equation L, it can be seen that the lateral leakage current can be reduced by increasing the subpixel pitch. However, as the subpixel pitch increases, there may be a disadvantage in terms of aperture ratio and may have a negative impact on the lifetime of the light-emitting device. Therefore, to implement a high-quality light-emitting device, it may be desirable to configure the light-emitting device to reduce the lateral leakage current while maintaining the subpixel pitch in a certain range.

In the light-emitting device according to an embodiment, in case that the turn-on voltages of the first subpixel and the second subpixel satisfy the relationship of Inequality 1 to minimize the gap in the turn-on voltages of the device, color mixing can be prevented by minimizing the turning on of the first subpixel in case that the second subpixel is turned on due to the same level of turn-on voltage even if a certain amount of leakage current exists. In case that the resistivity in the lateral direction is increased while maintaining the subpixel pitch in a certain range, the lateral leakage current between subpixels can be reduced, thereby preventing the color mixing phenomenon of the light-emitting device and improving color purity, efficiency, and lifetime.

The specific range of the resistivity in the lateral direction may be different depending on each layer included in the light-emitting device. For example, in the light-emitting device according to an embodiment, the resistivity of a hole injection layer (for example, a first hole injection layer or a p-type charge injection layer (pHIL)) may be $10^4$ Ωm or more, the resistivity of an n-type charge generation layer may be $10^6$ Ωm or more, and the resistivity of a p-type charge generation layer may be $10^3$ Ωm or more based on a single layer with a pixel pitch of about 20 μm. In case that the range is satisfied, the light-emitting device according to an embodiment can prevent a color mixing phenomenon and improve color purity, efficiency, and lifetime.

In the light-emitting device according to an embodiment, the turn-on voltage, that is, a driving voltage at a luminance of 1 nit, rather than a driving voltage at high luminance, which may be the generally required luminance of the first and second subpixels, may satisfy the relationship of Inequality 1, thereby preventing the color mixing phenomenon of the light-emitting device at low gray scale, and improving color purity and efficiency. Accordingly, the light-emitting device according to an embodiment can express an excellent image even at low gray scale and/or extremely low luminance.

According to an embodiment, the maximum emission wavelength of the first subpixel may be longer than the maximum emission wavelength of the second subpixel.

According to an embodiment, the first subpixel and the second subpixel may satisfy Inequality 2:

[Inequality 2]

$$V_{on2} - V_{on1} < 0.2 \text{ V}.$$

According to an embodiment, the distance between the first subpixel and the second subpixel may be in a range of about 10 μm to about 35 μm. For example, the distance between the first subpixel and the second subpixel may be in a range of about 12 μm to about 30 μm. In the range described above, the lateral leakage current of the light-emitting device can be reduced, thereby preventing the color mixing phenomenon of the light-emitting device and improving color purity, efficiency, and lifetime. For example, in case that the distance between the first subpixel and the second subpixel is less than about 10 μm, there may be a physical difficulty in manufacturing the light-emitting device, and in case that the distance between the first subpixel and the second subpixel is more than about 35 μm, the size of the subpixel has to be reduced, the lifetime may be significantly lowered (e.g., about 30 % or more), and the driving voltage may also increase (e.g., about 2 V or more), which may significantly deteriorate the light-emitting device characteristics.

According to an embodiment, at least one of the m emitting unit may further include a third subpixel.

According to an embodiment, the second subpixel and the third subpixel may satisfy Inequality 3:

[Inequality 3]

$$V_{on3} - V_{on2} \leq 0.2 \text{ V}$$

wherein in Inequality 3,

$V_{on2}$ may be a turn-on voltage of the second subpixel,

$V_{on3}$ may be a turn-on voltage of the third subpixel,
the turn-on voltage of the second subpixel may be a voltage applied to the subpixel in case that the luminance of the second subpixel is 1 nit, and
the turn-on voltage of the third subpixel may be a voltage applied to the third subpixel in case that the luminance of the third subpixel is 1 nit.

According to an embodiment, the maximum emission wavelength of the second subpixel may be longer than the maximum emission wavelength of the third subpixel.
According to an embodiment, the distance between two adjacent subpixels of the first subpixel, the second subpixel, and the third subpixel may be in a range of about 10 μm to about 35 μm. For example, the distance between two adjacent subpixels of the first subpixel, the second subpixel, and the third subpixel may be in a range of about 12 μm to about 30 μm.
According to an embodiment, the first subpixel may be a red subpixel, the second subpixel may be a green subpixel, and the third subpixel may be a blue subpixel.
According to an embodiment, a pixel defining layer may be located between two adjacent subpixels of the first subpixel, the second subpixel, and the third subpixel.
According to an embodiment, the pixel defining layer may have a surface shape such as an approximately flat structure, a concave-convex structure, a trench structure, or a tapered structure.
According to an embodiment, the pixel defining layer may be formed as a monolayer or multilayer.
According to an embodiment, the m emitting units may include a first emitting unit and a second emitting unit.
According to an embodiment, the area where the emission layer may be arranged in each emitting unit may be referred to as a light-emitting region . For example, the first emitting unit may include a first light-emitting region, and the second emitting unit may include a second light-emitting region. Details on the emission layer may be the same as described herein.
According to an embodiment, the first emitting unit and the second emitting unit may include a first subpixel and a second subpixel, respectively.
According to an embodiment, the first emitting unit may further include a first hole transport region located between the first electrode and the first light-emitting region.
According to an embodiment, the first hole transport region may be adjacent to the first electrode.
According to an embodiment, the m-1 charge generation units may include a first charge generation unit.
According to an embodiment, the first charge generation unit may include a first n-type charge generation layer and a first p-type charge generation layer.
According to an embodiment, the first hole transport region and the first p-type charge generation layer may each include a charge-generating dopant.
According to an embodiment, the charge-generating dopant may satisfy Inequality 11:

[Inequality 11]

$$\mathrm{LUMO(CGD)} < -5.0\ \mathrm{eV}$$

wherein, in Inequality 11, LUMO(CGD) may be the lowest unoccupied molecular orbital (LUMO) energy level of the charge-generating dopant.
According to an embodiment, the charge-generating dopant may be a compound represented by Formula 1:

[Formula 1]

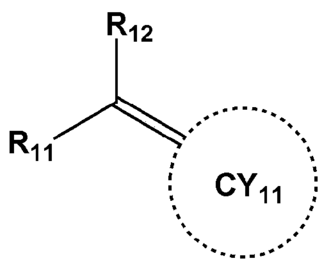

.

In Formula 1,

$CY_{11}$ may be a $C_3$-$C_{60}$ carbocyclic group or a $C_1$-$C_{60}$ heterocyclic group, each unsubstituted or substituted with at least

one $R_{10}$, and

$R_{10}$ to $R_{12}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$. $R_{10a}$ and $Q_1$ to $Q_3$ may each be the same as described herein.

According to an embodiment, the charge-generating dopant may be represented by any one of Formulae 1-1 to 1-6:

[Formula 1-1]

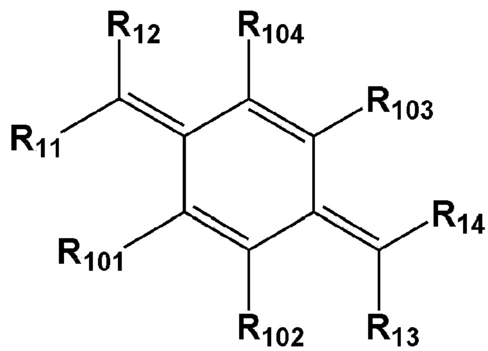

[Formula 1-2]

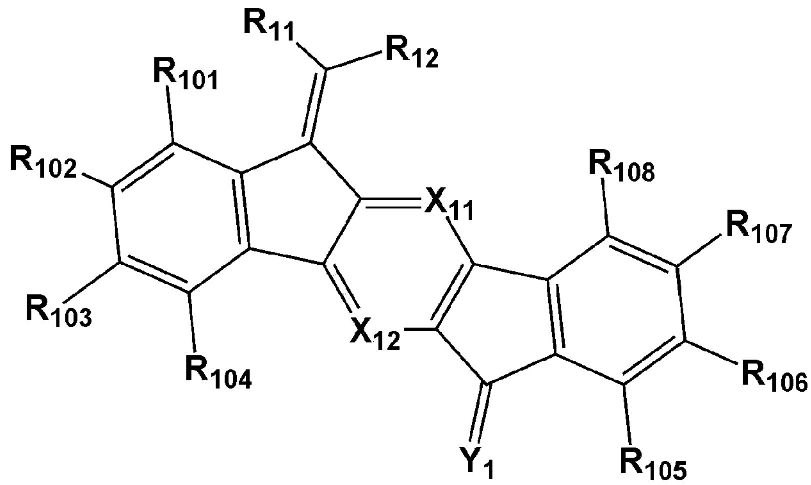

[Formula 1-3]

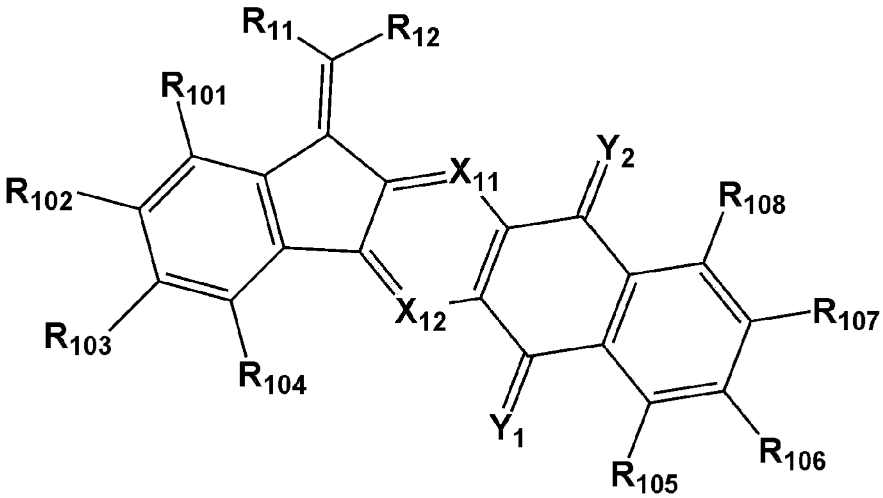

[Formula 1-4]

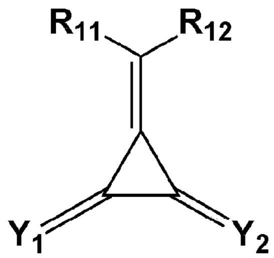

[Formula 1-5]

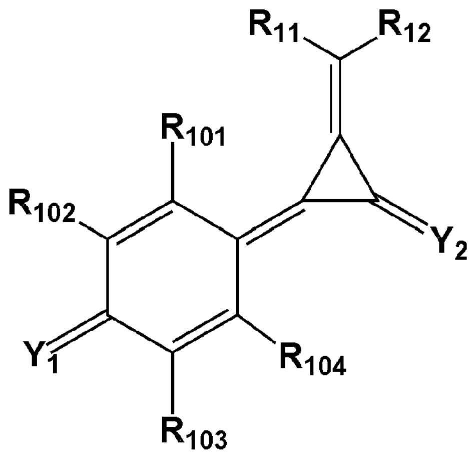

[Formula 1-6]

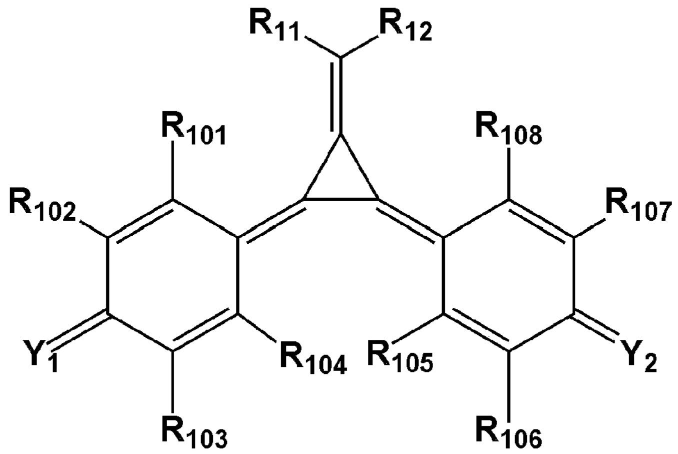

In Formulae 1-1 to 1-6,

$R_{11}$ and $R_{12}$ may be the same as described herein,
$X_{11}$ and $X_{12}$ may each independently be $C(R_{13})$ or N,
$Y_1$ and $Y_2$ may each independently be $C(E_1)(E_2)$, $N(E_1)$, O, S, Se, S(=O), or $S(=O)_2$,
$E_1$ and $E_2$ may each independently be an electron-withdrawing group, and
$R_{13}$, $R_{14}$, and $R_{101}$ to $R_{108}$ may each independently be the same as described herein with respect to $R_{10}$.

According to an embodiment, the electron-withdrawing group may be:

-F, -Cl, -Br, -I, or a cyano group;
a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, or a $C_6$-$C_{60}$ arylthio group, each substituted with -F, -Cl, -Br, -I, a cyano group, or any combination thereof;
a n electron deficient $C_1$-$C_{60}$ cyclic group unsubstituted or substituted with at least one $R_{10a}$; or
a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, or a $C_6$-$C_{60}$ arylthio group, each substituted with a n electron-deficient $C_1$-$C_{60}$ cyclic group unsubstituted or substituted with at least one $R_{10a}$. $R_{10a}$ may be the same as described herein.

According to an embodiment, the term "n electron deficient $C_1$-$C_{60}$ cyclic group" may be:

a 5 to 7-membered heteromonocyclic group having at least one *-N=*' moiety,
a heteropolycyclic group in which two or more of the 5 to 7-membered heteromonocyclic groups having at least one *-N=*' moiety are condensed with each other, or
a heteropolycyclic group in which at least one of the 5 to 7-membered heteromonocyclic groups having at least one *-N=*' moiety, and at least one $C_5$-$C_{60}$ carbocyclic group are condensed with each other.

According to an embodiment, the charge-generating dopant may each independently be one of Compounds CGP1 to CGP59:

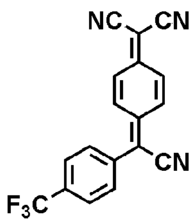

**CGP1**

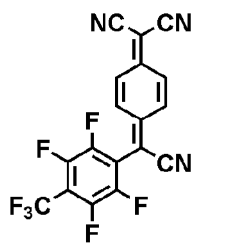

**CGP2**

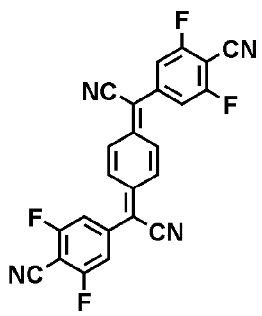

**CGP3**

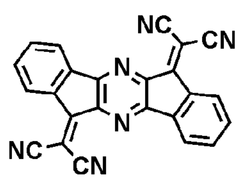

**CGP4**

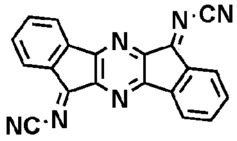

CGP5

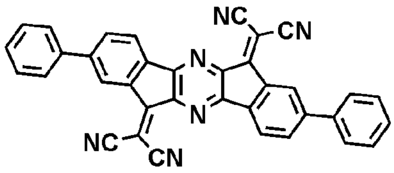

CGP6

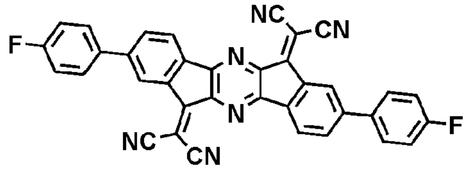

CGP7

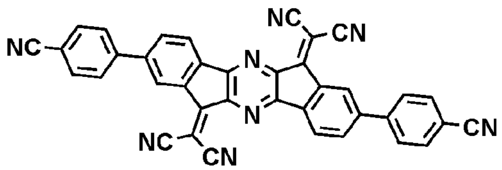

CGP8

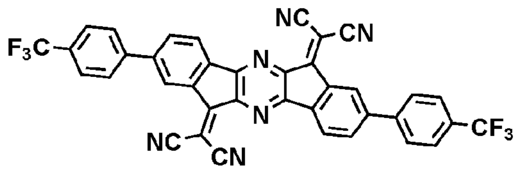

CGP9

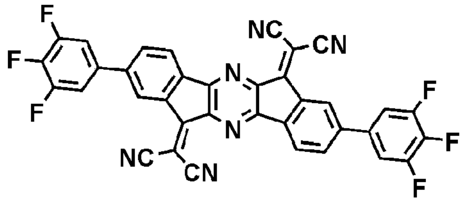

CGP10

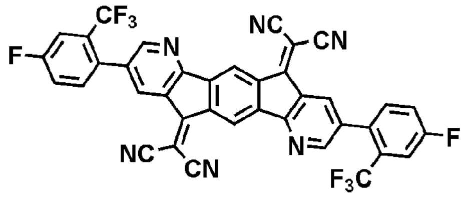

CGP11

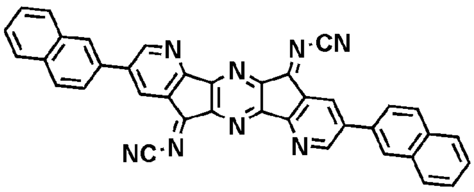

CGP12

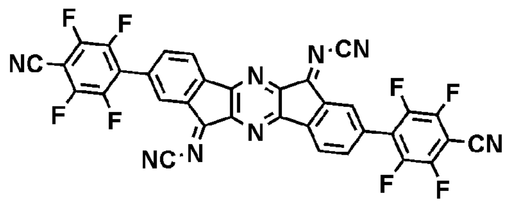

CGP13

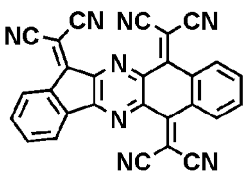

CGP14

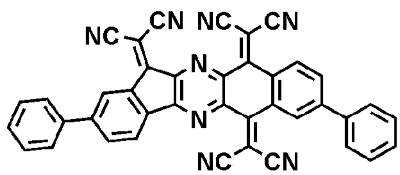

CGP15

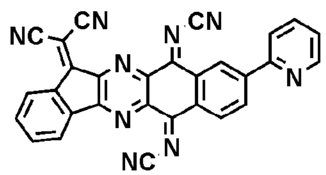

CGP16

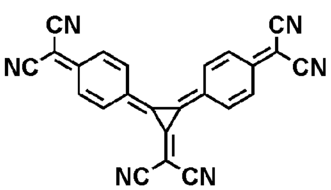

CGP17

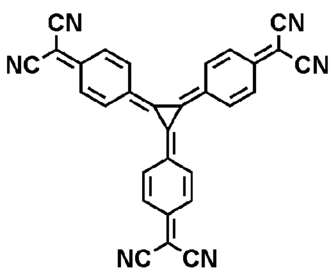

CGP18

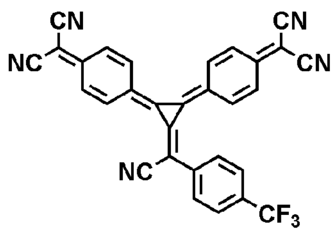

CGP19

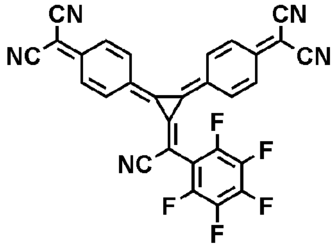

CGP20

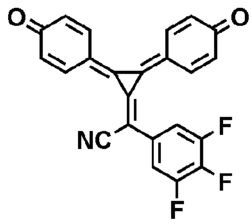

CGP21

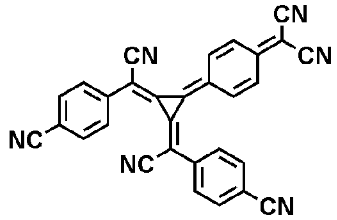

CGP22

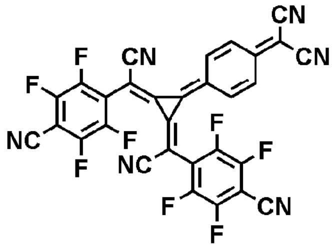

CGP23

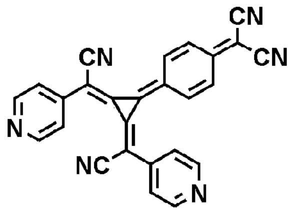

CGP24

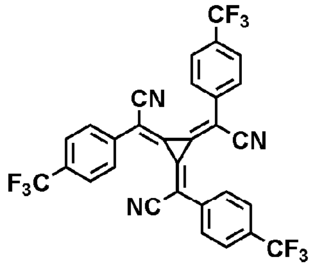

CGP25

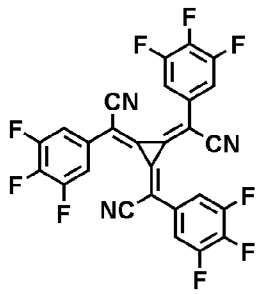

CGP26

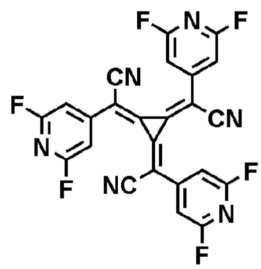

CGP27

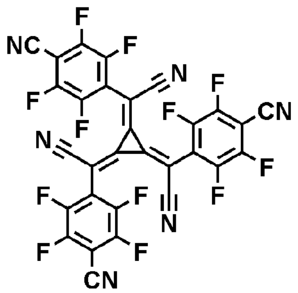

CGP28

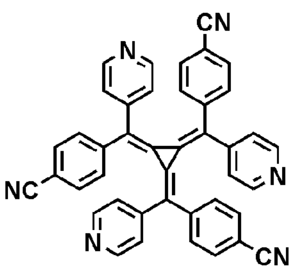

CGP29

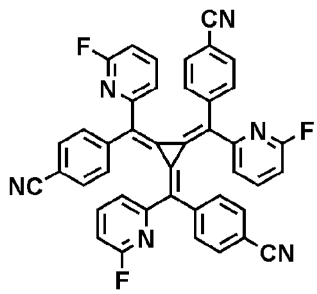

CGP30

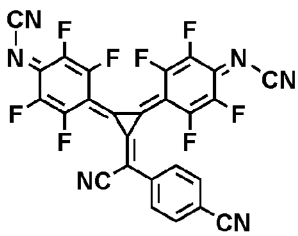

CGP31

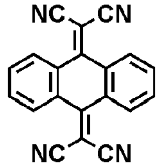
CGP32

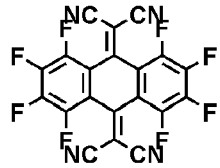
CGP33

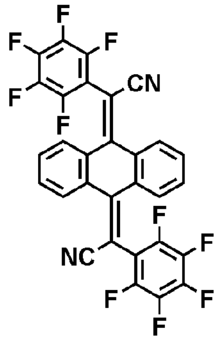
CGP34

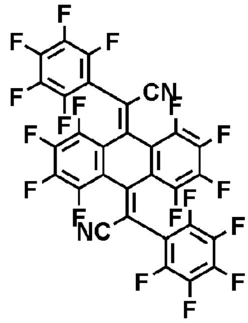
CGP35

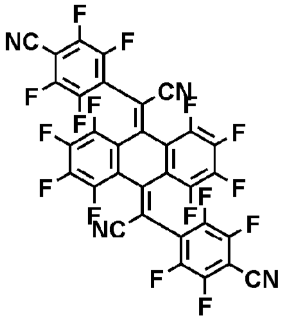
CGP36

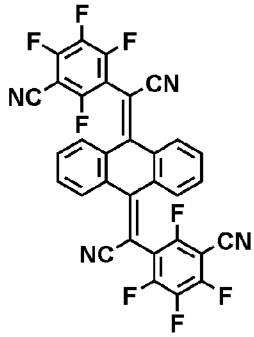
CGP37

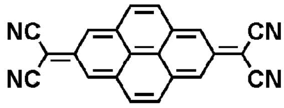
CGP38

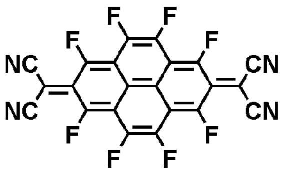
CGP39

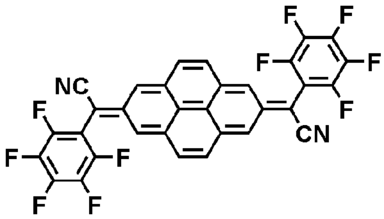
CGP40

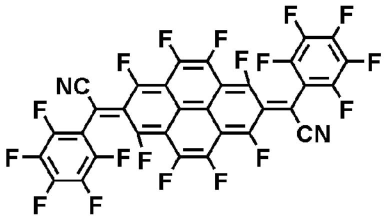
CGP41

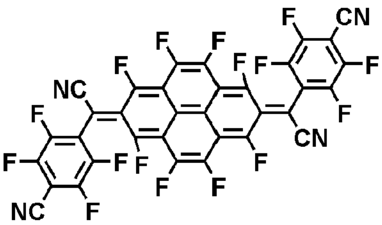
CGP42

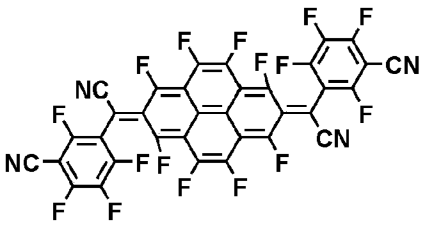
CGP43

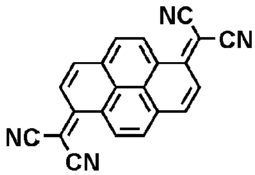
CGP44

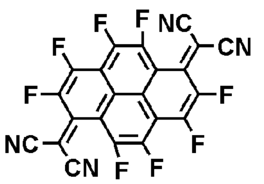
CGP45

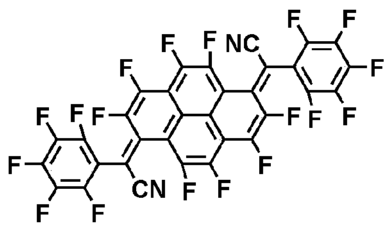
CGP46

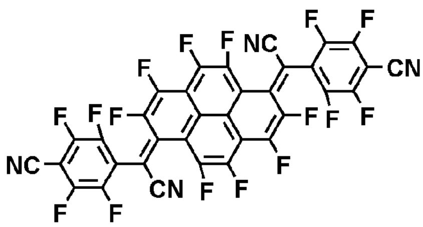
CGP47

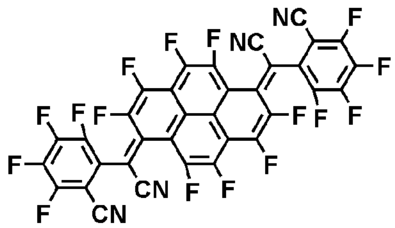

CGP48

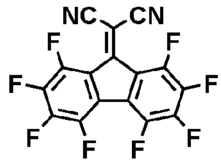

CGP49

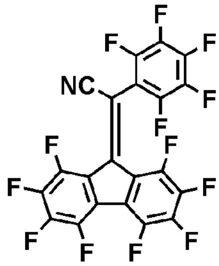

CGP50

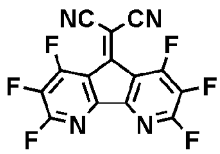

CGP51

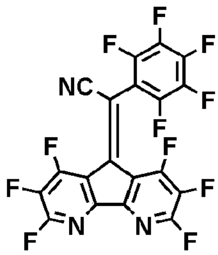

CGP52

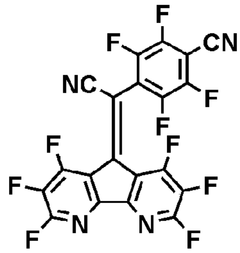

CGP53

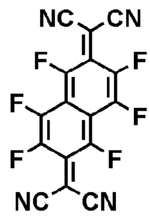

CGP54

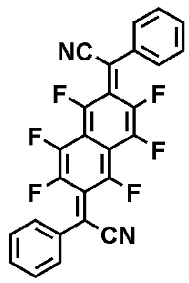

CGP55

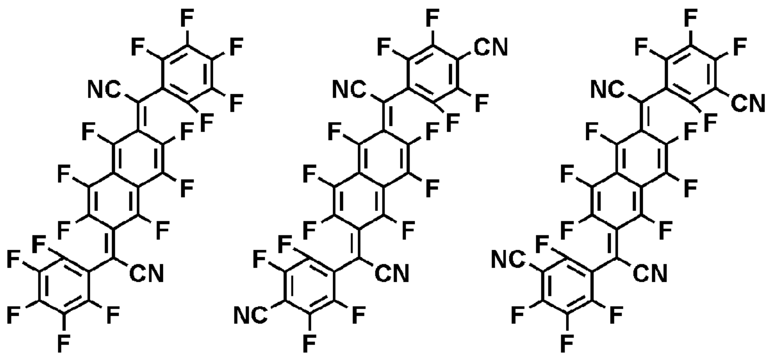

CGP56

CGP57

CGP58

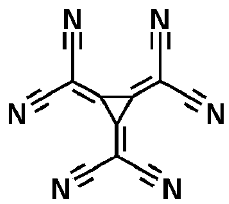

CGP59

.

According to an embodiment, each of the charge-generating dopants may not be F4-TCNQ.

According to an embodiment, the first hole transport region may include a first hole injection layer in direct contact with the first electrode, and the first hole injection layer may include the charge-generating dopant.

According to an embodiment, at least one of the first hole transport region and the first p-type charge generation layer may further include a hole transport compound represented by Formula 2:

[Formula 2]

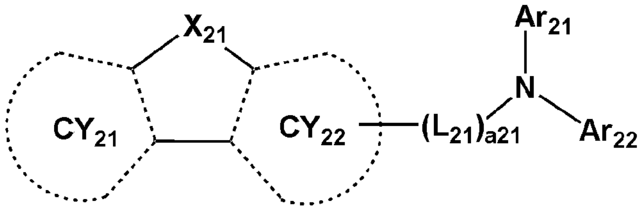

In Formula 2,

$X_{21}$ may be O, S, Se, $N(R_{21})$, $C(R_{21})(R_{22})$, $Si(R_{21})(R_{22})$, $Ge(R_{21})(R_{22})$, C(=O), $P(R_{21})$, $P(=O)(R_{21})$, or $S(=O)_2$,
$CY_{21}$ and $CY_{22}$ may each independently be a $C_3$-$C_{60}$ carbocyclic group or a $C_1$-$C_{60}$ heterocyclic group, each unsubstituted or substituted with at least one $R_{20}$,
$L_{21}$ may be a single bond, a $C_3$-$C_{60}$ carbocyclic group unsubstituted or substituted with at least one $R_{10a}$, or a $C_1$-$C_{60}$ heterocyclic group each unsubstituted or substituted with at least one $R_{10a}$,
a21 may be 1, 2, 3, 4, or 5,
$Ar_{21}$ and $Ar_{22}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
$R_{20}$ to $R_{22}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$, and
$R_{10a}$ and $Q_1$ to $Q_3$ are each the same as described herein.

According to an embodiment, the hole transport compound represented by Formula 2 may be represented by any one of Formulae 2-1 to 2-4:

[Formula 2-1]

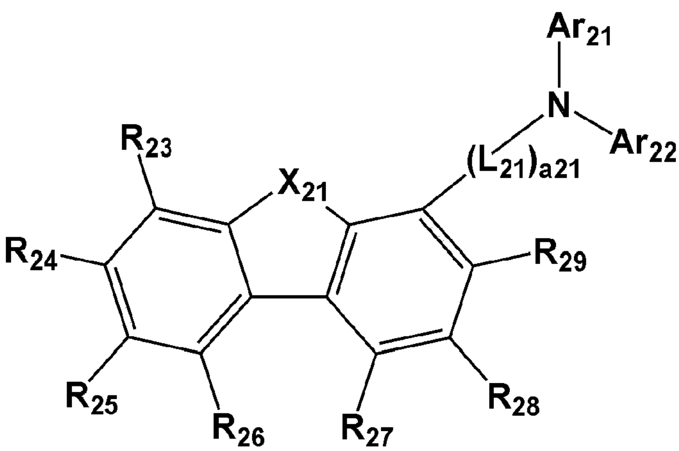

[Formula 2-2]

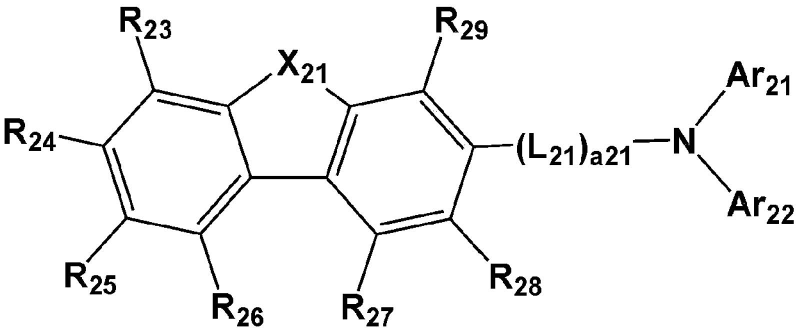

[Formula 2-3]

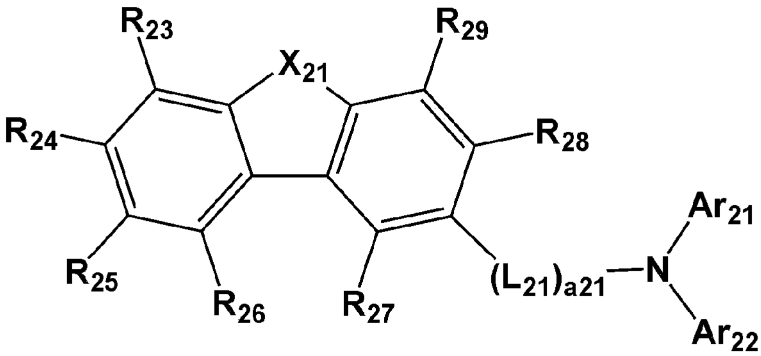

[Formula 2-4]

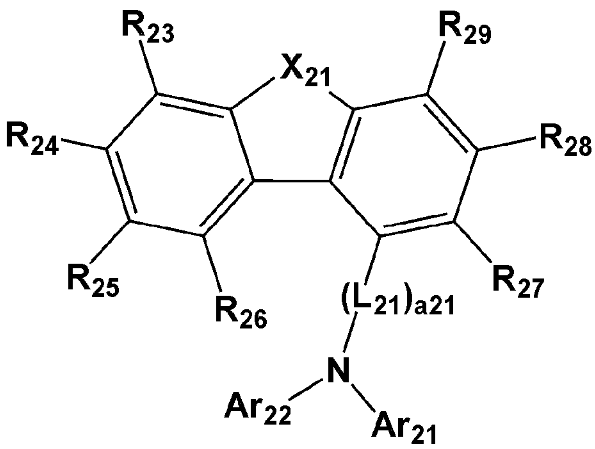

In Formulae 2-1 to 2-4,

$X_{21}$, $L_{21}$, a21, $Ar_{21}$, and $Ar_{22}$ may each be the same as described herein, and
$R_{23}$ to $R_{29}$ may each independently be the same as described herein with respect to $R_{20}$.

According to an embodiment, the hole transport compound represented by Formula 2 may be one of Compounds M1 to M33:

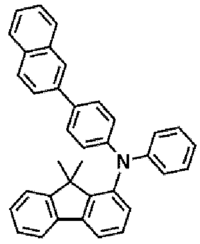

M1

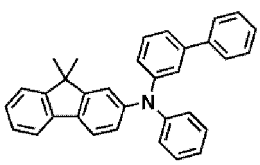

M2

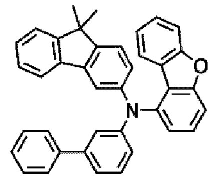

M3

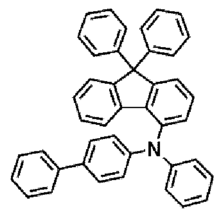

M4

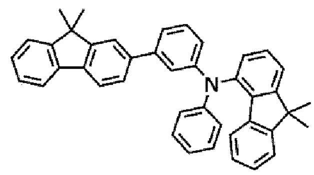

M5

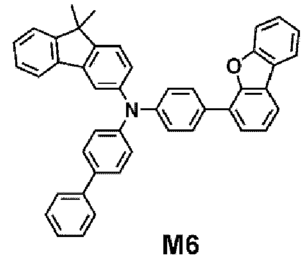

M6

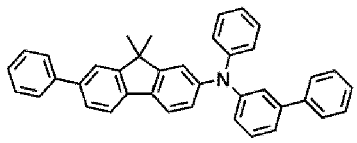

M7

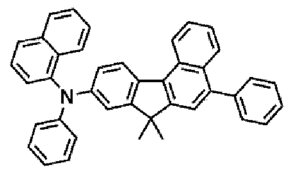

M8

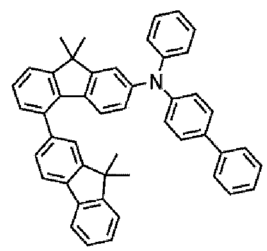

M9

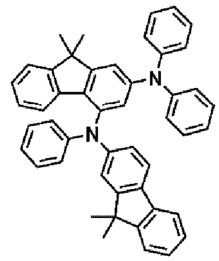

M10

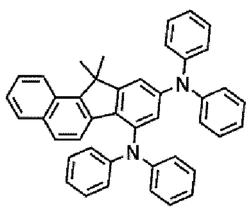

M11

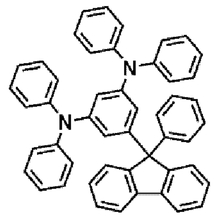

M12

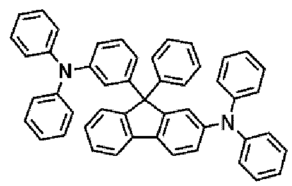

M13

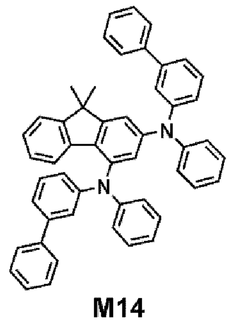

M14

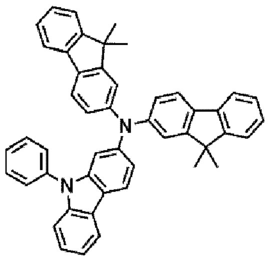

M15

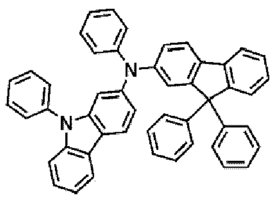

M16

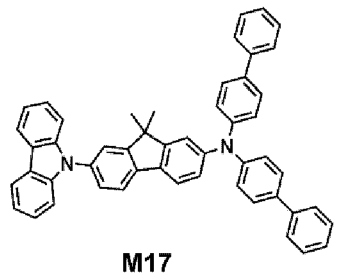

M17

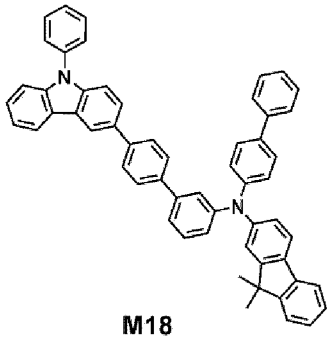
M18

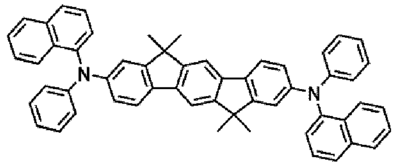
M19

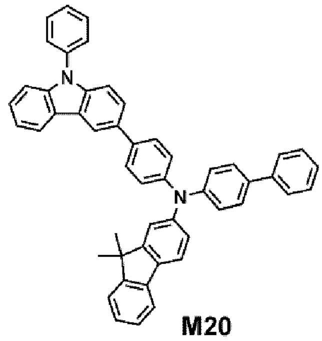
M20

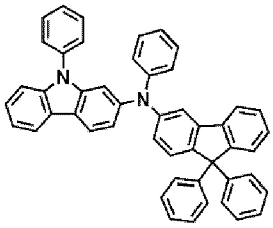
M21

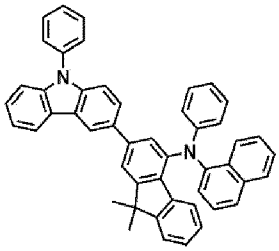
M22

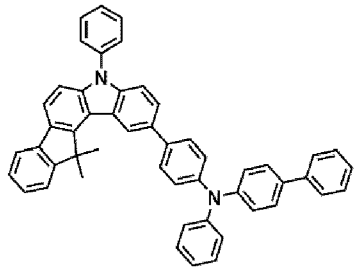
M23

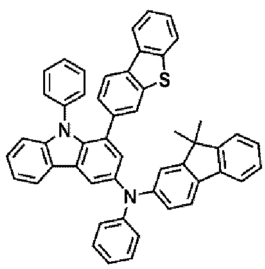
M24

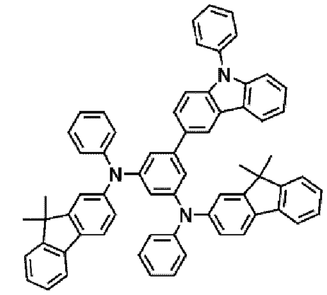
M25

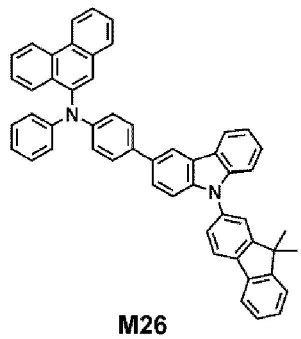
M26

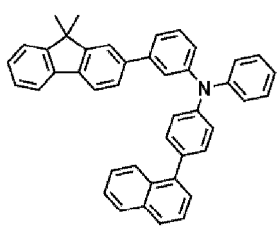
M27

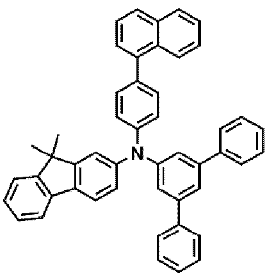
M28

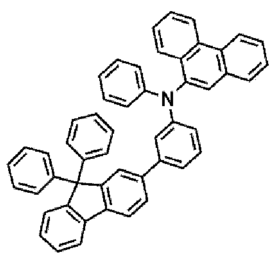
M29

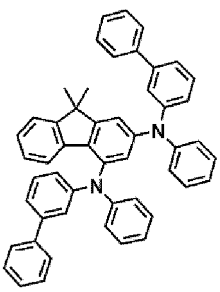
M30

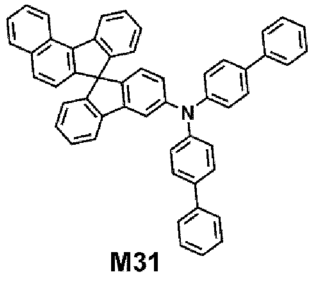
M31

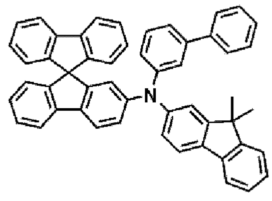
M32

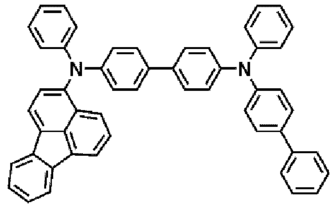
M33

.

According to an embodiment, the first hole transport region may include a first hole injection layer in direct contact with the first electrode, and the first hole injection layer may include the hole transport compound.

According to an embodiment, the second emitting unit may further include a second emission auxiliary layer located between the second light-emitting region and the first electrode.

According to an embodiment, the second emission auxiliary layer may include a third compound represented by Formula 3:

[Formula 3]

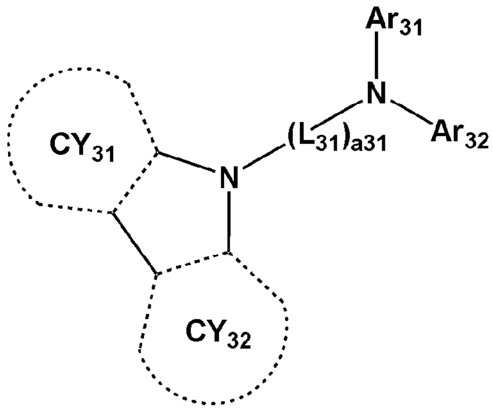

In Formula 3,

$CY_{31}$ and $CY_{32}$ may each independently be a $C_3$-$C_{60}$ carbocyclic group or a $C_1$-$C_{60}$ heterocyclic group, each unsubstituted or substituted with at least one $R_{30}$,
$L_{31}$ may be a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
a31 may be 1, 2, 3, 4, or 5,
$Ar_{31}$ and $Ar_{32}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, and
$R_{30}$ may be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$.
$R_{10a}$ may be:

deuterium, -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or any combination thereof;
a $C_3$-$C_{60}$ carbocyclic group, a $C_1$-$C_{60}$ heterocyclic group, a $C_6$-$C_{60}$ aryloxy group, or a $C_6$-$C_{60}$ arylthio group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$, and
$Q_1$ to $Q_3$, $Q_{11}$ to $Q_{13}$, $Q_{21}$ to $Q_{23}$, and $Q_{31}$ to $Q_{33}$ may each independently be: hydrogen; deuterium; -F; -Cl; -Br; -I; a hydroxyl group; a cyano group; a nitro group; a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, a cyano group, or any combination thereof; or a $C_3$-$C_{60}$ carbocyclic group or $C_1$-$C_{60}$ heterocyclic group, each unsubstituted or substituted with

deuterium, -F, a cyano group, a $C_1$-$C_{60}$ alkyl group, a $C_1$-$C_{60}$ alkoxy group, a phenyl group, a biphenyl group, or any combination thereof.

According to an embodiment, the third compound represented by Formula 3 may be represented by Formula 3-1:

[Formula 3-1]

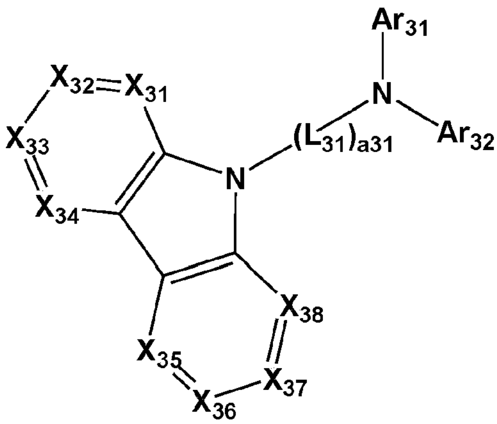

In Formula 3-1,

$L_{31}$, a31, $Ar_{31}$, and $Ar_{32}$ may each be the same as described herein,
$X_{31}$ may be $C(R_{31})$ or N, $X_{32}$ may be $C(R_{32})$ or N, $X_{33}$ may be $C(R_{33})$ or N, $X_{34}$ may be $C(R_{34})$ or N, $X_{35}$ may be $C(R_{33})$ or N, $X_{36}$ may be $C(R_{36})$ or N, $X_{37}$ may be $C(R_{37})$ or N, and $X_{38}$ may be $C(R_{38})$ or N, and
$R_{31}$ to $R_{38}$ may each independently be the same as described herein with respect to $R_{30}$.

In the related art, a light-emitting device with a tandem structure including two or more emitting units may have a problem in that leakage current in a lateral direction may be strengthened due to the introduction of a charge generation unit. For example, efficiency (e.g. luminescence efficiency) at low gray scale may decrease and color mixing may occur, which may deteriorate characteristics such as image quality and the like of the light-emitting device.

The light-emitting device according to an embodiment may have a structure including two or more emitting units and a charge generation unit, and by satisfying the above-described configuration, leakage current in the lateral direction and conductivity inside the light-emitting device can be reduced. Accordingly, the light-emitting device can have excellent image quality characteristics, especially on regions having low luminance and low gray scale, and can have high color purity. A high-quality electronic apparatus and a consumer product can be manufactured by using this light-emitting device.

According to an embodiment, in Formula 1, $CY_{11}$ may be a benzene group, a naphthalene group, a phenanthrene group, a fluoranthene group, a triphenylene group, a pyrene group, a chrysene group, an indene group, a fluorene group, a spiro-bifluorene group, a benzofluorene group, a dibenzofluorene group, an indole group, a pyridine group, a pyrimidine group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group , a benzonaphthothiophene group, or a dinaphthothiophene group, each unsubstituted or substituted with at least one $R_{10}$. $R_{10}$ may be the same as described herein.

According to an embodiment, in Formula 2, $CY_{21}$ and $CY_{22}$ may each independently be a benzene group, a naphthalene group, a phenanthrene group, a fluoranthene group, a triphenylene group, a pyrene group, a chrysene group, an indene group, a fluorene group, a spiro-bifluorene group, a benzofluorene group, a dibenzofluorene group, an indole group, a pyridine group, a pyrimidine group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, or a dinaphthothiophene group, each unsubstituted or substituted with at least one $R_{20}$. $R_{20}$ may be the same as described herein.

According to an embodiment, in Formula 3, $CY_{31}$ and $CY_{32}$ may each independently be a benzene group, a naphthalene group, a phenanthrene group, a fluoranthene group, a triphenylene group, a pyrene group, a chrysene group, an indene group, a fluorene group, a spiro-bifluorene group, a benzofluorene group, a dibenzofluorene group, an indole group, a pyridine group, a pyrimidine group, a carbazole group, a benzocarbazole group, a dibenzocarbazole group, a

furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, or a dinaphthothiophene group, each unsubstituted or substituted with at least one $R_{30}$. $R_{30}$ may be the same as described herein.

According to an embodiment, in Formulae 2 and 3, $L_{21}$ and $L_{31}$ may each independently be a single bond, a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-fluorene-benzofluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolilene group, a phenanthridinylene group, an acridinylene group, a phenanthrolinylene group, a phenazinylene group, a benzoimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosylolylene group, a benzocarbazolylene group, a dibenzocarbazolylene group, a thiadiazolylene group, an imidazopyridinylene, or imidazopyrimidinylene; or

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-fluorene-benzofluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isooxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, a benzoisothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a benzocarbazolylene group, a dibenzocarbazolylene group, a thiadiazolylene group, an imidazopyridinylene group, or an imidazopyrimidinylene group, each substituted with deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolylene group, a benzocarbazolyl group, a dibenzocarbazolyl group, a thiadiazolyl group, an imidazopyridinyl group, an imidazopyrimidinyl group, - $Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, - $P(=O)(Q_{31})(Q_{32})$, or

any combination thereof,

wherein $Q_{31}$ to $Q_{33}$ may each independently be a $C_1$-$C_{10}$ alkyl group, a $C_1$-$C_{10}$ alkoxy group, a phenyl group, a phenyl group substituted with a $C_1$-$C_{10}$ alkyl group, a biphenyl group, a terphenyl group, a naphthyl group, a pyridinyl group, a pyrimidyl group, a triazinyl group, a quinolinyl group, or an isoquinolinyl group.

According to an embodiment, in Formulae 2 and 3, $L_{21}$ and $L_{31}$ may each independently be a group represented by any one of Formulae 3-1 to 3-26:

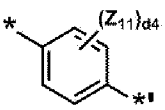
3-1

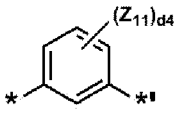
3-2

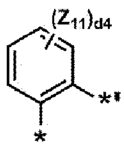
3-3

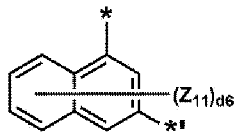
3-4

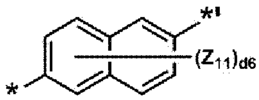
3-5

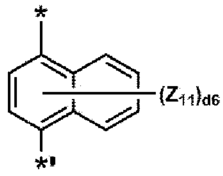
3-6

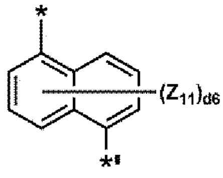
3-7

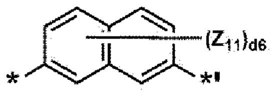
3-8

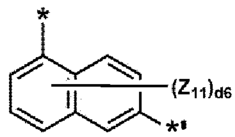
3-9

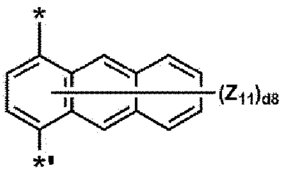
3-10

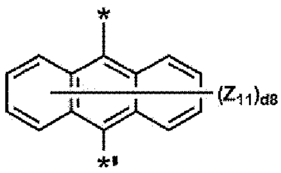
3-11

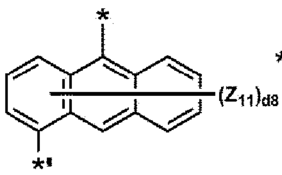
3-12

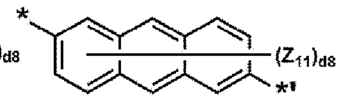
3-13

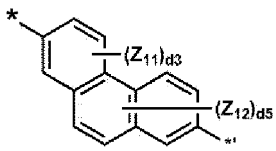
3-14

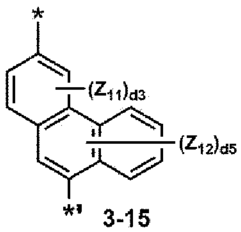
3-15

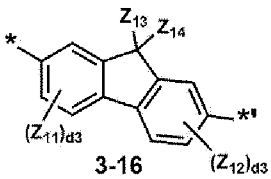
3-16

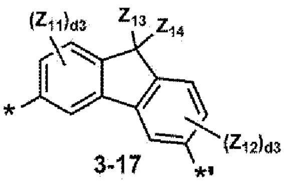
3-17

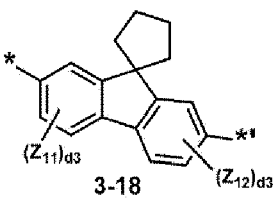
3-18

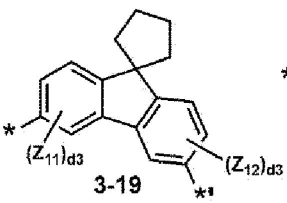
3-19

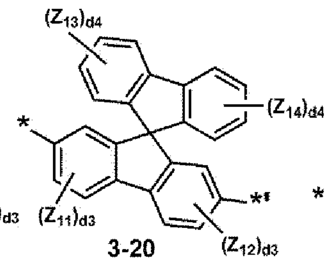
3-20

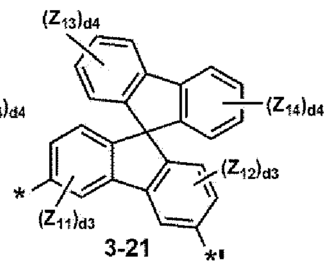
3-21

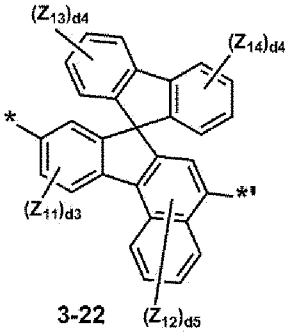
3-22

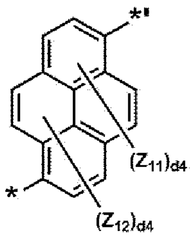
3-23

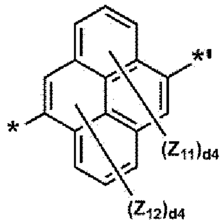
3-24

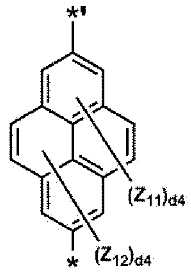
3-25

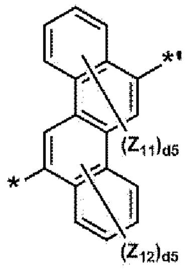
3-26

In Formulae 3-1 to 3-26,

$Z_{11}$ to $Z_{14}$ may each independently be hydrogen, deuterium, -F, -Cl, -Br, -I, a hydroxyl group, a cyano group, a nitro group, an amino group, an amidino group, a hydrazine group, a hydrazone group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a dibenzofuranyl group, a dibenzothiophenyl group, a triazinyl group, a benzoimidazolyl group, a phenanthrolinyl group, or $-Si(Q_{31})(Q_{32})(Q_{33})$,
$Q_{31}$ to $Q_{33}$ may each independently be a $C_1$-$C_{10}$ alkyl group, a $C_1$-$C_{10}$ alkoxy group, a phenyl group, a biphenyl group, a terphenyl group, or a naphthyl group,
d2 may be 0, 1, or 2,
d3 may be 0, 1, 2, or 3,
d4 may be 0, 1, 2, 3, or 4,
d5 may be 0, 1, 2, 3, 4, or 5,
d6 may be 0, 1, 2, 3, 4, 5, or 6,
d8 may be 0, 1, 2, 3, 4, 5, 6, 7, or 8, and
* and *' each indicate a binding site to a neighboring atom.

According to an embodiment, in Formulae 2 and 3, a21 and a31 may each independently be 0, 1, or 2.

According to an embodiment, in Formulae 2 and 3, $Ar_{21}$, $Ar_{22}$, $Ar_{31}$, and $Ar_{32}$ may each independently be:

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a pentalenyl group, an indenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinolinyl group, a carbazolyl group, a phenanthridinyl group, an acridinyl group, a phenanthrolinyl group, a benzoimidazolyl group, a benzofuranyl group, a benzothiophenyl group, a benzothiazolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or imidazopyrimidinyl group; or

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a pentalenyl group, an indenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl

group, a phenanthridinyl group, an acridinyl group, a phenanthrolinyl group, a benzoimidazolyl group, a benzofuranyl group, a benzothiophenyl group, a benzothiazolyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with deuterium, -F, -Cl, -Br, -I, a hydroxyl group, a cyano group, a nitro group, an amidino group, a hydrazino group, a hydrazono group, a $C_1$-$C_{20}$ alkyl group, a $C_2$-$C_{20}$ alkenyl group, a $C_2$-$C_{20}$ alkynyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a pentalenyl group, an indenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a benzoimidazolyl group, a benzofuranyl group, a benzothiophenyl group, a benzothiazolyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -Si($Q_{31}$)($Q_{32}$)($Q_{33}$), -N($Q_{31}$)($Q_{32}$), - B($Q_{31}$)($Q_{32}$), -C(=O)($Q_{31}$), -S(=O)$_2$($Q_{31}$), -P(=O)($Q_{31}$)($Q_{32}$), or any combination thereof,

wherein $Q_{31}$ to $Q_{33}$ may each independently be hydrogen, deuterium, -F, -Cl, -Br, -I, a cyano group, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{20}$ aryl group, a $C_1$-$C_{20}$ heteroaryl group, a monovalent non-aromatic condensed polycyclic group, a monovalent non-aromatic condensed heteropolycyclic group, a biphenyl group, or a terphenyl group.

According to an embodiment, in Formulae 2 and 3, $Ar_{21}$, $Ar_{22}$, $Ar_{31}$, and $Ar_{32}$ may each independently be a group represented by any one of Formulae 5-1 to 5-26 and Formulae 6-1 to 6-55:

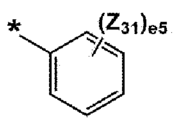
5-1

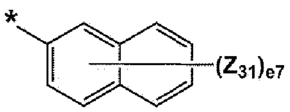
5-2

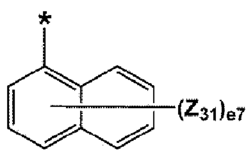
5-3

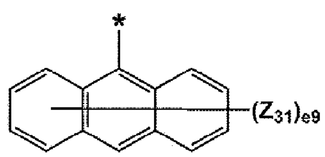
5-4

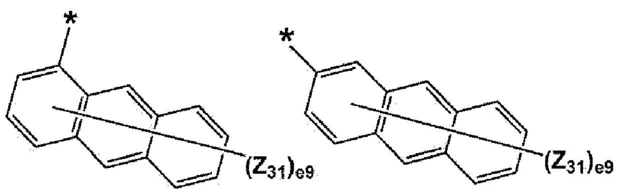
5-5

5-6

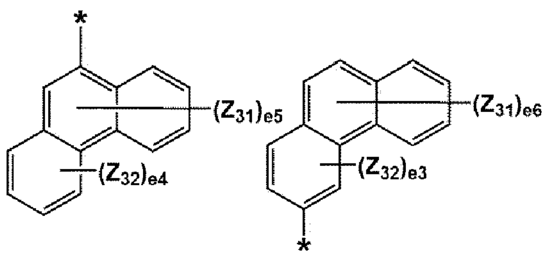
5-7

5-8

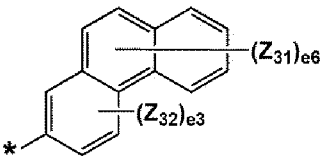

5-9

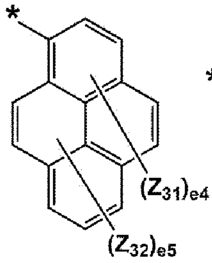

5-10

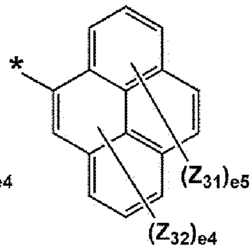

5-11

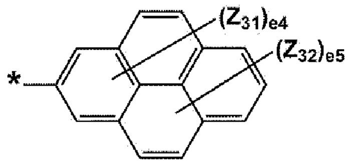

5-12

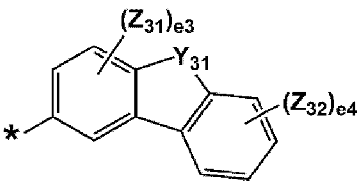

5-13

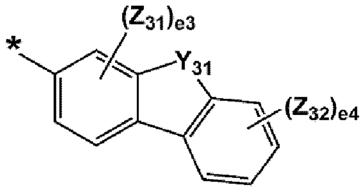

5-14

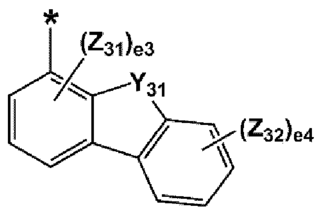

5-15

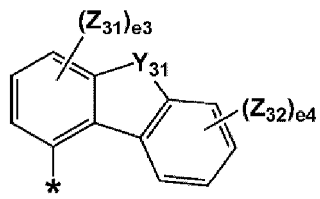

5-16

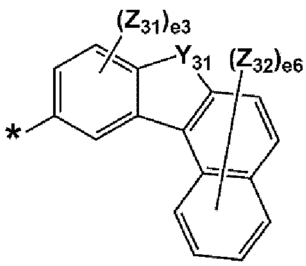

5-17

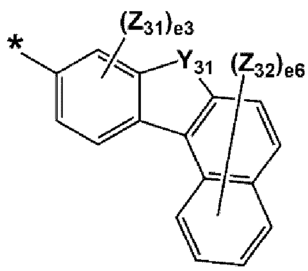

5-18

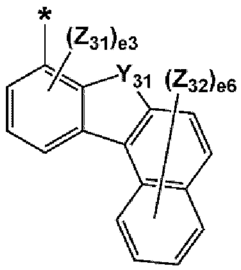

5-19

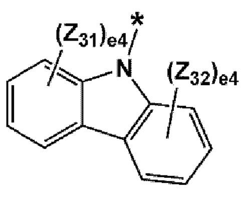

5-20

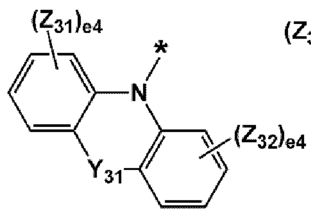

5-21

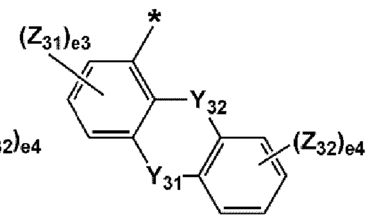

5-22

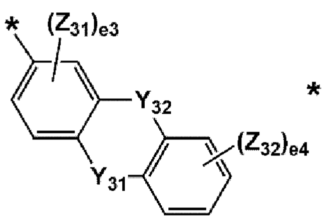

5-23

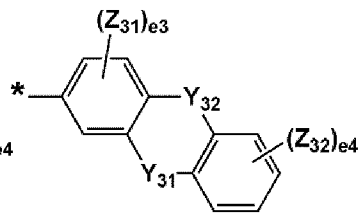

5-24

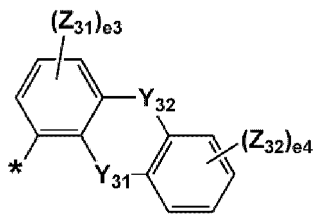

5-25

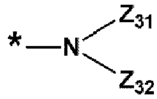

5-26

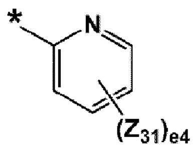
6-1

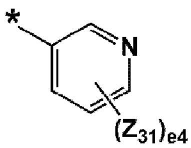
6-2

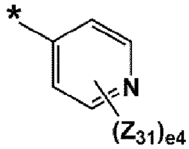
6-3

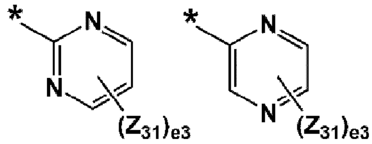
6-4

6-5

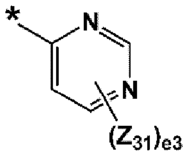
6-6

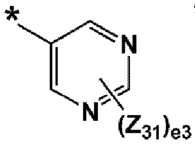
6-7

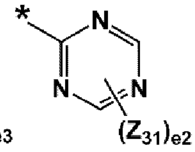
6-8

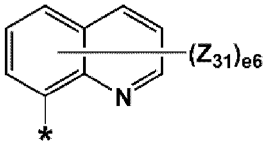
6-9

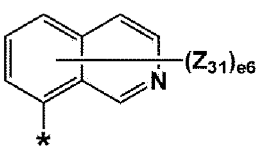
6-10

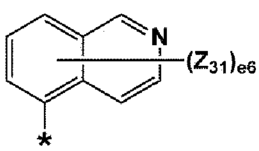
6-11

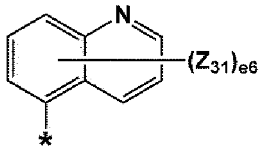
6-12

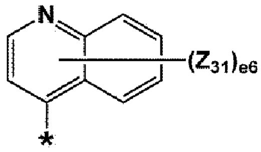
6-13

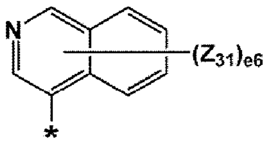
6-14

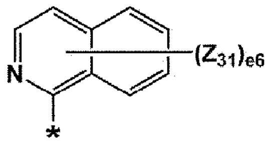
6-15

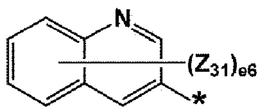
6-16

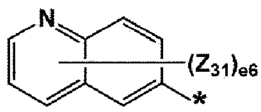
6-17

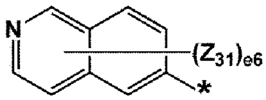
6-18

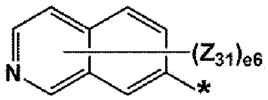
6-19

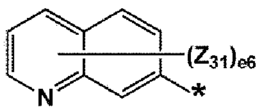
6-20

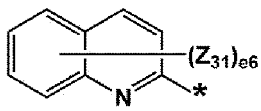
6-21

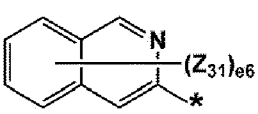
6-22

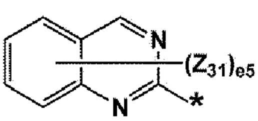
6-23

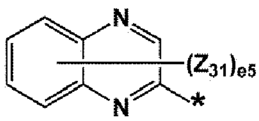
6-24

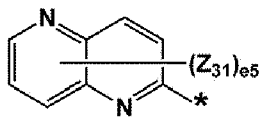
6-25

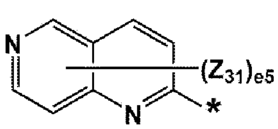
6-26

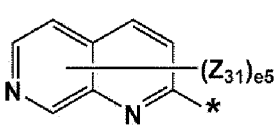
6-27

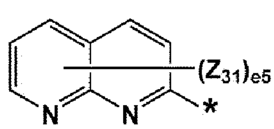
6-28

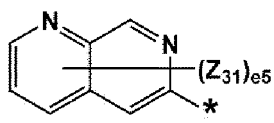
6-29

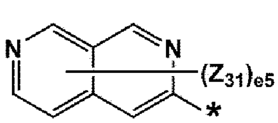
6-30

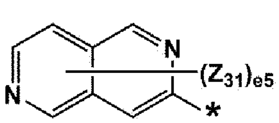
6-31

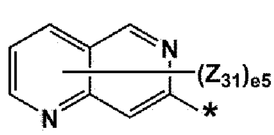
6-32

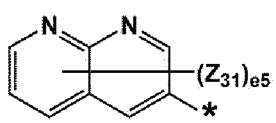
6-33

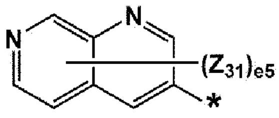

6-34

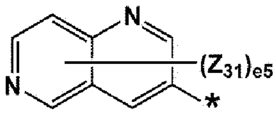

6-35

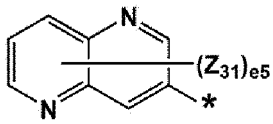

6-36

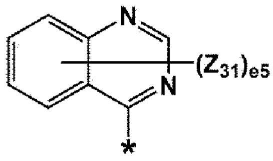

6-37

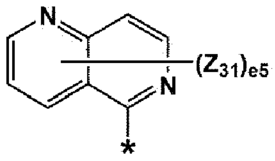

6-38

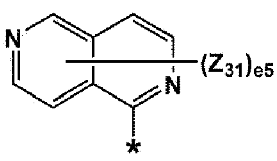

6-39

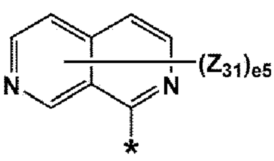

6-40

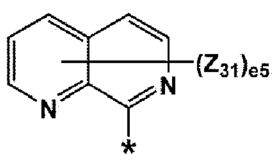

6-41

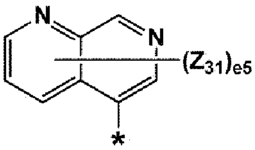

6-42

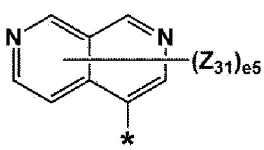

6-43

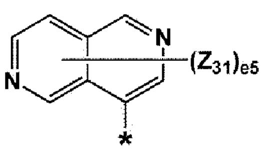

6-44

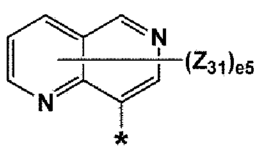

6-45

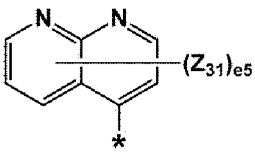

6-46

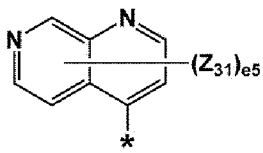

6-47

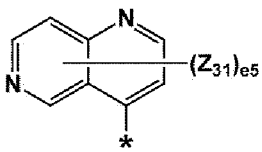

6-48

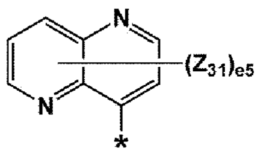

6-49

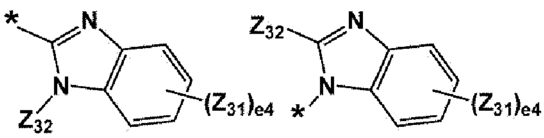

6-50 6-51

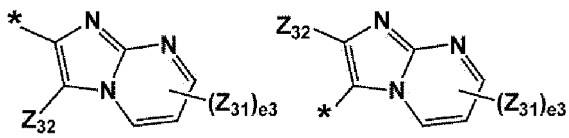

6-52 6-53

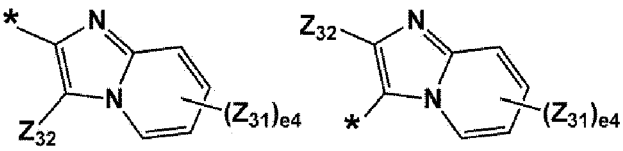

6-54 6-55

In Formulae 5-1 to 5-26 and 6-1 to 6-55,

$Y_{31}$ and $Y_{32}$ may each independently be O, S, $C(Z_{33})(Z_{34})$, $N(Z_{33})$, or $Si(Z_{33})(Z_{34})$,
$Z_{31}$ to $Z_{34}$ may each independently be hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_2$-$C_{20}$ alkenyl group, a $C_2$-$C_{20}$ alkynyl group, a $C_1$-$C_{20}$ alkoxy group, a phenyl group, a biphenyl group, a terphenyl group, a naphthyl group, a fluorenyl group, a spiro-bifluorenyl group, a phenanthrenyl group, an anthracenyl group, a triphenylenyl group, a pyridinyl group, a pyrimidinyl group, a carbazolyl group, or a triazinyl group,
e2 may be 1 or 2,
e3 may be 1, 2, or 3,
e4 may be 1, 2, 3, or 4,
e5 may be 1, 2, 3, 4, or 5,
e6 may be 1, 2, 3, 4, 5, or 6,
e7 may be 1, 2, 3, 4, 5, 6, or 7,

e9 may be 1, 2, 3, 4, 5, 6, 7, 8, or 9, and
* indicates a binding site to a neighboring atom.

According to an embodiment, in Formulae 1 to 3, $R_{10}$ to $R_{12}$, $R_{20}$ to $R_{22}$, and $R_{30}$ may each independently be:

hydrogen, deuterium, -F -Cl, -Br, -I, a hydroxyl group, or cyano group;
a $C_1$-$C_{20}$ alkyl group, a $C_2$-$C_{20}$ alkenyl group, a $C_2$-$C_{20}$ alkynyl group, or $C_1$-$C_{20}$ alkoxy group;
a $C_1$-$C_{20}$ alkyl group, $C_2$-$C_{20}$ alkenyl group, $C_2$-$C_{20}$ alkynyl group, or $C_1$-$C_{20}$ alkoxy group, each substituted with deuterium, -F, -Cl, -Br, -I, a hydroxyl group, a cyano group, a nitro group, an amidino group, a hydrazino group, a hydrazono group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, - $P(=O)(Q_{31})(Q_{32})$, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a pentalenyl group, an indenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a benzimidazolyl group, a benzofuranyl group, a benzothiophenyl group, a benzothiazolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a pentalenyl group, an indenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a benzoimidazolyl group, a benzofuranyl group, a benzothiophenyl group, a benzothiazolyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with deuterium, -F, -Cl, -Br, -I, a hydroxyl group, a cyano group, a nitro group, an amidino group, a hydrazino group, a hydrazono group, a $C_1$-$C_{20}$ alkyl group, a $C_2$-$C_{20}$ alkenyl group, a $C_2$-$C_{20}$ alkynyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a pentalenyl group, an indenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a benzoimidazolyl group, a benzofuranyl group, a benzothiophenyl group, a benzothiazolyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, $-Si(Q_{31})(Q_{32})(Q_{33})$, $-N(Q_{31})(Q_{32})$, - $B(Q_{31})(Q_{32})$, $-C(=O)(Q_{31})$, $-S(=O)_2(Q_{31})$, $-P(=O)(Q_{31})(Q_{32})$, or any combination thereof,
wherein $Q_{31}$ to $Q_{33}$ may each independently be hydrogen, deuterium, -F, -Cl, -Br, -I, a cyano group, a $C_1$-$C_{20}$ alkyl

group, a $C_2$-$C_{20}$ alkenyl group, a $C_2$-$C_{20}$ alkynyl group, a $C_1$-$C_{20}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{20}$ aryl group, a $C_1$-$C_{20}$ heteroaryl group, a monovalent non-aromatic condensed polycyclic group, a monovalent non-aromatic condensed heteropolycyclic group, a biphenyl group, or a terphenyl group.

According to an embodiment, in Formulae 1 to 3, $R_{10}$ to $R_{12}$, $R_{20}$ to $R_{22}$, and $R_{30}$ may each independently be:

hydrogen, deuterium, -F -Cl, -Br, -I, a hydroxyl group, a cyano group;
a $C_1$-$C_{20}$ alkyl group or a $C_1$-$C_{20}$ alkoxy group substituted with deuterium, -F, -Cl, -Br, -I, a cyano group, a phenyl group, a biphenyl group, or any combination thereof; or
a group represented by any one of Formulae 5-1 to 5-26 and Formulae 6-1 to 6-55.

According to an embodiment, the first hole injection layer may include a first compound and a first charge-generating dopant, and the first p-type charge generation layer may include a second compound and a second charge-generating dopant,

the first compound and the second compound may each independently be hole transport compounds represented by Formula 1, and
the first charge-generating dopant and the second charge-generating dopant may each independently be the charge-generating dopant.

According to an embodiment, the first charge-generating dopant and the second charge-generating dopant may be the same or different from each other.
According to an embodiment, the first compound and the second compound may be the same or different from each other.
According to an embodiment, an amount of the first charge-generating dopant may be in a range of about 0.1 parts by weight to about 5 parts by weight, per 100 parts by weight of the first hole injection layer. For example, an amount of the first charge-generating dopant may be in a range of about 1 parts by weight to about 3 parts by weight, per 100 parts by weight of the first hole injection layer.
According to an embodiment, an amount of the second charge-generating dopant may be in a range of about 1 parts by weight to about 15 parts by weight, per 100 parts by weight of the first p-type charge generation layer. For example, an amount of the second charge-generating dopant may be in a range of about 3 parts by weight to about 8 parts by weight, per 100 parts by weight of the first p-type charge generation layer.
According to an embodiment, an amount of the first charge-generating dopant per 100 parts by weight of the first hole injection layer may be more than twice the content of the second charge-generating dopant per 100 parts by weight of the first p-type charge generation layer. For example, an amount of the first charge-generating dopant per 100 parts by weight of the first hole injection layer may be about 2 times to about 10 times, or about 2 times to about 8 times, or about 2 times to about 5 times the content of the second charge-generating dopant, per 100 parts by weight of the first p-type charge generation layer.
According to an embodiment, the thickness of the hole injection layer of the first emitting unit may be in a range of about 1 nm to about 10 nm.
According to an embodiment, the thickness of the first p-type charge generation layer may be in a range of about 2 nm to about 30 nm.
According to an embodiment, the thickness of the hole injection layer of the first emitting unit may be more than twice the thickness of the p-type charge generation layer of the first charge generation unit. For example, the thickness of the hole injection layer of the first emitting unit may be about 2 times to about 10 times, or about 2 times to about 9 times, or about 2 times to about 5 times the thickness of the p-type charge generation layer of the first charge generation unit.
According to an embodiment, the first emitting unit among the m emitting units may be located closest to the first electrode.
According to an embodiment, the second emitting unit of the m emitting units may be located closest to the first electrode.
According to an embodiment, the configuration of each of the m emitting units may be the same or different from each other.
According to an embodiment, the first charge generation unit may be located between the first emitting unit and the second emitting unit.
According to an embodiment, the first charge generation unit may further include the first n-type charge generation layer.
According to an embodiment, the first n-type charge generation layer may include an electron transport

compound.

Details on the electron transport compound included in the first n-type charge generation layer may be the same as described herein with respect to the electron transport compound.

According to an embodiment, the electron transport compound may be a phenanthroline-based compound or a phosphine oxide-based compound.

According to an embodiment, the electron transport compound may be selected from Compound N1 and any phenanthroline-based compounds similar thereto:

[Compound N1]

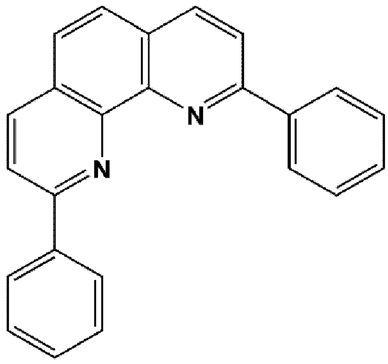

.

According to an embodiment, the first n-type charge generation layer may further include metal.

For example, the first n-type charge generation layer may include an alkali metal, an alkali metal alloy, an alkaline earth metal, an alkaline earth metal alloy, a lanthanide metal, a lanthanide metal alloy, or any combination thereof.

According to an embodiment, the first n-type charge generation layer may include the electron transport compound and the metal, and a volume ratio of the electron transport compound to the metal may be in a range of about 99.9:0.1 to about 80:20. For example, a volume ratio of the electron transport compound to the metal may be in a range of about 99:1 to about 80:20.

According to an embodiment, the configuration of the (m-1) charge generation unit(s) may be the same or different from each other.

According to an embodiment, the first subpixel area may be a red subpixel area, the second subpixel area may be a green subpixel area, and the third subpixel area may be a blue subpixel area.

According to an embodiment, the first light-emitting region may include a first red emission layer, a first green emission layer, and a first blue emission layer,

the first red emission layer may be arranged in the red subpixel area of the first emitting unit,
the first green emission layer may be arranged in the green subpixel area of the first emitting unit, and
the first blue emission layer may be arranged in the blue subpixel area of the first emitting unit.

According to an embodiment, the second light-emitting region may include a second red emission layer, a second green emission layer, and a second blue emission layer,

the second red emission layer may be arranged in the red subpixel area of the second emitting unit,
the second green emission layer may be arranged in the green subpixel area of the second emitting unit, and
the second blue emission layer may be arranged in the blue subpixel area of the second emitting unit.

According to an embodiment, the second emission auxiliary layer may be arranged in the red subpixel area of the second emitting unit and may be in direct contact with the second red emission layer.

According to an embodiment, the second emission auxiliary layer may be in direct contact with the first p-type charge generation layer. For example, the second emission auxiliary layer may be located between the second red emission layer and the first p-type charge generation layer, and may be in direct contact with the second red emission layer and the first p-type charge generation layer.

According to an embodiment, the first red emission layer, the first green emission layer, the first blue emission layer, the second red emission layer, the second green emission layer, and the second blue emission layer may each independently include a host and a dopant, and the content of the host may be greater than the content of the dopant based on the weight of each layer.

According to an embodiment, the host may include two or more different compounds. For example, the host may

include a first host compound and a second host compound, and the weight ratio of the first host compound and the second host compound may be in a range of about 0.1:99.9 to about 99.9:0.1, in a range of about 1:99 to about 99: 1, in a range of about 10:90 to about 90:10, in a range of about 20:80 to about 80:20, in a range of about 30:70 to about 70:30, in a range of about 40:60 to about 60:40, or in a range of about 45:55 to about 55:45.

According to an embodiment, the first host compound and the second host compound may be compounds including deuterium. According to an embodiment, the weight ratio of the first host compound and the second host compound may be in a range of about 0.1:99.9 to about 50:50, in a range of about 1:99 to about 49:51, in a range of about 10:90 to about 45:55, or in a range of about 20:80 to about 40:60.

According to an embodiment, the dopant may be a fluorescent dopant, a phosphorescent dopant, a delayed fluorescence dopant, or any combination thereof.

According to an embodiment, the m emitting units may each further include a hole transport region and/or an electron transport region, and the hole transport region may include at least one selected from a hole injection layer, a hole transport layer, a buffer layer, an emission auxiliary layer, and an electron blocking layer, and the electron transport region may include at least one selected from a hole blocking layer, an electron transport layer, and an electron injection layer.

In this specification, "the hole injection layer may include a charge-generating dopant" can be interpreted as "the hole injection layer may include one compound belonging to the category of the charge-generating dopant, or two or more different compounds belonging to the category of the charge-generating dopant.

In this specification, "the p-type charge generation layer may include a charge-generating dopant" can be interpreted as "the p-type charge generation layer may include one compound belonging to the category of the charge-generating dopant, or two or more different compounds belonging to the category of the charge-generating dopant.

In this specification, "the hole injection layer may include a compound represented by Formula 1" can be interpreted as "the hole injection layer may include one compound represented by Formula 1, or two or more different compounds each independently represented by Formula 1.

In this specification, "the p-type charge generation layer may include a compound represented by Formula 1" can be interpreted as "the p-type charge generation layer may include one compound represented by Formula 1, or two or more different compounds each independently represented by Formula 1.

In this specification, "the emission auxiliary layer may include a compound represented by Formula 3" can be interpreted as "the emission auxiliary layer may include one compound represented by Formula 3, or two or more different compounds each independently represented by Formula 3.

The term "interlayer" as used herein refers to a single layer and/or a plurality of (e.g. all) layers between a first electrode and a second electrode of the light-emitting device.

Another aspect provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. The electronic apparatus may further include a color filter, a color conversion layer, a touch screen layer, a polarizing layer, or any combination thereof. More details on the electronic apparatus may be the same as described herein.

Another aspect provides a consumer product (e.g. an electronic equipment) including the light-emitting device.

According to an embodiment, the consumer product may be a flat panel display, a curved display, a computer monitor, a medical monitor, a television, an advertisement board, an indoor light, an outdoor light, a signal light, a head-up display, a fully transparent display, a partially transparent display, a flexible display, a rollable display, a foldable display, a stretchable display, a laser printer, a phone, a mobile phone, a tablet computer, a phablet, a personal digital assistant (PDA), a wearable device, a laptop, a digital camera, a camcorder, a viewfinder, a micro display, a three-dimensional (3D) display, a virtual reality display, an augmented reality display, a vehicle, a video wall including multiple displays tiled together, a theater screen, a stadium screen, a phototherapy device, or a signage.

[Descriptions of FIGS. 1 to 3]

FIGS. 1 to 3 are each a schematic cross-sectional view of a light-emitting device 10 according to an embodiment.

Referring to FIG. 1, a light-emitting device 10 may include a first electrode 110, an interlayer 150, and a second electrode 190, and the interlayer 150 may include m emitting units; and m-1 charge generation units located between two adjacent emitting units among the m emitting units, wherein m may be an integer of 2 or more, and at least one of the emitting units 140 may include a first subpixel P1 and a second subpixel P2.

Referring to FIG. 2, the light-emitting device 10 may include a first emitting unit 141, a second emitting unit 142, and a first charge generation unit 151, and the first emitting unit 141 and the second emitting unit 142 may include first subpixels 141-P1 and 142-P1, second subpixels 141-P2 and 142-P2, and third subpixels 141-P3 and 142-P3, respectively. A pixel defining layer 290 may be located between adjacent subpixels. In case that the light-emitting device 10 is patterned in this way, first electrodes 110-P1, 110-P2, and 110-P3 corresponding to each subpixel area may be formed,

and the pixel defining layer 290 may be located between them.

Referring to FIG. 3, the first subpixel, second subpixel, and third subpixel included in each of the first emitting unit 141 and the second emitting unit 142 of the light-emitting device 10 may be a red pixel, a green subpixel, or a blue subpixel, respectively, and may be patterned so that the red subpixel may include red emission layers 141R and 142R, the green subpixel may include green emission layers 141G and 142G, and the blue subpixel may include blue emission layers 141B and 142B. A pixel defining layer 290 may be located between adjacent subpixels. In case that the light-emitting device 10" is patterned in this way, first electrodes 110R, 110G, and 110B corresponding to each subpixel area may be formed, and the pixel defining layer 290 may be located between them.

According to an embodiment, the area where the emission layer is arranged may be referred to as a light-emitting region. For example, the first light-emitting region included in the first emitting unit 141 may include a red emission layer 141R, a green emission layer 141G, and a blue emission layer 141B. As another example, the second light-emitting region included in the second emitting unit 142 may include a red emission layer 142R, a green emission layer 142G, and a blue emission layer 142B.

A red emission auxiliary layer 142R' may be arranged in the red subpixel, a green emission auxiliary layer 142G' may be arranged in the green subpixel, and a blue emission auxiliary layer 142B' may be arranged in the blue subpixel.

The first emitting unit 141 may include a first hole transport region, and the first hole transport region may include a first hole injection layer 121.

A first charge generation unit 151 may be located between the first emitting unit 141 and the second emitting unit 142, and the first charge generation unit may include a first p-type charge generation layer 151P and a first n-type charge generation layer 151N.

However, the positions of the first emitting unit 141, the second emitting unit 142, and the first charge generation unit 151 are not limited to those shown in FIGS. 1 to 3 described above. For example, the positions of the first emitting unit 141 and the second emitting unit 142 may be exchanged.

Other layers may be additionally located between each layer. For example, at least one of a hole transport layer, an electron blocking layer, and a buffer layer may be additionally located between the first hole injection layer 121 and the subpixels 141R, 141G, and 141B of the first emitting unit 141. As another example, the second emitting unit 142 may further include an electron transport region located between the subpixels of the second emitting unit 142 and the second electrode 190. As another example, a red emission auxiliary layer 142R', a green emission auxiliary layer 142G', and/or a blue emission auxiliary layer 142B' between each subpixel of the first emitting unit 141 may be additionally located adjacent to the first hole transport region.

Hereinafter, the structure and manufacturing method of the light-emitting device 10 according to an embodiment will be described in connection with FIGS. 1 to 3.

[First electrode 110]

In FIGS. 1 to 3, a substrate may be additionally located under the first electrode 110 or above the second electrode 190. As the substrate, a glass substrate or a plastic substrate may be used. For example, the substrate may be a flexible substrate, and may include plastics with excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. In case that the first electrode 110 is an anode, a material for forming the first electrode 110 may be a high-work function material that facilitates injection of holes.

The first electrode 110 may be a reflective electrode, a transflective electrode, or a transmissive electrode. In case that the first electrode 110 is a transmissive electrode, a material for forming the first electrode 110 may include indium tin oxide (ITO), indium zinc oxide (IZO), tin oxide ($SnO_2$), zinc oxide (ZnO), or any combination thereof. For example, in case that the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a monolayer structure consisting of a single layer or a multilayer structure including multiple layers. For example, the first electrode 110 may have a three-layered structure of ITO/Ag/ITO.

[Interlayer 150]

The interlayer 150 may be located on the first electrode 110. The interlayer 150 may include an emission layer.

The interlayer 150 may further include a hole transport region located between the first electrode 110 and the emission layer, and an electron transport region located between the emission layer and the second electrode 190.

The interlayer 150 may further include metal-containing compounds such as organometallic compounds,

inorganic materials such as quantum dots, and the like, in addition to various organic materials.

The interlayer 150 may include, i) two or more emitting units sequentially stacked on each other between the first electrode 110 and the second electrode 190, and ii) a charge generation layer located between the two or more emitting units. In case that the interlayer 150 includes the emitting units and the charge generation layer as described above, the light-emitting device 10' and 10" may be a tandem light-emitting device.

[Hole transport region in interlayer 150]

In addition to the hole injection layer and the hole transport layer, the hole transport region may further include an emission auxiliary layer, an electron blocking layer, or any combination thereof.

Each layer of the hole transport region may have, for example, i) a monolayer structure consisting of a single layer consisting of a single material, ii) a monolayer structure consisting of a single layer including multiple different materials, or iii) a multilayer structure including multiple layers including multiple different materials.

For example, the hole transport region may have a multilayer structure of a hole injection layer/hole transport layer, a hole injection layer/hole transport layer/emission auxiliary layer, or a hole injection layer/hole transport layer/-electron blocking layer, which are sequentially stacked on each other from the first electrode 110.

The hole transport region may further include a compound represented by Formula 201, a compound represented by Formula 202, or any combination thereof:

[Formula 201]

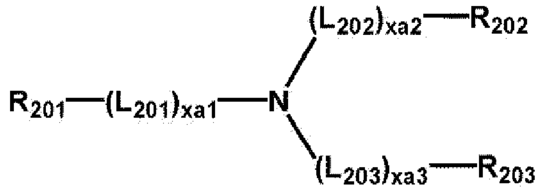

[Formula 202]

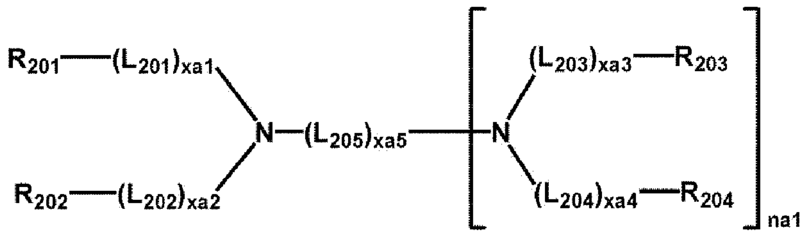

In Formulae 201 and 202,

$L_{201}$ to $L_{204}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
$L_{205}$ may be *-O-*', *-S-*', *-N($Q_{201}$)-*', a $C_1$-$C_{20}$ alkylene group unsubstituted or substituted with at least one $R_{10a}$, a $C_2$-$C_{20}$ alkenylene group unsubstituted or substituted with at least one $R_{10a}$, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
* and *' indicate a binding site to a neighboring atom,
xa1 to xa4 may each independently be an integer from 0 to 5,
xa5 may be an integer from 1 to 10,
$R_{201}$ to $R_{204}$ and $Q_{201}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
$R_{201}$ and $R_{202}$ may optionally be linked to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group (for example, a carbazole group, etc.) unsubstituted or substituted with at least one $R_{10a}$ (for example, see Compound HT16),
$R_{203}$ and $R_{204}$ may optionally be linked to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group unsubstituted or substituted with at least one $R_{10a}$, and
na1 may be an integer from 1 to 4. $R_{10a}$ may be the same as described herein.

In an embodiment, the compound represented by Formula 201 and the compound represented by Formula 202 may each independently include at least one of groups represented by Formulae CY201 to CY217:

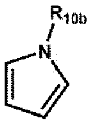

CY201

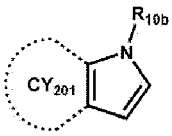

CY202

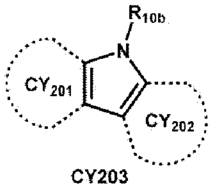

CY203

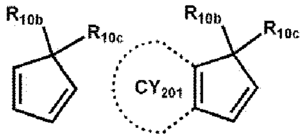

CY204 CY205

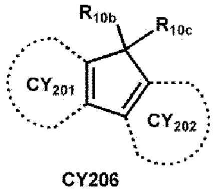

CY206

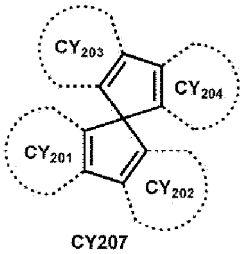

CY207

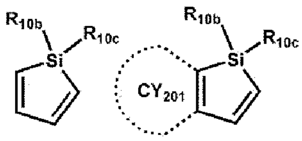

CY208 CY209

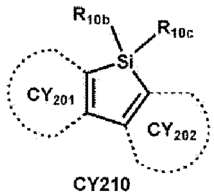

CY210

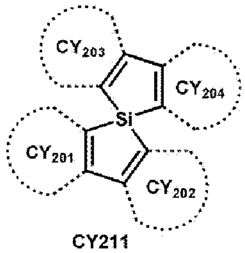

CY211

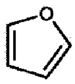

CY212

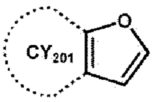

CY213

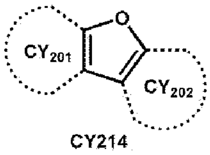

CY214

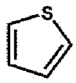

CY215

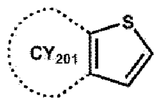

CY216

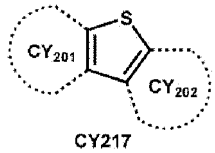

CY217

In Formulae CY201 to CY217, $R_{10b}$ and $R_{10c}$ may each independently be the same as described with respect to $R_{10a}$, ring CY201 to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with $R_{10a}$ as described above.

In an embodiment, in Formulae CY201 to CY217, ring $CY_{201}$ to ring $CY_{204}$ may each independently be a benzene group, a naphthalene group, a phenanthrene group, or an anthracene group.

According to embodiments, the compound represented by Formula 201 and the compound represented by Formula 202 may each independently include at least one of groups represented by Formulae CY201 to CY203.

According to embodiments, the compound represented by Formula 201 may include at least one of the groups represented by Formulae CY201 to CY203 and at least one of the groups represented by Formulae CY204 to CY217.

According to embodiments, in Formula 201, xa1 may be 1, $R_{201}$ may be a group represented by one of Formulae CY201 to CY203, xa2 may be 0, and $R_{202}$ may be a group represented by one of Formulae CY204 to CY207.

According to embodiments, the compound represented by Formula 201 and the compound represented by Formula 202 may each not include a group represented by one of Formulae CY201 to CY203.

According to embodiments, the compound represented by Formula 201 and the compound represented by Formula 202 may each not include a group represented by one of Formulae CY201 to CY203, and may each independently include at least one of the groups represented by Formulae CY204 to CY217.

In an embodiment, the compound represented by Formula 201 and the compound represented by Formula 202 may each not include a group represented by one of Formulae CY201 to CY217.

In embodiments, the hole transport region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl) triphenylamine (TCTA), polyaniline/dodecylbenzenesulfonic acid (PANI/DBSA), poly(3,4-ethylenedioxythiophene)/-poly(4-styrenesulfonate) (PEDOT/PSS), polyaniline/camphor sulfonic acid (PANI/CSA), polyaniline/poly(4-styrenesulfonate) (PANI/PSS), or any combination thereof:

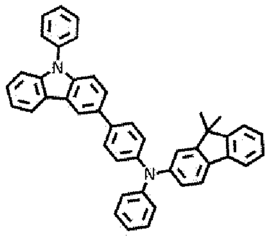

HT1

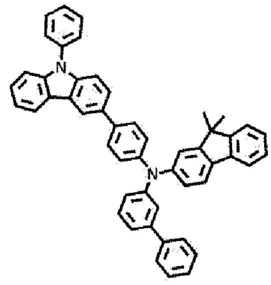

HT2

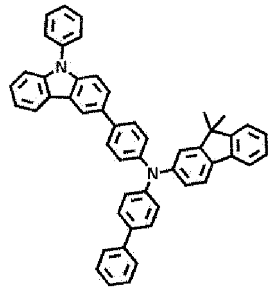

HT3

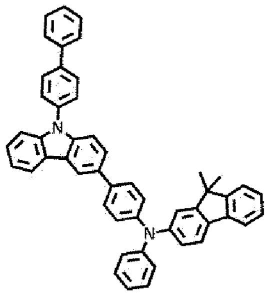

HT4

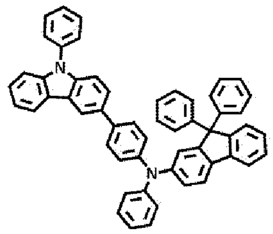

HT5

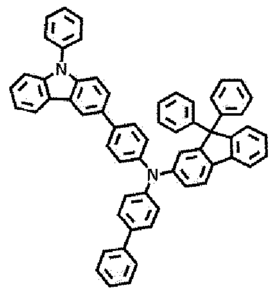

HT6

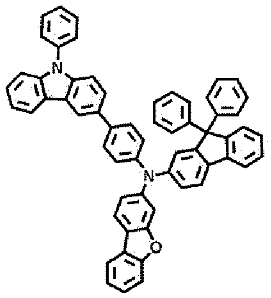

HT7

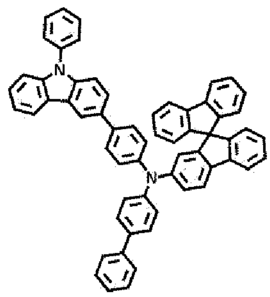

HT8

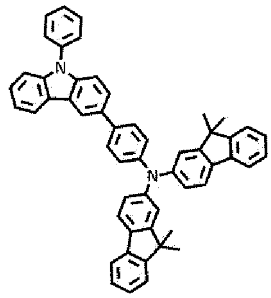

HT9

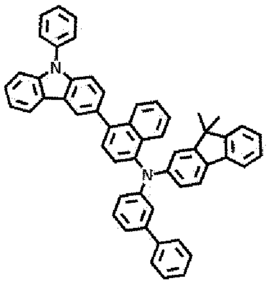

HT10

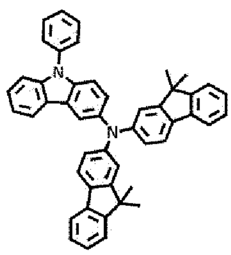

HT11

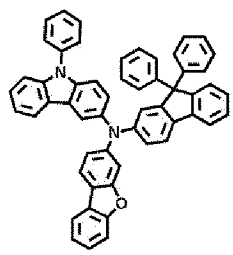

HT12

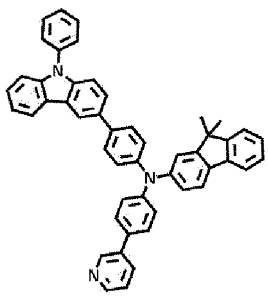

HT13

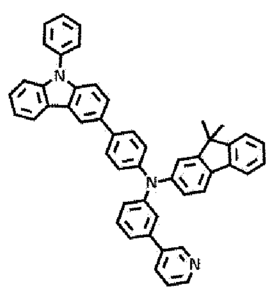

HT14

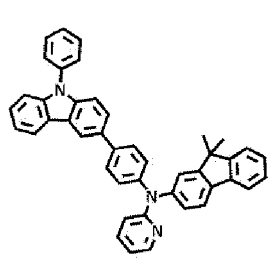

HT15

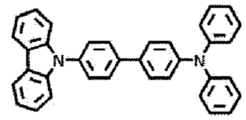

HT16

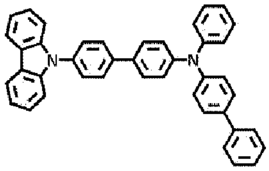

HT17

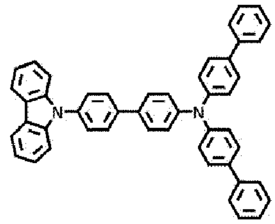

HT18

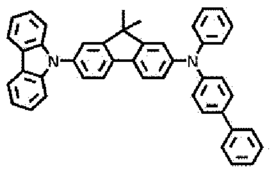

HT19

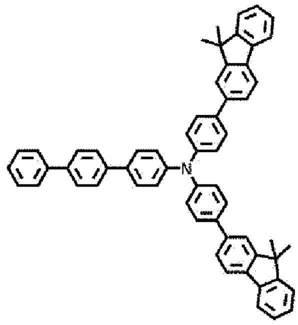

HT20

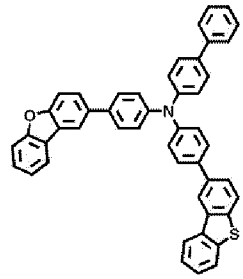

HT21

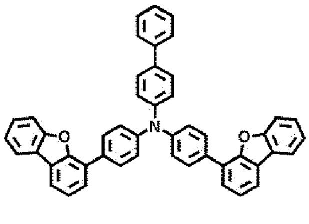

HT22

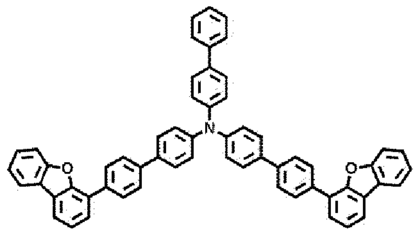

HT23

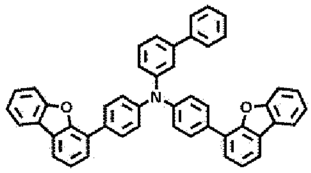

HT24

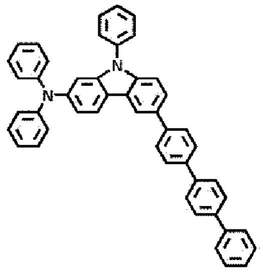

HT25

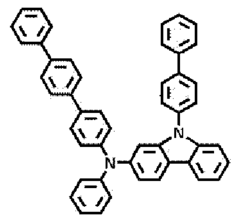

HT26

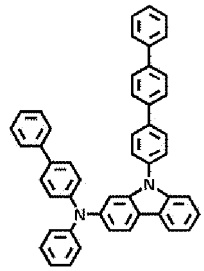

HT27

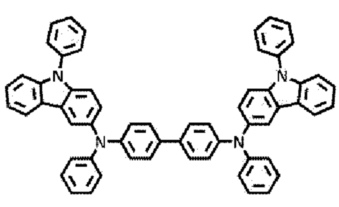

HT28

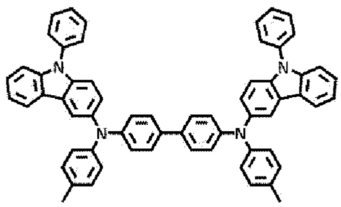

HT29

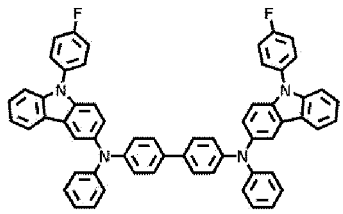

HT30

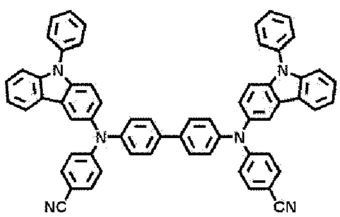

HT31

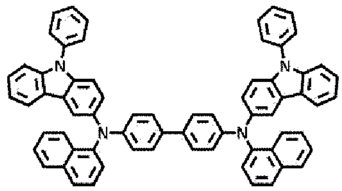

HT32

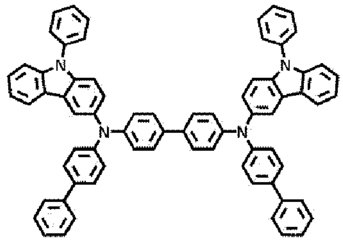

HT33

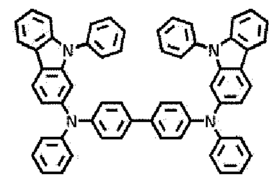

HT34

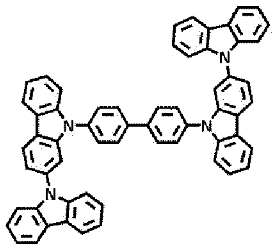

HT35

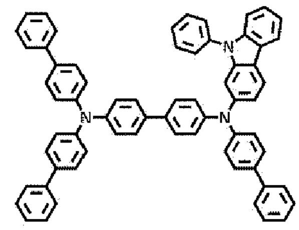

HT36

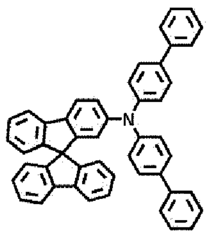

HT37

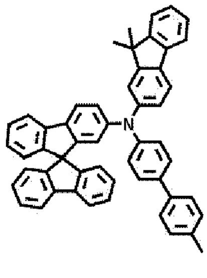

HT38

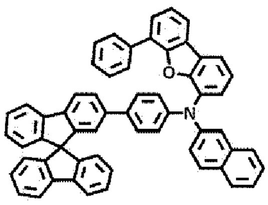

HT39

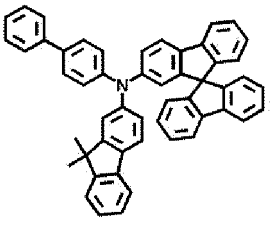

HT40

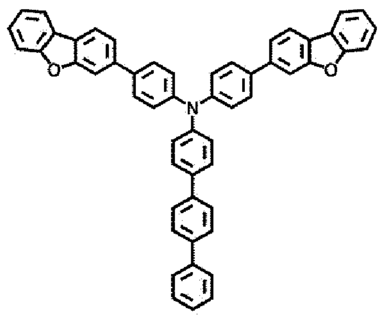

HT41

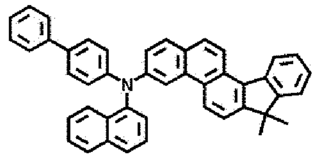

HT42

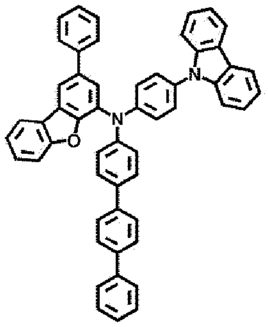

HT43

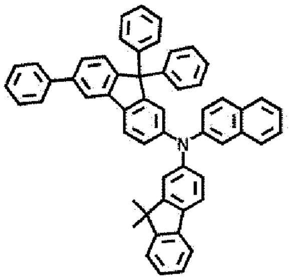

HT44

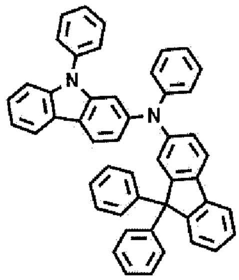

HT45

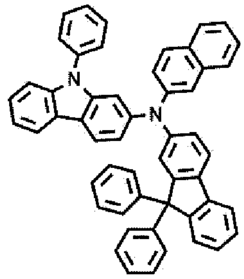

HT46

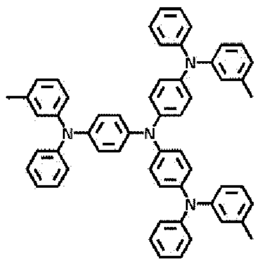

m-MTDATA

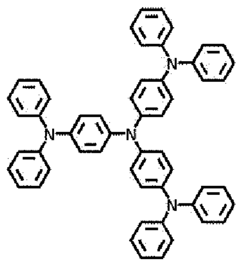

TDATA

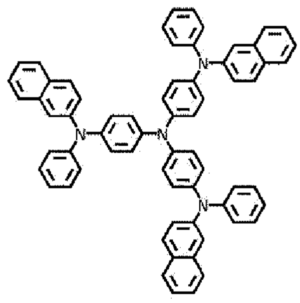

2-TNATA

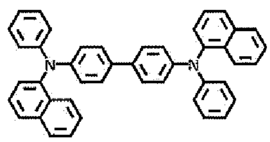

NPB

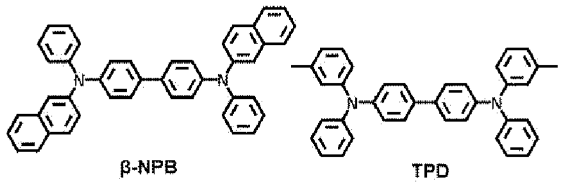

β-NPB

TPD

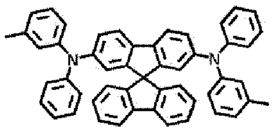

Spiro-TPD

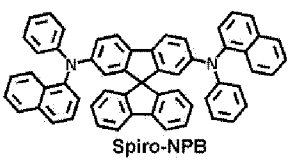

Spiro-NPB

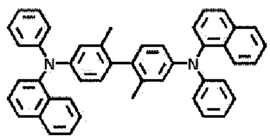

methylated-NPB

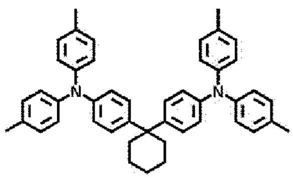

TAPC

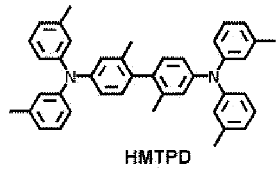

HMTPD

A thickness of the hole transport region may be in a range of about 50 Å (5nm) to about 10,000 Å (1000nm), for example, in a range of about 100 Å (100nm) to about 4,000 Å (400nm). In case that the hole transport region includes a hole injection layer, a hole transport layer, or any combination thereof, a thickness of the hole injection layer may be in a range of about 100 Å (10nm) to about 9,000 Å (900nm), for example, in a range of about 100 Å (10nm) to about 1,000 Å (100nm), and a thickness of the hole transport layer may be in a range of about 50 Å (5nm) to about 2,000 Å (200nm), for example, in a range of about 100 Å (10nm) to about 1,500 Å (150nm). In case that the thicknesses of the hole transport region, the hole injection layer, and the hole transport layer are in these ranges, satisfactory hole transporting characteristics may be obtained without a substantial increase in driving voltage.

The emission auxiliary layer may increase luminescence efficiency by compensating for an optical resonance distance according to the wavelength of light emitted by an emission layer, and the electron blocking layer may block the leakage of electrons from an emission layer to a hole transport region. Materials that may be included in the hole transport region may be included in the emission auxiliary layer and the electron blocking layer.

[p-dopant]

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material). The charge-generation material may be the same as or different from the charge generation compound included in the hole injection layer.

The charge-generation material may be, for example, a p-dopant.

In an embodiment, a lowest unoccupied molecular orbital (LUMO) energy level of the p-dopant may be about -3.5 eV or less.

According to an embodiment, the p-dopant may include a quinone derivative, a cyano group-containing compound, a compound including element EL1 and element EL2, or any combination thereof.

Examples of a quinone derivative may include TCNQ, F4-TCNQ, etc.

Examples of a cyano group-containing compound may include HAT-CN, and a compound represented by Formula 221:

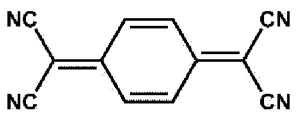

TCNQ

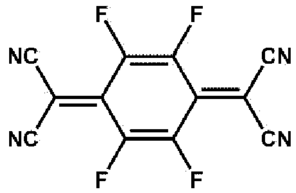

F4-TCNQ

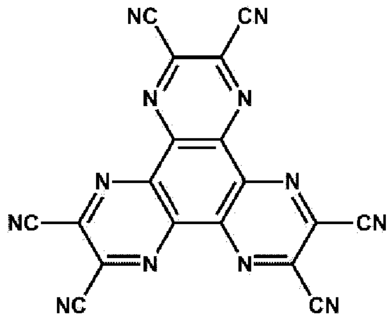

HAT-CN

[Formula 221]

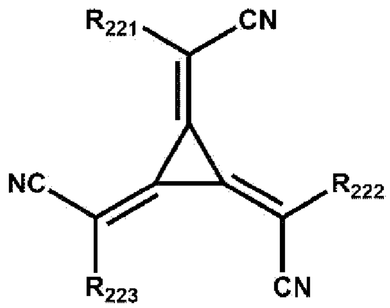

In Formula 221,

$R_{221}$ to $R_{223}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, $R_{10a}$ may be the same as described herein, and

at least one of $R_{221}$ to $R_{223}$ may each independently be a $C_3$-$C_{60}$ carbocyclic group or a $C_1$-$C_{60}$ heterocyclic group, each substituted with a cyano group; -F; -Cl; -Br; -I; a $C_1$-$C_{20}$ alkyl group substituted with a cyano group, -F, -Cl, -Br, -I, or any combination thereof; or any combination thereof.

In the compound including element EL1 and element EL2, element EL1 may be a metal, a metalloid, or any combination thereof, and element EL2 may be a non-metal, a metalloid, or any combination thereof.

Examples of a metal may include: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of a metalloid may include silicon (Si), antimony (Sb), and tellurium (Te).

Examples of a non-metal may include oxygen (O) and a halogen (for example, F, Cl, Br, I, etc.).

Examples of a compound including element EL1 and element EL2 may include a metal oxide, a metal halide (for example, a metal fluoride, a metal chloride, a metal bromide, or a metal iodide), a metalloid halide (for example, a metalloid fluoride, a metalloid chloride, a metalloid bromide, or a metalloid iodide), a metal telluride, or any combination thereof.

Examples of a metal oxide may include a tungsten oxide (for example, WO, $W_2O_3$, $WO_2$, $WO_3$, $W_2O_5$, etc.), a vanadium oxide (for example, VO, $V_2O_3$, $VO_2$, $V_2O_5$, etc.), a molybdenum oxide (for example, MoO, $Mo_2O_3$, $MoO_2$, $MoO_3$, MozOs, etc.), and a rhenium oxide (for example, $ReO_3$, etc.).

Examples of a metal halide may include an alkali metal halide, an alkaline earth metal halide, a transition metal halide, a post-transition metal halide, and a lanthanide metal halide.

Examples of an alkali metal halide may include LiF, NaF, KF, RbF, CsF, LiCl, NaCl, KCl, RbCl, CsCl, LiBr, NaBr, KBr, RbBr, CsBr, LiI, NaI, KI, RbI, and CsI.

Examples of an alkaline earth metal halide may include $BeF_2$, $MgF_2$, $CaF_2$, $SrF_2$, $BaF_2$, BeClz, $MgCl_2$, $CaCl_2$, SrClz, BaClz, $BeBr_2$, $MgBr_2$, $CaBr_2$, $SrBr_2$, $BaBr_2$, $BeI_2$, $MgI_2$, $CaI_2$, $SrI_2$, and $BaI_2$.

Examples of a transition metal halide may include a titanium halide (for example, $TiF_4$, $TiCl_4$, $TiBr_4$, $TiI_4$, etc.), a zirconium halide (for example, $ZrF_4$, $ZrCl_4$, $ZrBr_4$, $ZrI_4$, etc.), a hafnium halide (for example, $HfF_4$, $HfCl_4$, $HfBr_4$, $HfI_4$, etc.), a vanadium halide (for example, $VF_3$, $VCl_3$, $VBr_3$, $VI_3$, etc.), a niobium halide (for example, $NbF_3$, $NbCl_3$, $NbBr_3$, $NbI_3$, etc.), a tantalum halide (for example, $TaF_3$, $TaCl_3$, $TaBr_3$, $TaI_3$, etc.), a chromium halide (for example, $CrF_3$, $CrCl_3$, $CrBr_3$, $CrI_3$, etc.), a molybdenum halide (for example, $MoF_3$, $MoCl_3$, $MoBr_3$, $MoI_3$, etc.), a tungsten halide (for example, $WF_3$, $WCl_3$, $WBr_3$, $WI_3$, etc.), a manganese halide (for example, $MnF_2$, $MnCl_2$, $MnBr_2$, $MnI_2$, etc.), a technetium halide (for example, $TcF_2$, $TcCl_2$, $TcBr_2$, $TcI_2$, etc.), a rhenium halide (for example, $ReF_2$, $ReCl_2$, $ReBr_2$, $ReI_2$, etc.), an iron halide (for example, $FeF_2$, $FeCl_2$, $FeBr_2$, $FeI_2$, etc.), a ruthenium halide (for example, $RuF_2$, $RuCl_2$, $RuBr_2$, $RuI_2$, etc.), an osmium halide (for example, $OsF_2$, $OsCl_2$, $OsBr_2$, $OsI_2$, etc.), a cobalt halide (for example, $CoF_2$, CoClz, $CoBr_2$, $CoI_2$, etc.), a rhodium halide (for example, $RhF_2$, RhClz, $RhBr_2$, $RhI_2$, etc.), an iridium halide (for example, $IrF_2$, $IrCl_2$, $IrBr_2$, $IrI_2$, etc.), a nickel halide (for example, $NiF_2$, NiClz, $NiBr_2$, $NiI_2$, etc.), a palladium halide (for example, $PdF_2$, PdClz, $PdBr_2$, $PdI_2$, etc.), a platinum halide (for example, $PtF_2$, PtClz, $PtBr_2$, $PtI_2$, etc.), a copper halide (for example, CuF, CuCl, CuBr, CuI, etc.), a silver halide (for example, AgF, AgCl, AgBr, AgI, etc.), and a gold halide (for example, AuF, AuCl, AuBr, AuI, etc.).

Examples of a post-transition metal halide may include a zinc halide (for example, $ZnF_2$, $ZnCl_2$, $ZnBr_2$, $ZnI_2$, etc.), an indium halide (for example, $InI_3$, etc.), and a tin halide (for example, $SnI_2$, etc.).

Examples of a lanthanide metal halide may include YbF, $YbF_2$, $YbF_3$, $SmF_3$, YbCl, $YbCl_2$, $YbCl_3$, $SmCl_3$, YbBr, $YbBr_2$, $YbBr_3$, $SmBr_3$, YbI, $YbI_2$, $YbI_3$, and $SmI_3$.

Examples of a metalloid halide may include an antimony halide (for example, $SbCl_5$, etc.).

Examples of a metal telluride may include an alkali metal telluride (for example, $Li_2Te$, $Na_2Te$, $K_2Te$, $Rb_2Te$, $Cs_2Te$, etc.), an alkaline earth metal telluride (for example, BeTe, MgTe, CaTe, SrTe, BaTe, etc.), a transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, etc.), a post-transition metal telluride (for example, ZnTe, etc.), and a lanthanide metal telluride (for example, LaTe, CeTe, PrTe, NdTe, PmTe, EuTe, GdTe, TbTe, DyTe, HoTe, ErTe, TmTe, YbTe, LuTe, etc.).

[Emission layer in interlayer 150]

In case that the light-emitting device 10, 10' and 10" are a full-color light-emitting device, the emission layer may be patterned into a red emission layer, a green emission layer, and/or a blue emission layer, according to a subpixel. For example, the emission layer may have a stacked structure of two or more layers of a red emission layer, a green emission layer, and a blue emission layer, in which the two or more layers contact each other or are separated from each other to emit white light, or a mixed structure of two or more materials of a red light-emitting material, a green light-emitting material, and a blue light-emitting material, in which the two or more materials are mixed with each other in a single layer to emit white light.

The emission layer may include a host and a dopant. The dopant may include a phosphorescent dopant, a fluorescent dopant, or any combination thereof.

The amount of the dopant in the emission layer may be from about 0.01 part by weight to about 15 parts by weight based on 100 parts by weight of the host.

For example, the emission layer may include a quantum dot.

The emission layer may include a delayed fluorescence material. The delayed fluorescence material may act as a host or a dopant in the emission layer.

A thickness of the emission layer may be in a range of about 100 Å to about 1,000 Å, for example, in a range of about 200 Å to about 600 Å. In case that the thickness of the emission layer is in these ranges, excellent luminescence characteristics may be obtained without a substantial increase in driving voltage.

[Host]

The host may include a compound represented by Formula 301:

[Formula 301] $[Ar_{301}]_{xb11}$-$[(L_{301})_{xb1}$-$R_{301}]_{xb21}$

In Formula 301,

$Ar_{301}$ and $L_{301}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
xb11 may be 1, 2, or 3,
xb1 may be an integer from 0 to 5,
$R_{301}$ may be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -Si($Q_{301}$)($Q_{302}$)($Q_{303}$), -N($Q_{301}$)($Q_{302}$), -B($Q_{301}$)($Q_{302}$), - C(=O)($Q_{301}$), -S(=O)$_2$($Q_{301}$), or -P(=O)($Q_{301}$)($Q_{302}$),
xb21 may be an integer from 1 to 5, and
$Q_{301}$ to $Q_{303}$ may each independently be the same as described herein with respect to $Q_1$. $R_{10a}$ may be the same as described herein.

In an embodiment, in Formula 301, in case that xb11 is 2 or more, two or more of $Ar_{301}$(s) may be linked to each other via a single bond.

In an embodiment, the host may include a compound represented by Formula 301-1, a compound represented by Formula 301-2, or any combination thereof:

[Formula 301-1]

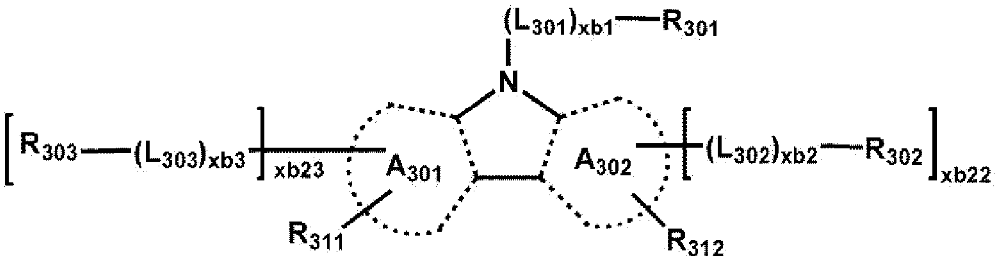

[Formula 301-2]

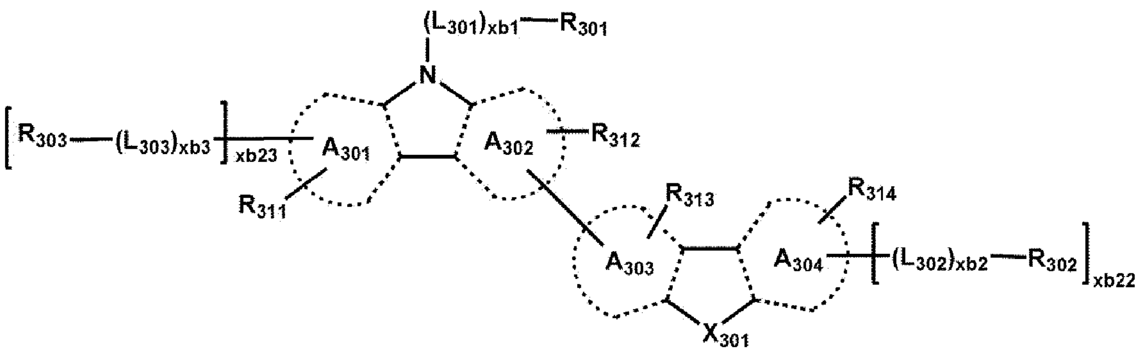

In Formulae 301-1 and 301-2,

ring $A_{301}$ to ring $A_{304}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
$X_{301}$ may be O, S, N[$(L_{304})_{xb4}$-$R_{304}$], C($R_{304}$)($R_{305}$), or Si($R_{304}$)($R_{303}$),

xb22 and xb23 may each independently be 0, 1, or 2,

$L_{301}$, xb1, and $R_{301}$ may each be the same as described herein,

$L_{302}$ to $L_{304}$ may each independently be the same as described herein with respect to with $L_{301}$,

xb2 to xb4 may each independently be the same as described herein with respect to xb1, and

$R_{302}$ to $R_{303}$ and $R_{311}$ to $R_{314}$ may each independently be the same as described herein with respect to $R_{301}$.

In an embodiment, the host may include an alkali earth metal complex, a post-transition metal complex, or any combination thereof. For example, the host may include a Be complex (for example, Compound H55), an Mg complex, a Zn complex, or any combination thereof.

In an embodiment, the host may include one of Compounds H1 to H124, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di(9-carbazolyl)benzene (mCP), 1,3,5-tri(carbazol-9-yl)benzene (TCP), or any combination thereof:

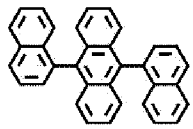
H1

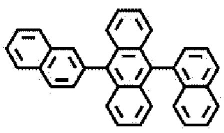
H2

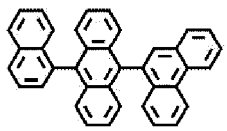
H3

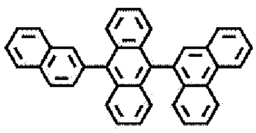
H4

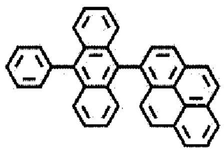
H5

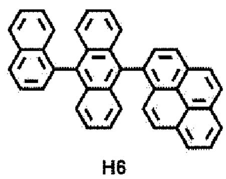
H6

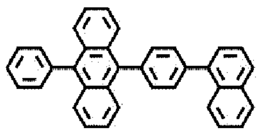
H7

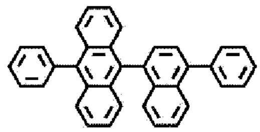
H8

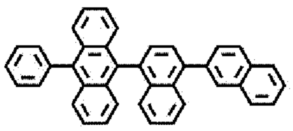
H9

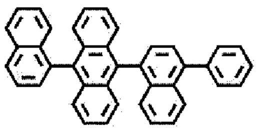
H10

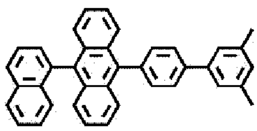
H11

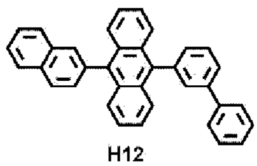
H12

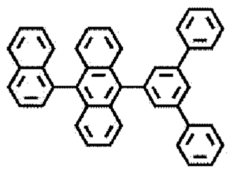
H13

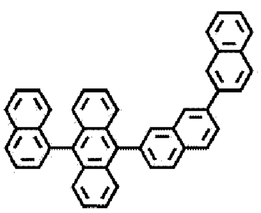
H14

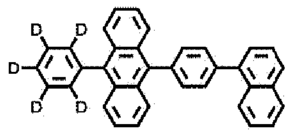
H15

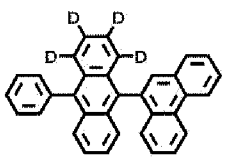
H16

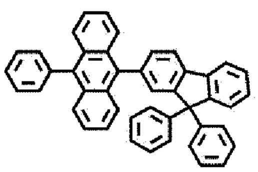
H17

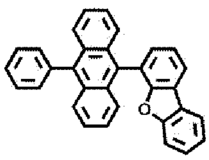
H18

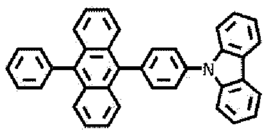
H19

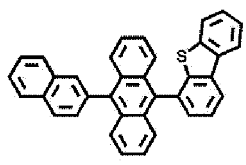
H20

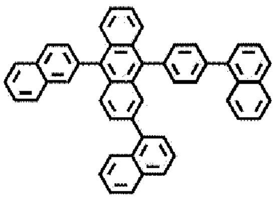
H21

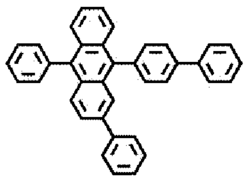
H22

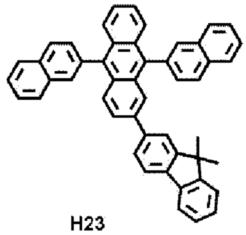
H23

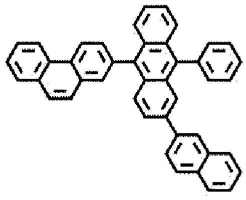
H24

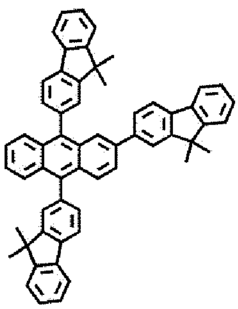
H25

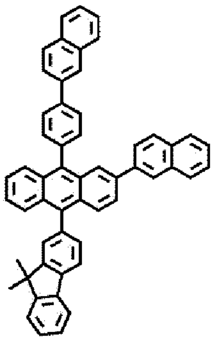
H26

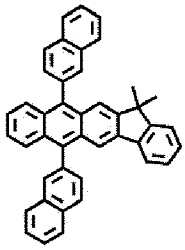
H27

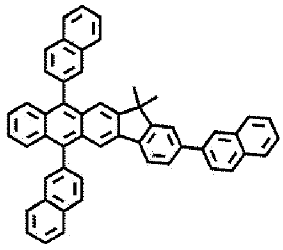
H28

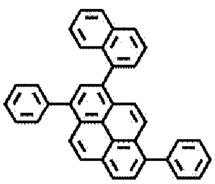
H29

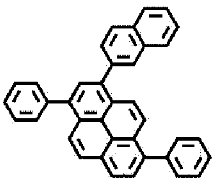
H30

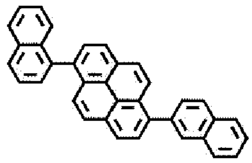
H31

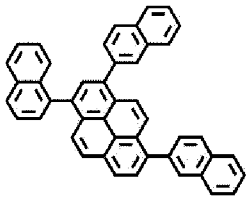
H32

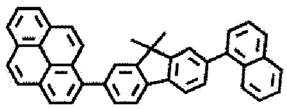
H33

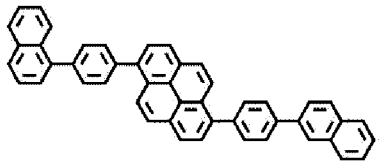
H34

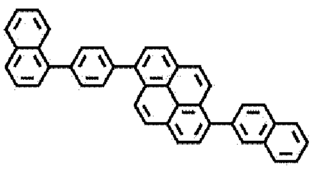
H35

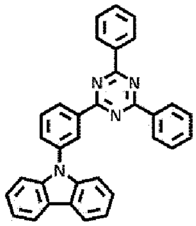
H36

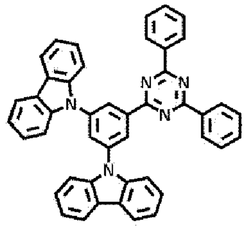
H37

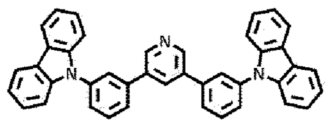
H38

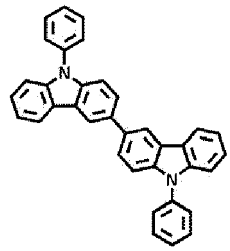
H39

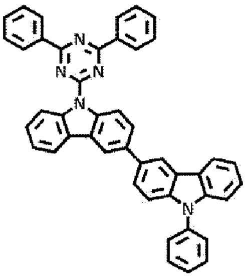

H40

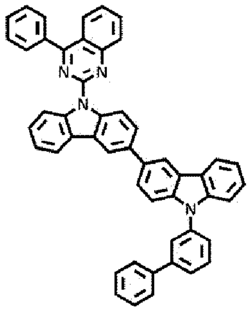

H41

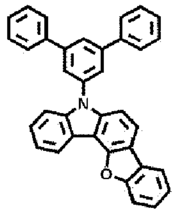

H42

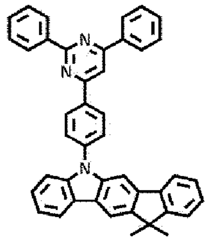

H43

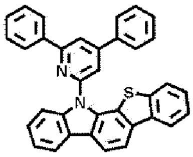

H44

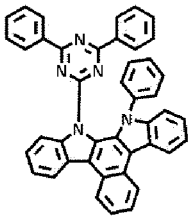

H45

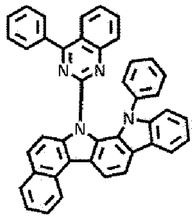

H46

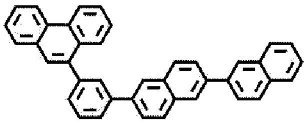

H47

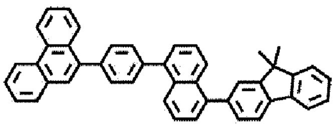

H48

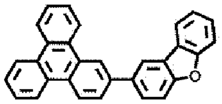

H49

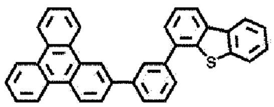

H50

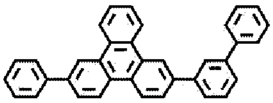

H51

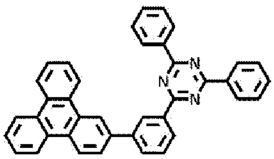

H52

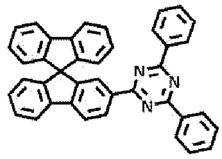

H53

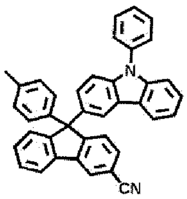

H54

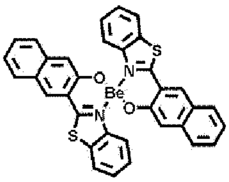

H55

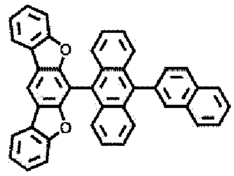

H56

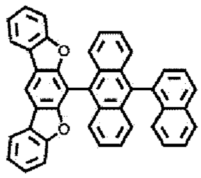

H57

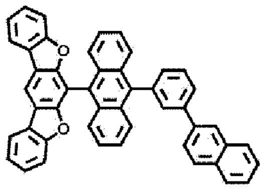

H58

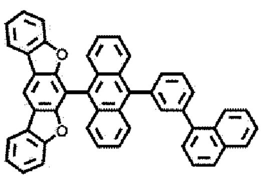

H59

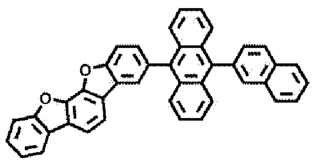

H60

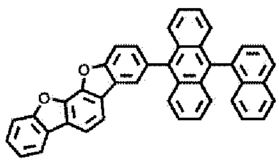

H61

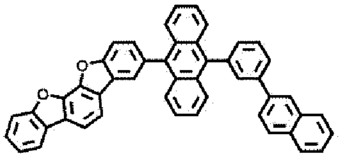

H62

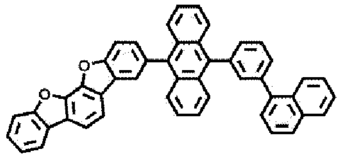

H63

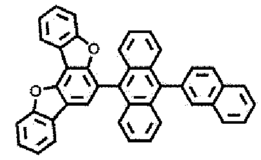

H64

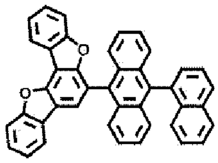

H65

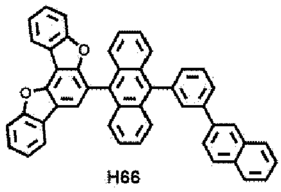

H66

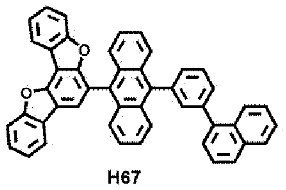

H67

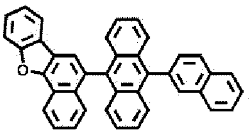

H68

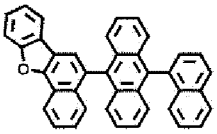

H69

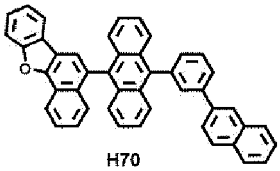

H70

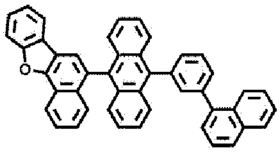

H71

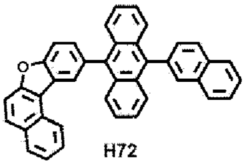

H72

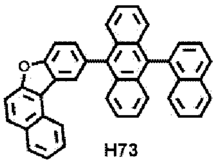

H73

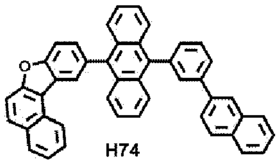

H74

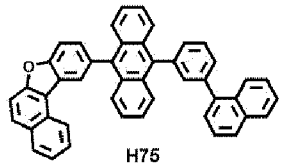

H75

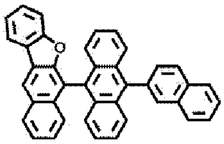

H76

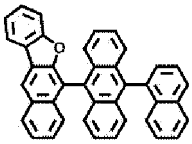

H77

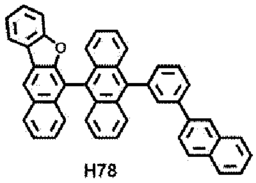

H78

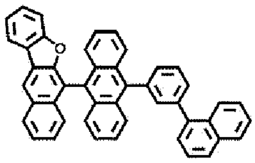

H79

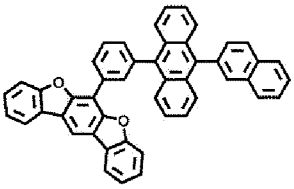

H80

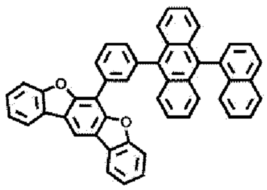

H81

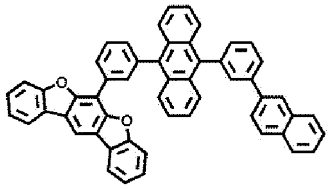

H82

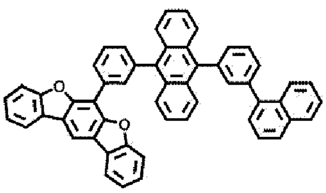

H83

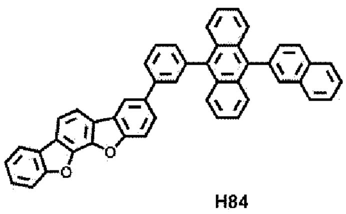

H84

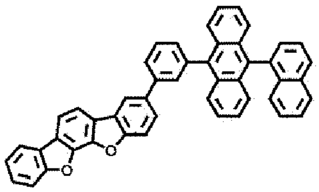

H85

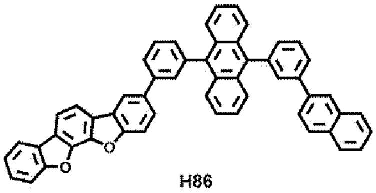
H86

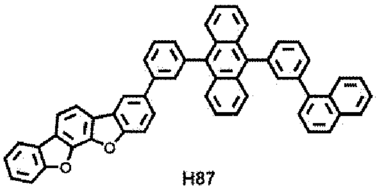
H87

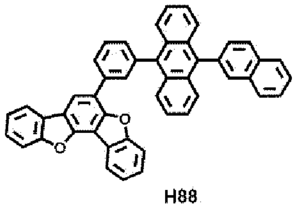
H88

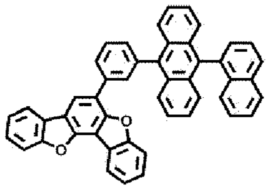
H89

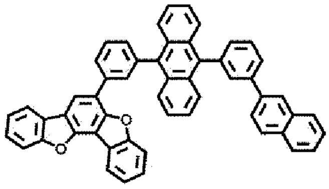
H90

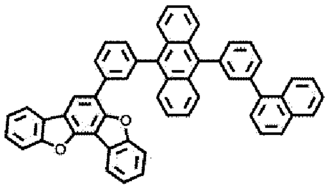
H91

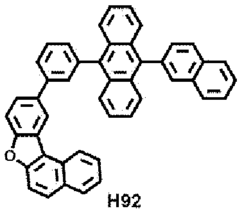
H92

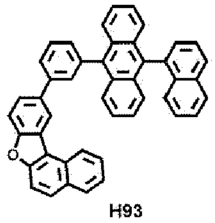
H93

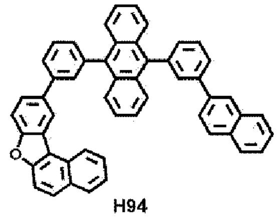
H94

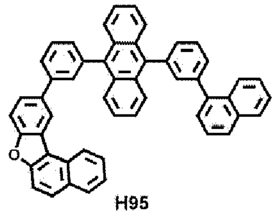
H95

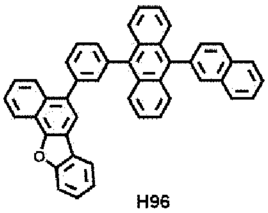
H96

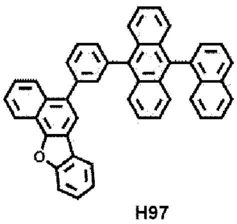
H97

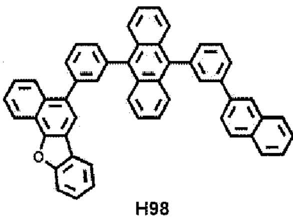
H98

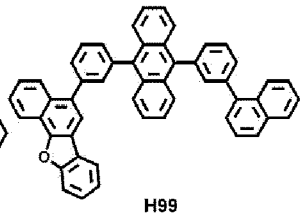
H99

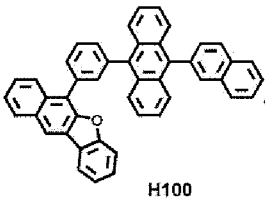
H100

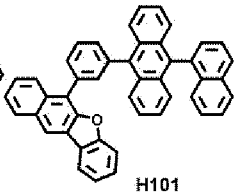
H101

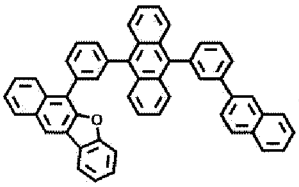
H102

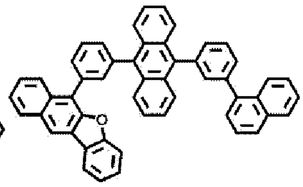
H103

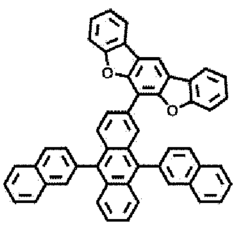
H104

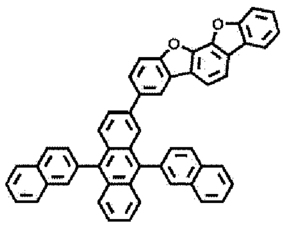
H105

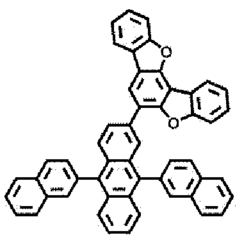
H106

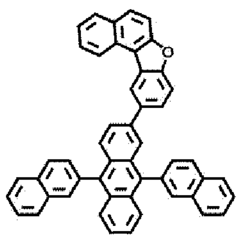
H107

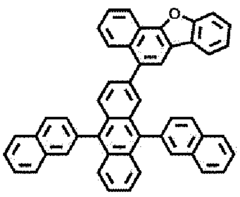 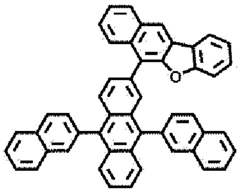 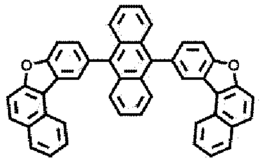 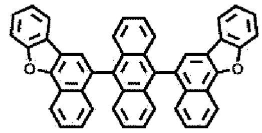

H108 H109 H110 H111

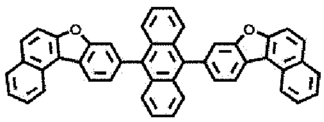 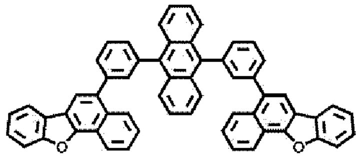 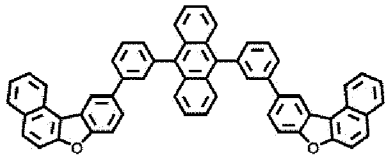

H112 H113 H114

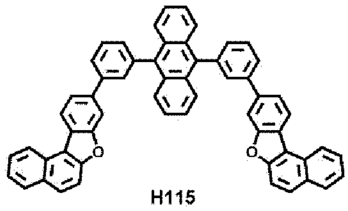 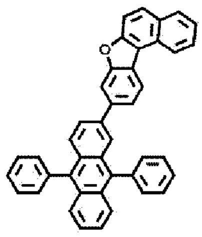 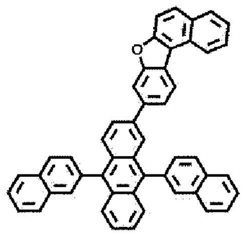

H115 H116 H117

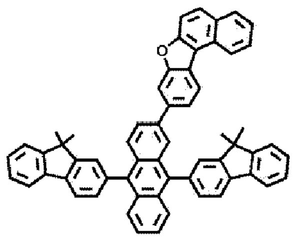 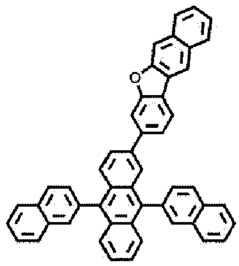 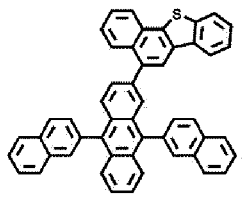

H118 H119 H120

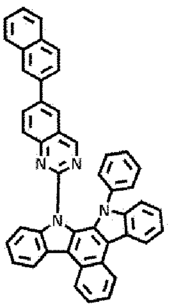 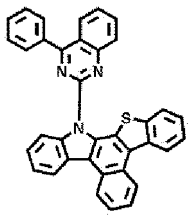 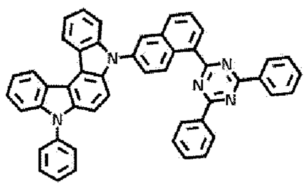 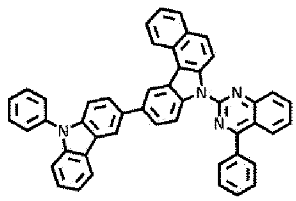

H121 H122 H123 H124

According to an embodiment, the host may include a hole transport host and an electron transport host.

In the specification, the term "hole transport host" may be a compound that includes a hole transport moiety.

In the specification, the term "electron transport host" may be a compound having bipolar properties or a compound that includes an electron transport moiety.

In this specification, a "hole transport host" and an "electron transport host" may be understood according to a relative difference in hole mobility and electron mobility between them. For example, even in case that the electron transport host does not include an electron transport moiety, a bipolar compound exhibiting relatively higher electron mobility than the hole transport host may be understood as an electron transport host.

According to an embodiment, the hole transport host may be represented by one of Formulae 311-1 to 311-6, and

the electron transport host may be represented by one of Formulae 312-1 to 312-4 and 313:

[Formula 311-1]

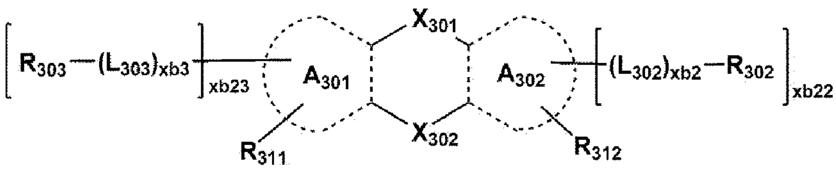

[Formula 311-2]

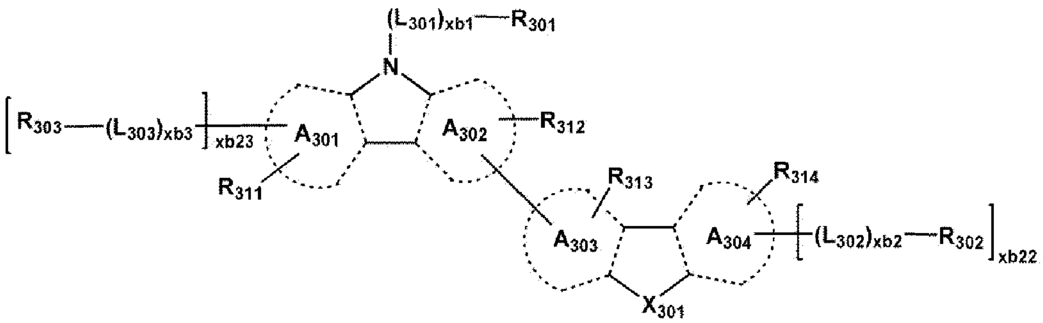

[Formula 311-3]

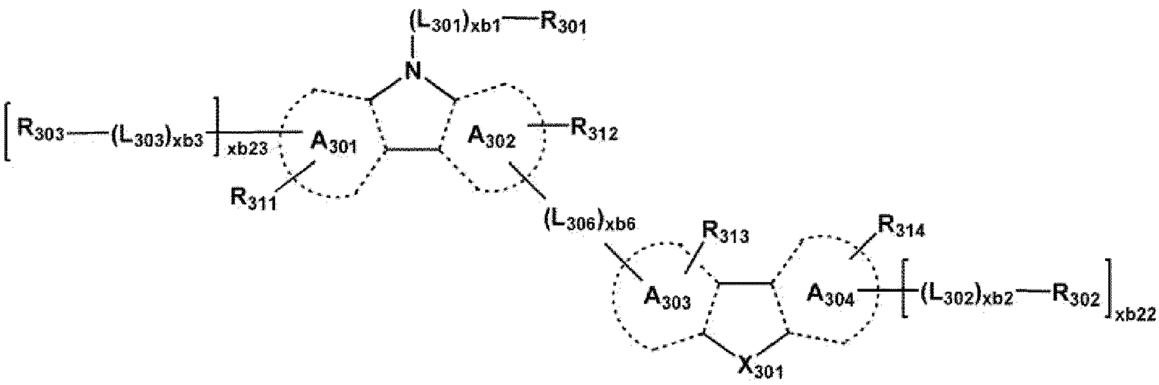

[Formula 311-4]

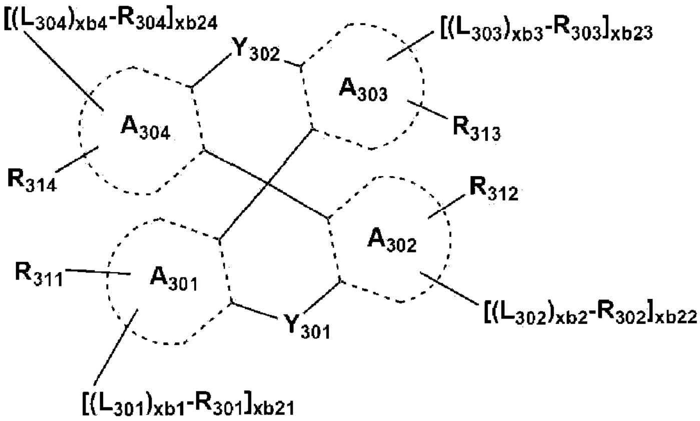

[Formula 311-5]

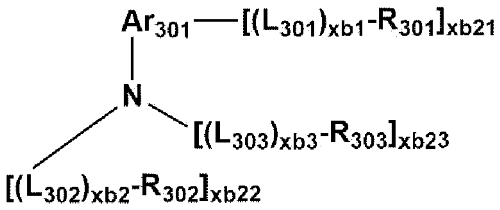

[Formula 311-6]

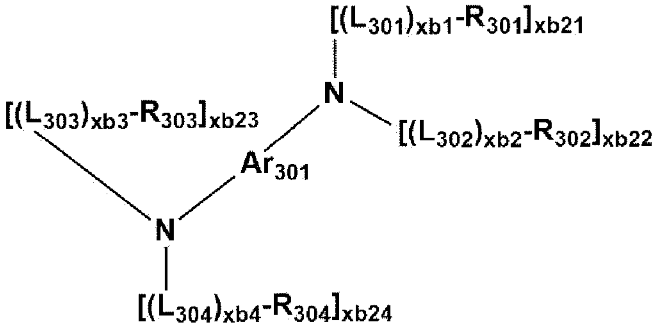

[Formula 312-1]

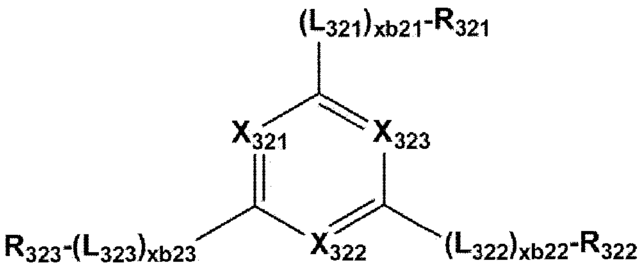

[Formula 312-2]

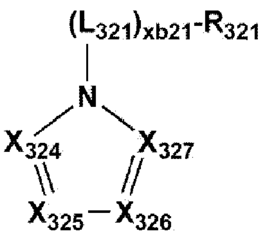

[Formula 312-3]

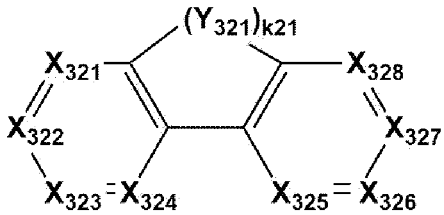

[Formula 312-4]

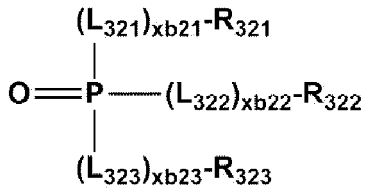

[Formula 313]

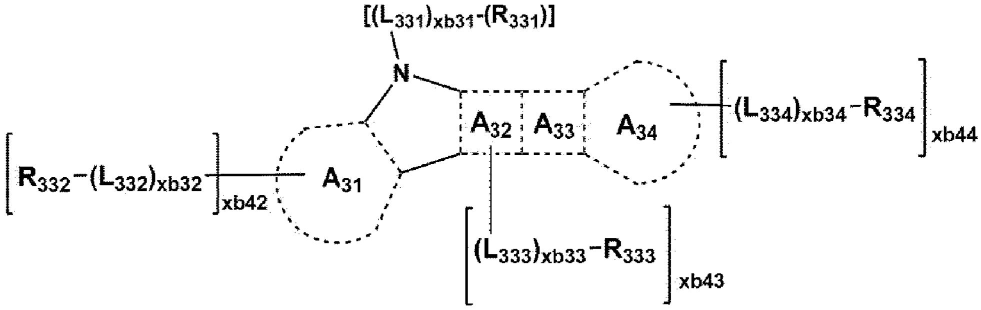

[Formula 313A]

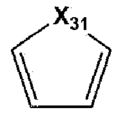

In Formulae 311-1 to 311-6, 312-1 to 312-4, 313, and 313A,

$Ar_{301}$ may be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
$A_{301}$ to $A_{304}$ may each independently be a $C_3$-$C_{60}$ carbocyclic group or a $C_1$-$C_{60}$ heterocyclic group,
$X_{301}$ may be O, S, $N[(L_{304})_{xb4}$-$R_{304}]$, $C[(L_{304})_{xb4}$-$R_{304}][(L_{303})_{xb3}$-$R_{303}]$, or $Si[(L_{304})_{xb4}$-$R_{304}][(L_{305})_{xb5}$-$R_{305}]$,
$X_{302}$, $Y_{301}$, and $Y_{302}$ may each independently be a single bond, O, S, N-$[(L_{305})_{xb5}$-$R_{303}]$, $C[(L_{304})_{xb4}$-$R_{304}][(L_{305})_{xb5}$-$R_{305}]$, $Si[(L_{304})_{xb4}$-$R_{304}][(L_{305})_{xb5}$-$R_{305}]$, or $S(=O)_2$,
xb1 to xb5 may each independently be 0, 1, 2, 3, 4, or 5,
xb6 may be 1, 2, 3, 4, or 5,
$X_{321}$ to $X_{328}$ may each independently be N or $C[(L_{324})_{xb24}$-$R_{324}]$,
$Y_{321}$ may be *-O-*', *-S-*', *-$N[(L_{325})_{xb25}$-$R_{325}]$-*', *-$C[(L_{325})_{xb25}$-$R_{325}][(L_{326})_{xb26}$-R326] -*', *-$C[(L_{325})_{xb25}$-$R_{325}]$=$C[(L_{326})_{xb26}$-$R_{326}]$-*', *-$C[(L_{325})_{xb25}$-$R_{325}]$=N-*', or *-N= $C[(L_{326})_{xb26}$-$R_{326}]$-*', * and *' indicate a binding site to a neighboring atom,
k21 may be 0, 1, or 2, wherein $Y_{321}$ does not exist in case that k21 is 0,
xb21 to xb26 may each independently be 0, 1, 2, 3, 4, or 5,
$A_{31}$, $A_{32}$, and $A_{34}$ may each independently be a $C_3$-$C_{60}$ carbocyclic group or a $C_1$-$C_{30}$ heterocyclic group,
$A_{33}$ may be a group represented by Formula 313A,
$X_{31}$ may be $N[(L_{335})_{xb35}$-$(R_{335})]$, O, S, Se, $C[(L_{335})_{xb35}$-$(R_{335})][(L_{336})_{xb36}$-$(R_{336})]$, or $Si[(L_{335})_{xb35}$-$(R_{335})][(L_{336})_{xb36}$-$(R_{336})]$,
xb31 to xb36 may each independently be 0, 1, 2, 3, 4, or 5,
xb42 to xb44 may each independently be 0, 1, 2, 3, 4, 5, 6, 7, 8, 9, or 10,
$L_{301}$ to $L_{306}$, $L_{321}$ to $L_{326}$, and $L_{331}$ to $L_{336}$ may each independently be a single bond, a $C_1$-$C_{20}$ alkylene group unsubstituted or substituted with at least one $R_{10a}$, a $C_1$-$C_{20}$ alkenylene group unsubstituted or substituted with at least one $R_{10a}$, a $C_1$-$C_{20}$ alkynylene group unsubstituted or substituted with at least one $R_{10a}$, a $C_3$-$C_{10}$ cycloalkylene group unsubstituted or substituted with at least one $R_{10a}$, a $C_1$-$C_{10}$ heterocycloalkylene group unsubstituted or substituted with at least one $R_{10a}$, a $C_3$-$C_{10}$ cycloalkenylene group unsubstituted or substituted with at least one $R_{10a}$, a $C_1$-$C_{10}$ heterocycloalkenylene group unsubstituted or substituted with at least one $R_{10a}$, a $C_6$-$C_{60}$ arylene group unsubstituted or substituted with at least one $R_{10a}$, a $C_1$-$C_{60}$ heteroarylene group unsubstituted or substituted with at least one $R_{10a}$, a divalent non-aromatic condensed polycyclic group unsubstituted or substituted with at least one

$R_{10a}$, or a divalent non-aromatic condensed heteropolycyclic group unsubstituted or substituted with at least one $R_{10a}$, $R_{301}$ to $R_{303}$, $R_{311}$ to $R_{314}$, $R_{321}$ to $R_{326}$, and $R_{331}$ to $R_{336}$ may each independently be hydrogen, deuterium, -F, -Cl, -Br, -I, a hydroxyl group, a cyano group, a nitro group, an amidino group, a hydrazino group, a hydrazono group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{10}$ cycloalkyl group unsubstituted or substituted with at least one $R_{10a}$, a $C_1$-$C_{10}$ heterocycloalkyl group unsubstituted or substituted with at least one $R_{10a}$, a $C_3$-$C_{10}$ cycloalkenyl group unsubstituted or substituted with at least one $R_{10a}$, a $C_1$-$C_{10}$ heterocycloalkenyl group unsubstituted or substituted with at least one $R_{10a}$, a $C_6$-$C_{60}$ aryl group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, a $C_1$-$C_{60}$ heteroaryl group unsubstituted or substituted with at least one $R_{10a}$, a $C_1$-$C_{60}$ heteroaryloxy group unsubstituted or substituted with at least one $R_{10a}$, a $C_1$-$C_{60}$ heteroarylthio group unsubstituted or substituted with at least one $R_{10a}$, a monovalent non-aromatic condensed polycyclic group unsubstituted or substituted with at least one $R_{10a}$, a monovalent non-aromatic condensed heteropolycyclic group unsubstituted or substituted with at least one $R_{10a}$, -Si($Q_1$)($Q_2$)($Q_3$), -B($Q_1$)($Q_2$), -N($Q_1$)($Q_2$), -P($Q_1$)($Q_2$), -C(=O)($Q_1$), -S(=O)($Q_1$), -S(=O)$_2$($Q_1$), -P(=O)($Q_1$)($Q_2$), or -P(=S)($Q_1$)($Q_2$),

two or more neighboring substituents among $R_{321}$ to $R_{326}$ may be optionally bonded together to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, and

$R_{10a}$ may be:

deuterium, -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_1$-$C_{60}$ heteroaryloxy group, a $C_1$-$C_{60}$ heteroarylthio group, -Si($Q_{11}$)($Q_{12}$)($Q_{13}$), -N($Q_{11}$)($Q_{12}$), -B($Q_{11}$)($Q_{12}$), -C(=O)($Q_{11}$), - S(=O)$_2$($Q_{11}$), -P(=O)($Q_{11}$)($Q_{12}$), or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_1$-$C_{60}$ heteroaryloxy group, or a $C_1$-$C_{60}$ heteroarylthio group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_1$-$C_{60}$heteroaryloxy group, a $C_1$-$C_{60}$heteroarylthio group, -Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), - P(=O)($Q_{21}$)($Q_{22}$), or any combination thereof; or

-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$), and

$Q_1$ to $Q_3$, $Q_{11}$ to $Q_{13}$, $Q_{21}$ to $Q_{23}$, $Q_{31}$ to $Q_{33}$, $Q_{41}$ to $Q_{43}$, $Q_{301}$ to $Q_{303}$, $Q_{321}$ to $Q_{323}$, and $Q_{331}$ to $Q_{333}$ may each independently be: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; or a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

[Phosphorescent dopant]

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

In an embodiment, the phosphorescent dopant may include an organometallic compound represented by Formula 401:

[Formula 401] $M(L_{401})_{xc1}(L_{402})_{xc2}$

[Formula 402]

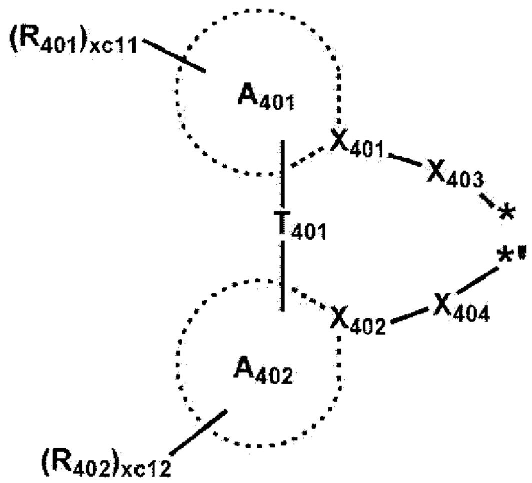

In Formulae 401 and 402,

M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
$L_{401}$ may be a ligand represented by Formula 402, and xc1 may be 1, 2, or 3, wherein in case that xc1 is two or more, two or more of $L_{401}$(s) may be the same as or different from each other,
$L_{402}$ may be an organic ligand, and xc2 may be 0, 1, 2, 3, or 4, wherein in case that xc2 is 2 or more, two or more of $L_{402}$ (s) may be the same as or different from each other,
$X_{401}$ and $X_{402}$ may each independently be nitrogen or carbon,
ring $A_{401}$ and ring $A_{402}$ may each independently be a $C_3$-$C_{60}$ carbocyclic group or a $C_1$-$C_{60}$ heterocyclic group,
$T_{401}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$) =*', or *=C=*', * and *' indicate a binding site to a neighboring atom,
$X_{403}$ and $X_{404}$ may each independently be a chemical bond (for example, a covalent bond or a coordination bond), O, S, N(Q413), B($Q_{413}$), P($Q_{413}$), C(Q413)(Q414), or Si($Q_{413}$)($Q_{414}$),
$Q_{411}$ to $Q_{414}$ may each independently be the same as described herein with respect to $Q_1$,
$R_{401}$ and $R_{402}$ may each independently be hydrogen, deuterium, -F, -Cl, -Br, -I, a hydroxyl group, a cyano group, a nitro group, a $C_1$-$C_{20}$ alkyl group unsubstituted or substituted with at least one $R_{10a}$, a $C_1$-$C_{20}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, - Si($Q_{401}$)($Q_{402}$)($Q_{403}$), -N($Q_{401}$)($Q_{402}$), -B($Q_{401}$)($Q_{402}$), -C(=O)($Q_{401}$), -S(=O)$_2$($Q_{401}$), or - P(=O)($Q_{401}$)($Q_{402}$), $R_{10a}$ may be the same as described herein,
$Q_{401}$ to $Q_{403}$ may each independently be the same as described herein with respect to $Q_1$,
xc11 and xc12 may each independently be an integer from 0 to 10, and
* and *' in Formula 402 each indicates a binding site to M in Formula 401.

For example, in Formula 402, $X_{401}$ may be nitrogen and $X_{402}$ may be carbon, or $X_{401}$ and $X_{402}$ may each be nitrogen.

In an embodiment, in Formula 401, in case that xc1 is 2 or more, two ring $A_{401}$(s) among two or more of $L_{401}$ may optionally be bonded to each other via $T_{402}$, which may be a linking group, and two ring $A_{402}$(s) among two or more of $L_{401}$ may optionally be bonded to each other via $T_{403}$, which may be a linking group (see Compounds PD1 to PD4 and PD7). $T_{402}$ and $T_{403}$ may each independently be the same as described herein with respect to $T_{401}$.

In Formula 401, $L_{402}$ may be an organic ligand. For example, $L_{402}$ may include a halogen group, a diketone group (for example, an acetylacetonate group), a carboxylic acid group (for example, a picolinate group), -C(=O), an isonitrile group, -CN group, a phosphorus-containing group (for example, a phosphine group, a phosphite group, etc.), or any combination thereof.

In an embodiment, the phosphorescent dopant may include, for example, one of Compounds PD1 to PD39, or any combination thereof:

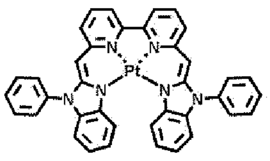
PD1

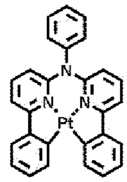
PD2

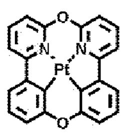
PD3

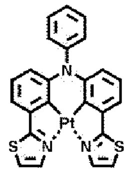
PD4

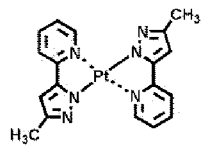
PD5

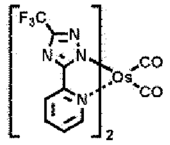
PD6

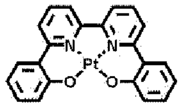
PD7

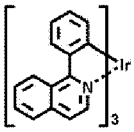
PD8

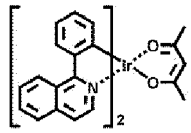
PD9

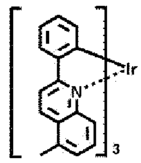
PD10

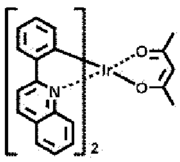
PD11

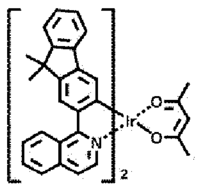
PD12

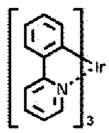
PD13

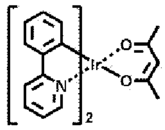
PD14

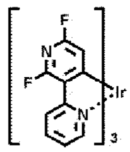
PD15

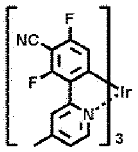
PD16

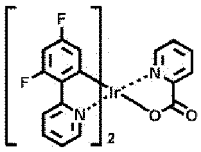
PD17

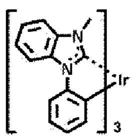
PD18

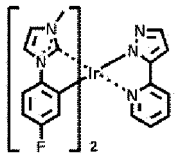
PD19

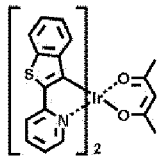
PD20

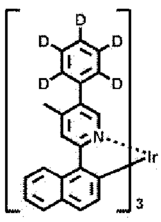
PD21

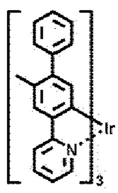
PD22

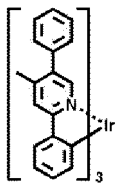
PD23

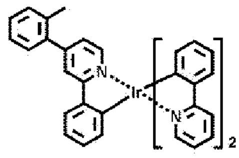
PD24

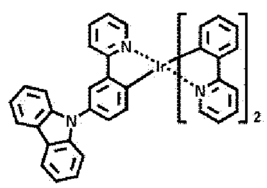
PD25

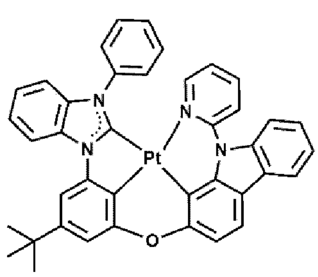
PD26

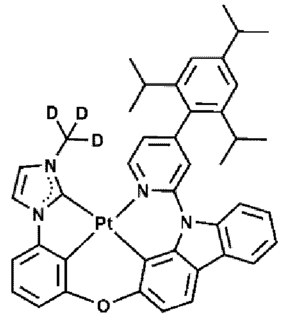
PD27

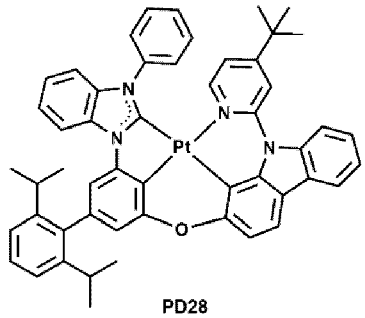
PD28

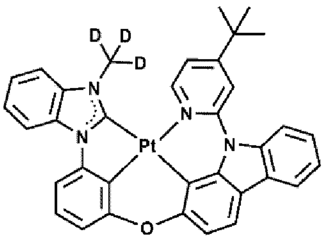

PD29

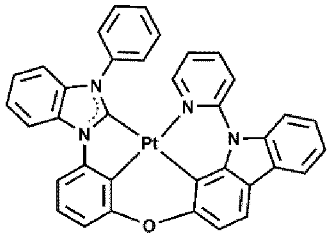

PD30

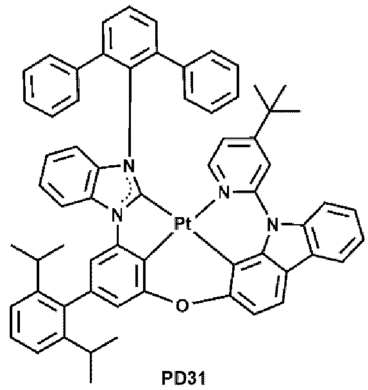

PD31

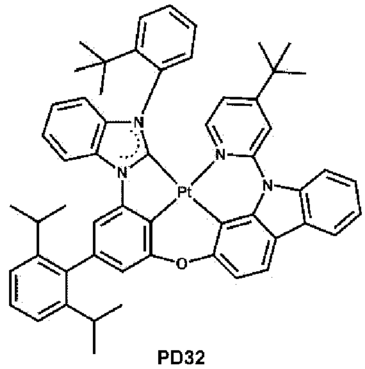

PD32

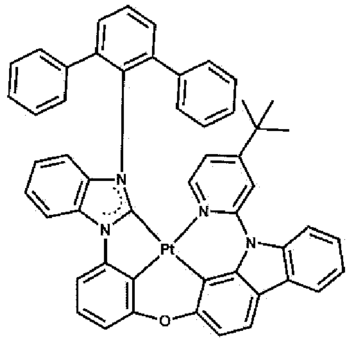

PD33

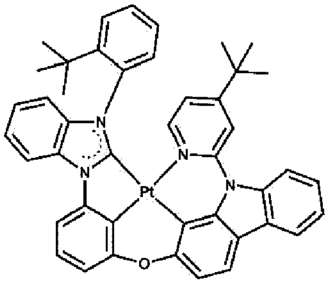

PD34

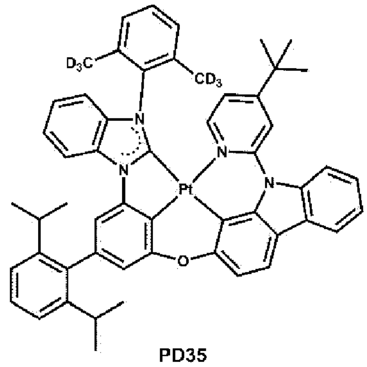

PD35

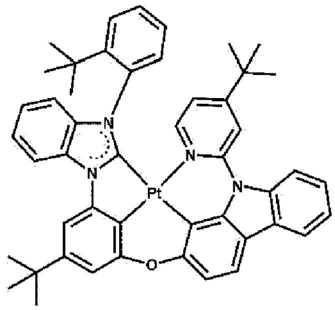

PD36

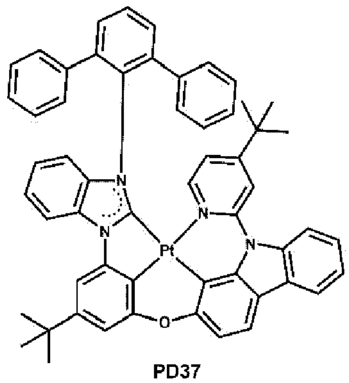

PD37

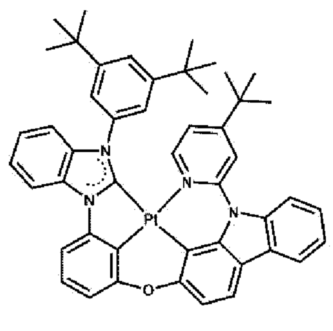

PD38

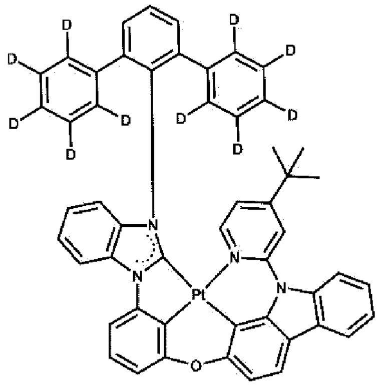

PD39 .

[Fluorescent dopant]

The fluorescent dopant may include an amine group-containing compound, a styryl group-containing compound, or any combination thereof.

In an embodiment, the fluorescent dopant may include a compound represented by Formula 501:

[Formula 501]

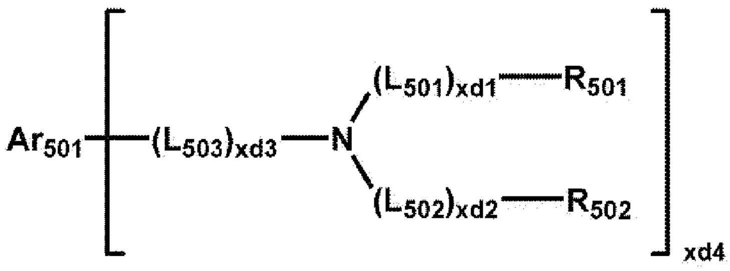

In Formula 501,

$Ar_{501}$, $L_{501}$ to $L_{503}$, $R_{501}$, and $R_{502}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
xd1 to xd3 may each independently be 0, 1, 2, or 3, and
xd4 may be 1, 2, 3, 4, 5, or 6.

In an embodiment, in Formula 501, $Ar_{501}$ may be a condensed cyclic group (for example, an anthracene group, a chrysene group, a pyrene group, etc.) in which three or more monocyclic groups are condensed together.

In an embodiment, in Formula 501, xd4 may be 2.

In an embodiment, the fluorescent dopant may include one of Compounds FD1 to FD36, DPVBi, DPAVBi, or any combination thereof:

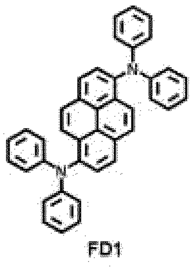
FD1

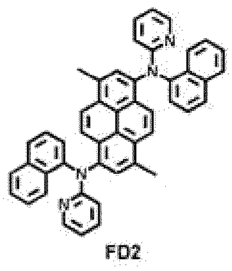
FD2

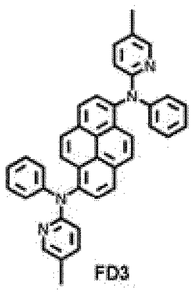
FD3

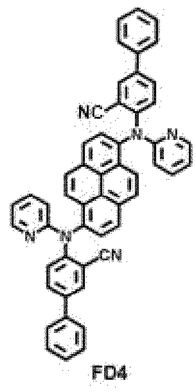
FD4

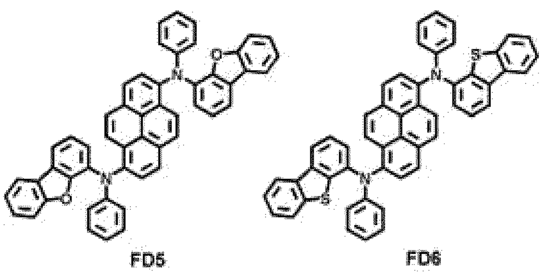
FD5

FD6

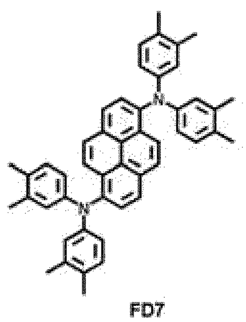
FD7

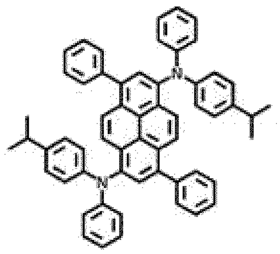
FD8

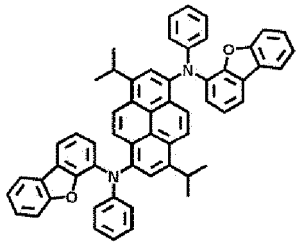

FD9

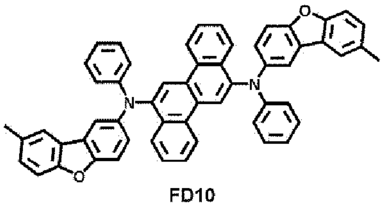

FD10

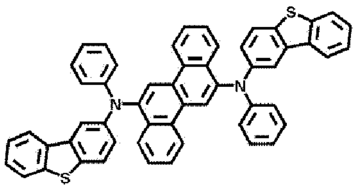

FD11

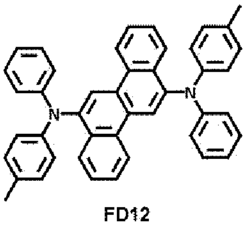

FD12

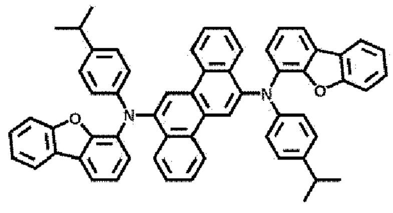

FD13

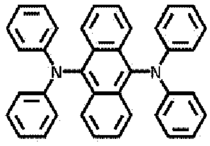

FD14

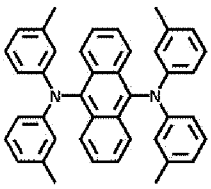

FD15

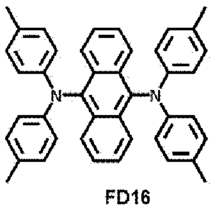

FD16

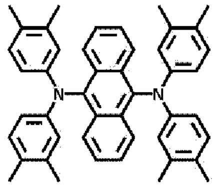

FD17

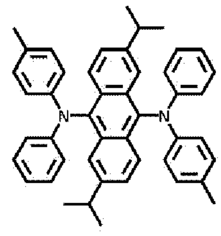

FD18

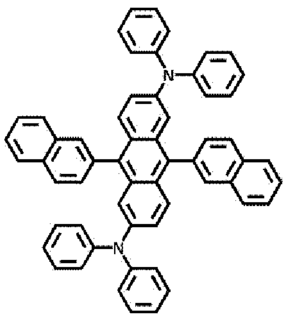

FD19

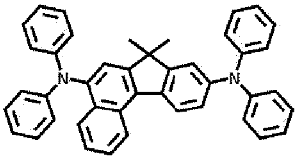

FD20

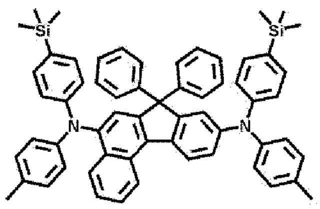

FD21

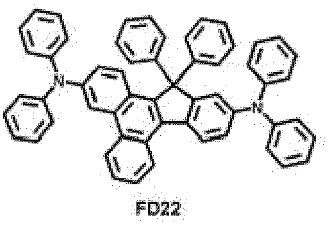

FD22

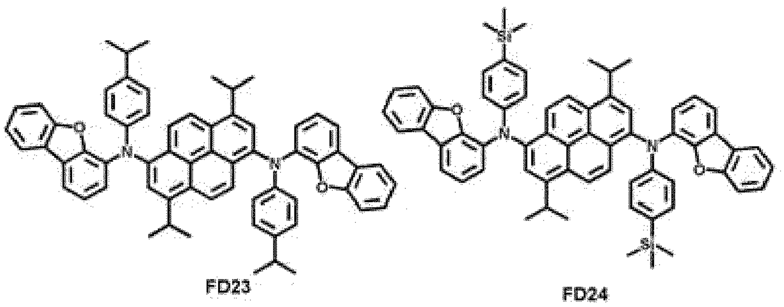

FD23

FD24

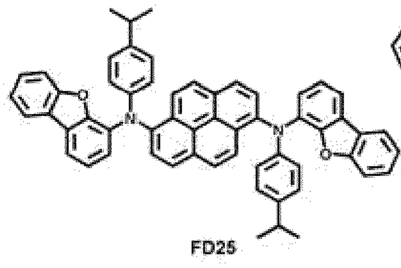
FD25

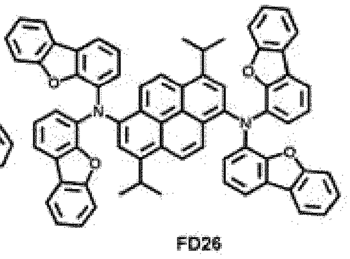
FD26

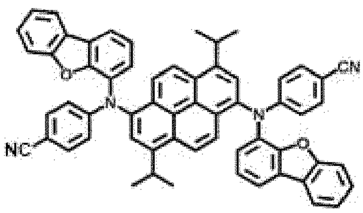
FD27

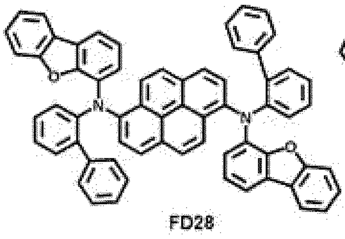
FD28

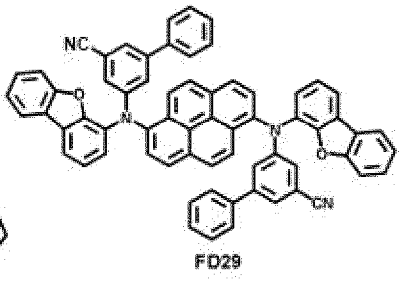
FD29

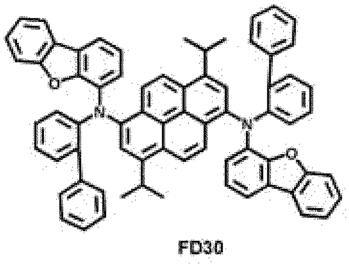
FD30

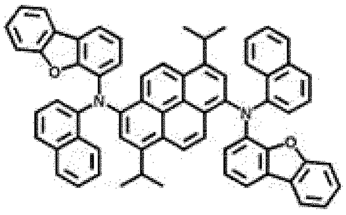
FD31

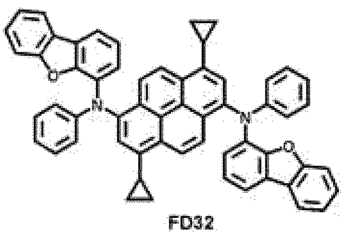
FD32

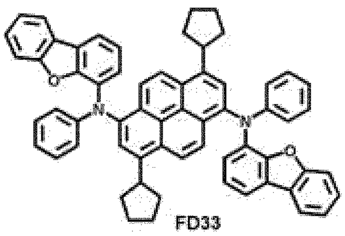
FD33

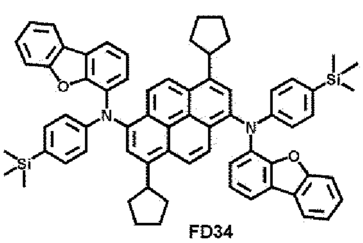
FD34

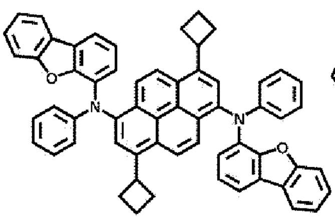
FD35

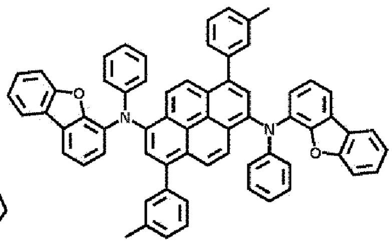
FD36

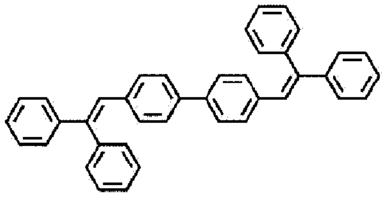
DPVBi

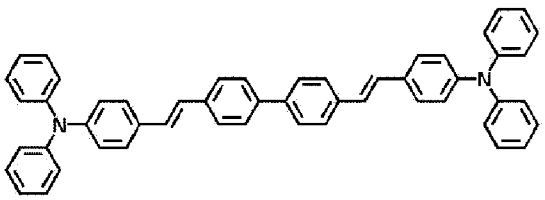
DPAVBi

[Delayed fluorescence material]

The emission layer may include a delayed fluorescence material.

In the specification, the delayed fluorescence material may be selected from compounds capable of emitting delayed fluorescence, based on a delayed fluorescence emission mechanism.

The delayed fluorescence material included in the emission layer may act as a host or as a dopant, depending on the type of other materials included in the emission layer.

According to an embodiment, a difference between a triplet energy level (eV) of the delayed fluorescence material and a singlet energy level (eV) of the delayed fluorescence material may be in a range of about 0 eV to about 0.5

eV. In case that the difference between the triplet energy level (eV) of the delayed fluorescence material and the singlet energy level (eV) of the delayed fluorescence material satisfies the above-described range, up-conversion from a triplet state to a singlet state of the delayed fluorescence materials may effectively occur, and thus, the luminescence efficiency of the light-emitting device 10 may be improved.

In an embodiment, the delayed fluorescence material may include: a material including at least one electron donor (for example, a n electron-rich $C_3$-$C_{60}$ cyclic group, such as a carbazole group) and at least one electron acceptor (for example, a sulfoxide group, a cyano group, or a n electron-deficient nitrogen-containing $C_1$-$C_{60}$ cyclic group); or may include a material including a $C_8$-$C_{60}$ polycyclic group in which two or more cyclic groups are condensed while sharing boron (B).

In an embodiment, the delayed fluorescence material may include at least one of Compounds DF1 to DF9:

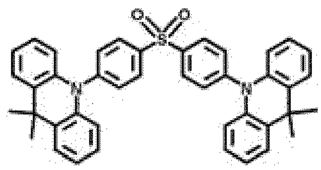
DF1(DMAC-DPS)

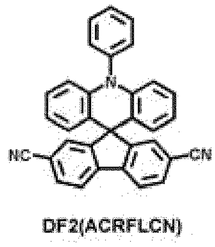
DF2(ACRFLCN)

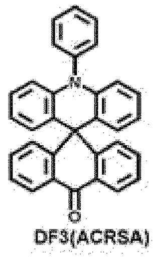
DF3(ACRSA)

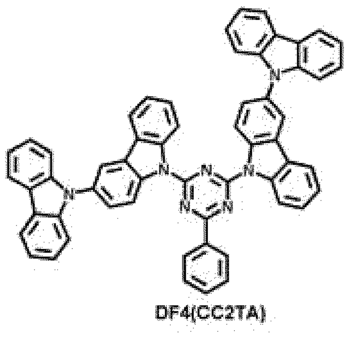
DF4(CC2TA)

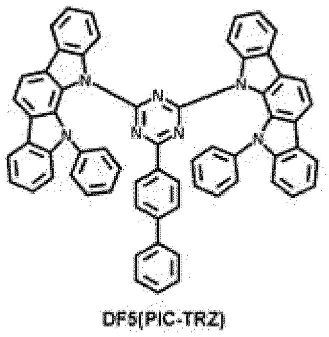
DF5(PIC-TRZ)

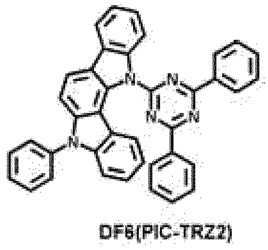
DF6(PIC-TRZ2)

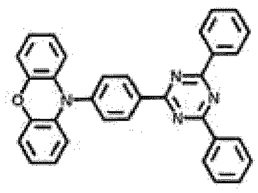
DF7(PXZ-TRZ)

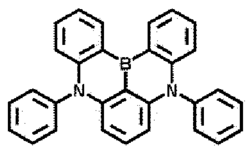
DF8(DABNA-1)

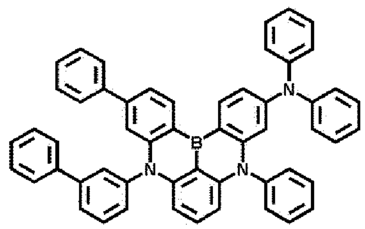
DF9(DABNA-2)

.

[Quantum dot]

The emission layer may include a quantum dot.

In the specification, a quantum dot may be a crystal of a semiconductor compound, and may include any material capable of emitting light of various emission wavelengths according to a size of the crystal.

A diameter of the quantum dot may be, for example, in a range of about 1 nm to about 10 nm.

The quantum dot may be synthesized by a wet chemical process, a metal organic chemical vapor deposition process, a molecular beam epitaxy process, or any process similar thereto.

The wet chemical process may be a method that includes mixing a precursor material with an organic solvent and growing a quantum dot particle crystal. In case that the crystal grows, the organic solvent naturally acts as a dispersant coordinated on the surface of the quantum dot crystal and controls the growth of the crystal so that the growth of quantum dot particles can be controlled through a process which costs less, and may be more readily performed than vapor

deposition methods, such as metal organic chemical vapor deposition (MOCVD) or molecular beam epitaxy (MBE),

The quantum dot may include: a Group II-VI semiconductor compound, a Group III-V semiconductor compound, a Group III-VI semiconductor compound, a Group I-III-VI semiconductor compound, a Group IV-VI semiconductor compound, a Group IV element or compound, or any combination thereof.

Examples of a Group II-VI semiconductor compound may include: a binary compound, such as CdS, CdSe, CdTe, ZnS, ZnSe, ZnTe, ZnO, HgS, HgSe, HgTe, MgSe, MgS, etc.; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, etc.; a quaternary compound, such as CdZnSeS, CdZnSeTe, CdZnSTe, CdHgSeS, CdHgSeTe, CdHgSTe, HgZnSeS, HgZnSeTe, HgZnSTe, etc.; or any combination thereof.

Examples of a Group III-V semiconductor compound may include: a binary compound, such as GaN, GaP, GaAs, GaSb, AlN, AlP, AlAs, AlSb, InN, InP, InAs, InSb, etc.; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, etc.; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, etc.; or any combination thereof. In an embodiment, a Group III-V semiconductor compound may further include a Group II element. Examples of a Group III-V semiconductor compound further including a Group II element may include InZnP, InGaZnP, InAlZnP, etc.

Examples of a Group III-VI semiconductor compound may include: a binary compound, such as GaS, GaSe, $Ga_2Se_3$, GaTe, InS, InSe, $In_2S_3$, $In_2Se_3$, InTe, etc.; a ternary compound, such as $InGaS_3$, $InGaSe_3$, etc.; or any combination thereof.

Examples of a Group I-III-VI semiconductor compound may include: a ternary compound, such as AgInS, $AgInS_2$, CuInS, $CuInS_2$, $CuGaO_2$, $AgGaO_2$, $AgAlO_2$, etc.; or any combination thereof.

Examples of a Group IV-VI semiconductor compound may include: a binary compound, such as SnS, SnSe, SnTe, PbS, PbSe, PbTe, etc.; a ternary compound, such as SnSeS, SnSeTe, SnSTe, PbSeS, PbSeTe, PbSTe, SnPbS, SnPbSe, SnPbTe, etc.; a quaternary compound, such as SnPbSSe, SnPbSeTe, SnPbSTe, etc.; or any combination thereof.

Examples of a Group IV element or compound may include: a single element material, such as Si, Ge, etc.; a binary compound, such as SiC, SiGe, etc.; or any combination thereof.

Each element included in a compound such as a binary compound, a ternary compound, or a quaternary compound may be present at a uniform concentration or at a non-uniform concentration in a particle.

In an embodiment, the quantum dot may have a single structure in which the concentration of each element in the quantum dot may be uniform, or the quantum dot may have a core-shell structure. In case that the quantum dot has a core-shell structure, a material included in the core and the material included in the shell may be different from each other.

The shell of a quantum dot may serve as a protective layer that prevents chemical degeneration of the core to maintain semiconductor characteristics, and/or may serve as a charging layer that imparts electrophoretic characteristics to the quantum dot. The shell may be a monolayer or a multilayer. An interface between the core and the shell may have a concentration gradient in which the concentration of an element that is present in the shell decreases toward the core.

Examples of a shell of a quantum dot may include a metal oxide, a metalloid oxide, a non-metal oxide, a semiconductor compound, and any combination thereof. Examples of a metal oxide, a metalloid oxide, or a non-metal oxide may include: a binary compound, such as SiOz, $Al_2O_3$, TiOz, ZnO, MnO, $Mn_2O_3$, $Mn_3O_4$, CuO, FeO, $Fe_2O_3$, $Fe_3O_4$, CoO, $Co_3O_4$, NiO, etc.; a ternary compound, such as $MgAl_2O_4$, $CoFe_2O_4$, $NiFe_2O_4$, $CoMn_2O_4$, etc.; or any combination thereof. Examples of a semiconductor compound may include, as described herein: a Group II-VI semiconductor compound; a Group III-V semiconductor compound; a Group III-VI semiconductor compound; a Group I-III-VI semiconductor compound; a Group IV-VI semiconductor compound; or any combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

A full width at half maximum (FWHM) of an emission spectrum of a quantum dot may be about 45 nm or less. For example, a FWHM of an emission spectrum of a quantum dot may be about 40 nm or less. For example, a FWHM of an emission spectrum of a quantum dot may be about 30 nm or less. In any of these ranges, color purity or color reproducibility may be improved. Light emitted through a quantum dot may be emitted in all directions, so that a wide viewing angle may be improved.

In embodiments, a quantum dot may be in the form of a spherical particle, a pyramidal particle, a multi-arm particle, a cubic nanoparticle, a nanotube particle, a nanowire particle, a nanofiber particle, or a nanoplate particle.

Since the energy band gap may be adjusted by controlling the size of the quantum dot, light having various wavelength bands may be obtained from the quantum dot emission layer. Accordingly, by using quantum dots of different sizes, a light-emitting device that emits light of various wavelengths may be implemented. Specifically, the size of the quantum dot may be selected to emit red, green and/or blue light. The size of the quantum dot may be configured to emit white light by combination of light of various colors.

[Electron transport region in interlayer 150]

The electron transport region may have i) a monolayer structure consisting of a single layer consisting of a single material, ii) a monolayer structure consisting of a single layer consisting of multiple different materials, or iii) a multilayer structure including multiple layers including different materials.

The electron transport region may include a buffer layer, a hole blocking layer, an electron control layer, an electron transport layer, an electron injection layer, or any combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, the constituting layers of each structure being sequentially stacked on each other from an emission layer.

The electron transport region (for example, the buffer layer, the hole blocking layer, the electron control layer, or the electron transport layer in the electron transport region) may include a metal-free compound including at least one n electron-deficient nitrogen-containing $C_1$-$C_{60}$ cyclic group.

In an embodiment, the electron transport region may include a compound represented by Formula 601:

[Formula 601] $[Ar_{601}]_{xe11}$-$[(L_{601})_{xe1}$-$R_{601}]_{xe21}$

In Formula 601,

$Ar_{601}$ and $L_{601}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xe11 may be 1, 2, or 3,
xe1 may be 0, 1, 2, 3, 4, or 5,
$R_{601}$ may be a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, - $Si(Q_{601})(Q_{602})(Q_{603})$, $-C(=O)(Q_{601})$, $-S(=O)_2(Q_{601})$, or $-P(=O)(Q_{601})(Q_{602})$,
$Q_{601}$ to $Q_{603}$ may each independently be the same as described herein with respect to $Q_1$,
xe21 may be 1, 2, 3, 4, or 5, and
at least one of $Ar_{601}$, $L_{601}$, and $R_{601}$ may each independently be a n electron-deficient nitrogen-containing $C_1$-$C_{60}$ cyclic group unsubstituted or substituted with at least one $R_{10a}$.

In an embodiment, in Formula 601, in case that xe11 is 2 or more, two or more of $Ar_{601}$(s) may be linked to each other via a single bond.

In an embodiment, in Formula 601, $Ar_{601}$ may be an unsubstituted or substituted with at least one $R_{10a}$. $R_{10a}$ may be the same as described herein.

In an embodiment, the electron transport region may include a compound represented by Formula 601-1:

[Formula 601-1]

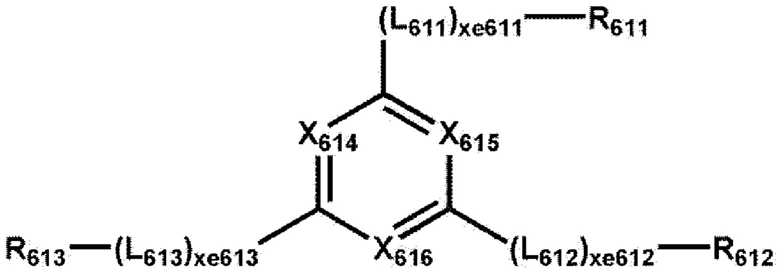

In Formula 601-1,

$X_{614}$ may be N or $C(R_{614})$, $X_{615}$ may be N or $C(R_{615})$, $X_{616}$ may be N or $C(R_{616})$, and at least one of $X_{614}$ to $X_{616}$ may be N,
$L_{611}$ to $L_{613}$ may each independently be the same as described herein with respect to $L_{601}$,
xe611 to xe613 may each independently be the same as described herein with respect to xe1,
$R_{611}$ to $R_{613}$ may each independently be the same as described herein with respect to $R_{601}$, and
$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group unsubstituted or substituted with at

least one $R_{10a}$, or a $C_1$-$C_{60}$ heterocyclic group unsubstituted or substituted with at least one $R_{10a}$. $R_{10a}$ may be the same as described herein.

In an embodiment, in Formulae 601 and 601-1, xe1 and xe611 to xe613 may each independently be 0, 1, or 2.

The electron transport region may include one of Compounds ET1 to ET45, 2,9-dimethyl-4,7-diphenyl-1,10-phenanthroline (BCP), 4,7-diphenyl-1,10-phenanthroline (Bphen), $Alq_3$, BAlq, TAZ, NTAZ, or any combination thereof:

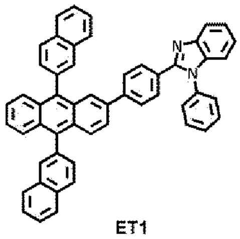
ET1

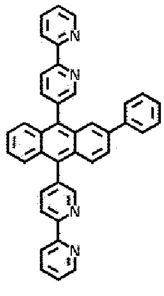
ET2

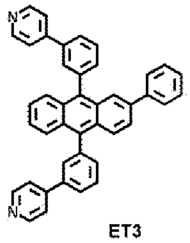
ET3

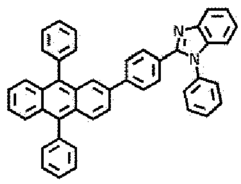
ET4

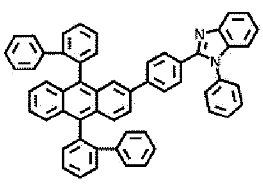
ET5

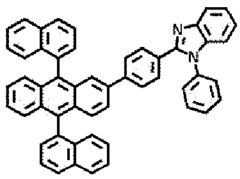
ET6

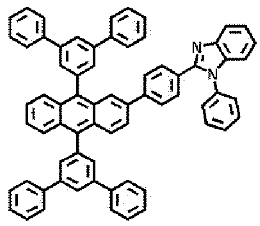
ET7

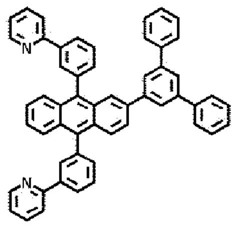
ET8

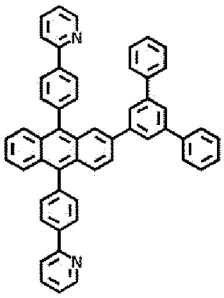
ET9

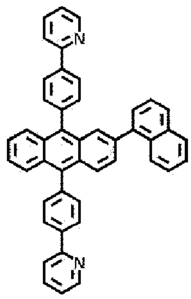
ET10

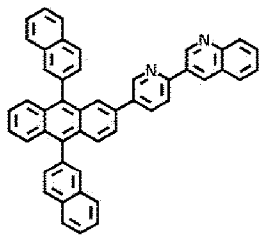
ET11

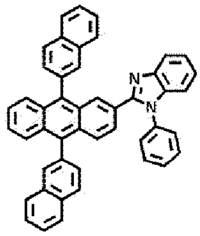
ET12

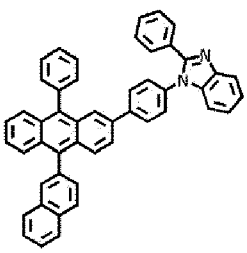
ET13

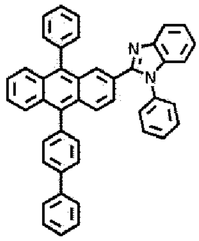
ET14

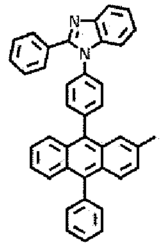
ET15

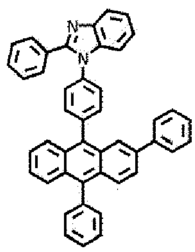
ET16

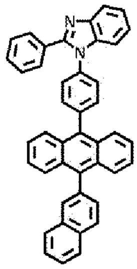
ET17

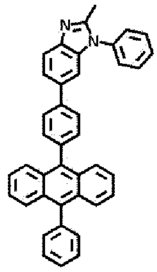
ET18

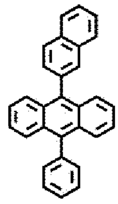
ET19

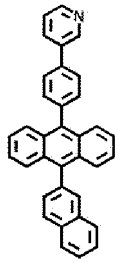
ET20

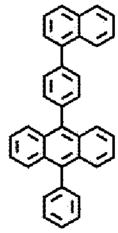
ET21

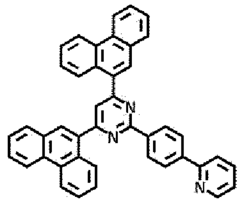
ET22

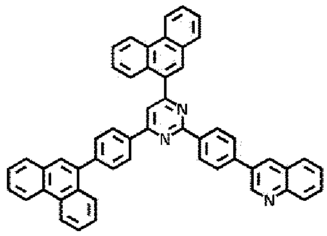
ET23

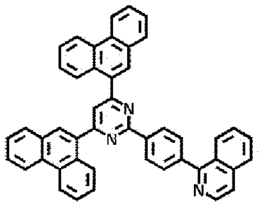
ET24

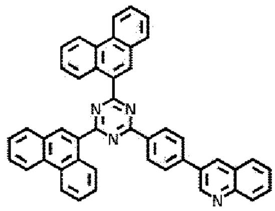
ET25

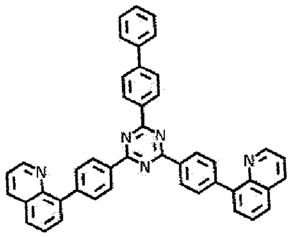
ET26

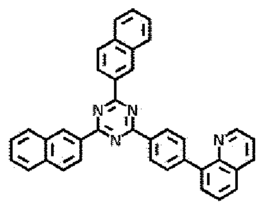
ET27

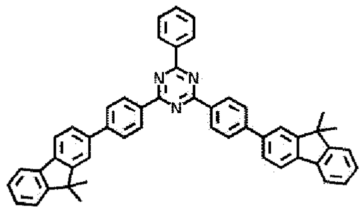
ET28

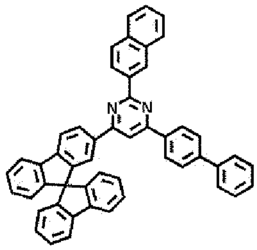
ET29

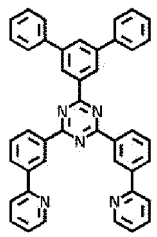
ET30

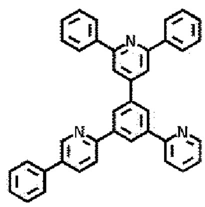
ET31

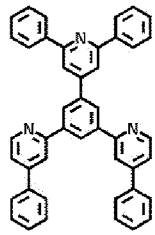
ET32

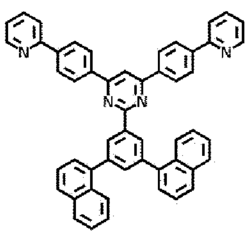
ET33

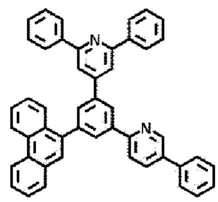
ET34

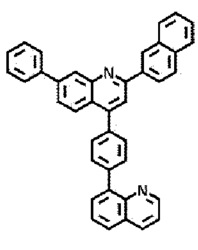
ET35

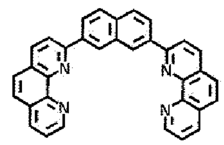
ET36

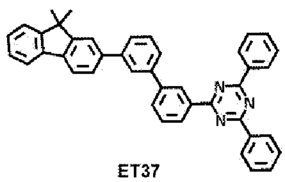

ET37

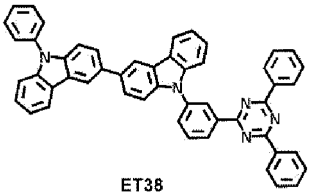

ET38

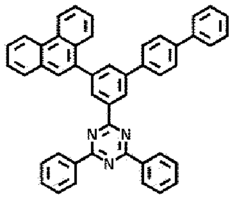

ET39

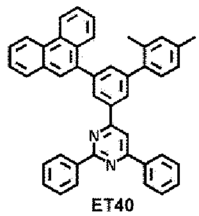

ET40

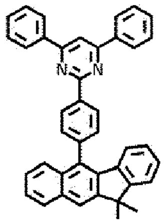

ET41

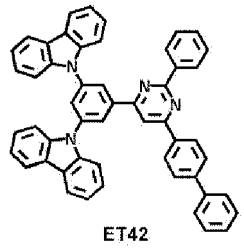

ET42

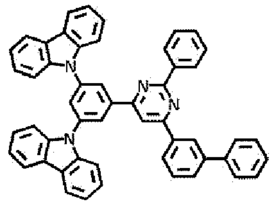

ET43

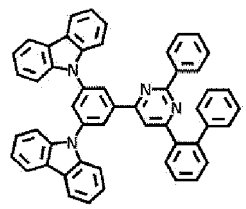

ET44

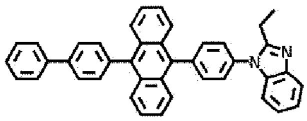

ET45

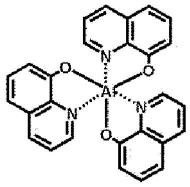

Alq3

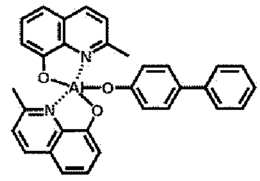

BAlq

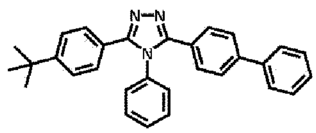

TAZ

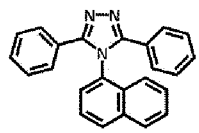

NTAZ .

A thickness of the electron transport region may be in a range of about 100 Å to about 5,000 Å, for example, in a range of about 160 Å to about 4,000 Å. In case that the electron transport region includes a buffer layer, a hole blocking layer, an electron control layer, an electron transport layer, or any combination thereof, a thickness of the buffer layer, the hole blocking layer, or the electron control layer may be in a range of about 20 Å to about 1,000 Å, for example, in a range of about 30 Å to about 300 Å, and a thickness of the electron transport layer may be in a range of about 100 Å to about 1,000 Å, for example, in a range of about 150 Å to about 500 Å. In case that the thickness of the buffer layer, the hole blocking layer, the electron control layer, the electron transport layer, and/or the electron transport region are in these ranges, satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. A metal ion of an alkali metal complex may be a Li ion, a Na ion, a K ion, a Rb ion, or a Cs ion. A metal ion of an alkaline earth metal complex may be a Be ion, a Mg ion, a Ca ion, a Sr ion, or a Ba ion.

A ligand coordinated with a metal ion of an alkali metal complex or an alkaline earth-metal complex may each independently include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may include a Li complex. The Li complex may include, for example, Compound ET-D1 (LiQ) or Compound ET-D2:

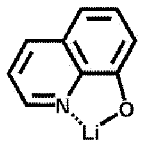

ET-D1

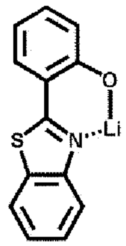

ET-D2 .

The electron transport region may include an electron injection layer that facilitates the injection of electrons from the second electrode 190. The electron injection layer may directly contact the second electrode 190.

The electron injection layer may have i) a monolayer structure consisting of a single layer consisting of a single material, ii) a monolayer structure consisting of a single layer consisting of multiple different materials, or iii) a multilayer structure including multiple layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (for example, fluorides, chlorides, bromides, iodides, etc.), or tellurides of the alkali metal, the alkaline earth metal, and the rare earth metal, or any combination thereof.

The alkali metal-containing compound may include: an alkali metal oxide, such as $Li_2O$, CszO, $K_2O$, etc.; an alkali metal halide, such as LiF, NaF, CsF, KF, LiI, NaI, CsI, KI, etc.; or any combination thereof. The alkaline earth metal-containing compound may include an alkaline earth metal oxide, such as BaO, SrO, CaO, $Ba_xSr_{1-x}O$ (wherein x may be a real number satisfying the condition of $0<x<1$), $Ba_xCa_{1-x}O$ (wherein x may be a real number satisfying the condition of $0<x<1$), etc. The rare earth metal-containing compound may include $YbF_3$, $ScF_3$, $Sc_2O_3$, $Y_2O_3$, $Ce_2O_3$, $GdF_3$, $TbF_3$, $YbI_3$, $ScI_3$, $TbI_3$, or any combination thereof. In an embodiment, the rare earth metal-containing compound may include a lanthanide metal telluride. Examples of a lanthanide metal telluride may include LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, $Lu_2Te_3$, etc.

The alkali metal complex, the alkaline earth-metal complex, and the rare earth metal complex may include: an alkali metal ion, an alkaline earth metal ion, or a rare earth metal ion; and a ligand bonded to the metal ion (for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof).

In embodiments, the electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In an embodiment, the electron injection layer may further include an organic material (for example, a compound represented by Formula 601).

According to an embodiment, the electron injection layer may consist of an alkali metal-containing compound (for example, an alkali metal halide); or the electron injection layer may consist of an alkali metal-containing compound (for example, an alkali metal halide), and an alkali metal, an alkaline earth metal, a rare earth metal, or any combination thereof. For example, the electron injection layer may be a KI:Yb co-deposited layer, an RbI:Yb co-deposited layer, a LiF:Yb co-deposited layer, etc.

In case that the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be uniformly or non-uniformly dispersed in a matrix including the organic material.

A thickness of the electron injection layer may be in a range of about 1 Å to about 100 Å, for example, in a range of about 3 Å to about 90 Å. In case that the thickness of the electron injection layer is in the ranges described above, satisfactory electron injection characteristics may be obtained without a substantial increase in driving voltage.

[Second electrode 190]

The second electrode 190 may be located on the interlayer 150 having such a structure. The second electrode 190 may be a cathode, which may be an electron injection electrode, and as the material for the second electrode 190, a metal, an alloy, an electrically conductive compound, or any combination thereof, each having a low work function, may be used.

The second electrode 190 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 190 may be a transmissive electrode, a semi-transmissive electrode, or a reflective electrode.

The second electrode 190 may have a monolayer structure having a single layer or a multilayer structure having multiple layers.

[Capping layer]

A first capping layer may be arranged outside the first electrode 110, and/or a second capping layer may be arranged outside the second electrode 190. In detail, the light-emitting device 10 may have a structure in which the first capping layer, the first electrode 110, the interlayer 150, and the second electrode 190 are sequentially stacked on each other in this stated order, a structure in which the first electrode 110, the interlayer 150, the second electrode 190, and the second capping layer are sequentially stacked on each other in this stated order, or a structure in which the first capping layer, the first electrode 110, the interlayer 150 , the second electrode 190, and the second capping layer are sequentially stacked on each other in this stated order.

Light generated in an emission layer of the interlayer 150 of the light-emitting device 10 may be extracted toward the outside through the first electrode 110 which may be a transflective electrode or a transmissive electrode, and the first capping layer, and light generated in an emission layer of the interlayer 150 of the light-emitting device 10 may be extracted toward the outside through the second electrode 190 which may be a transflective electrode or a transmissive electrode, and the second capping layer.

The first capping layer and the second capping layer may increase external luminescence efficiency according to the principle of constructive interference. Accordingly, the light extraction efficiency of the light-emitting device 10 may be increased, so that the luminescence efficiency of the light-emitting device 10 may be improved.

Each of the first capping layer and the second capping layer may include a material having a refractive index of about 1.6 or more (at about 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may be optionally substituted with a substituent including O, N, S, Se, Si, F, Cl, Br, I, or any combination thereof.

An according to an embodiment, at least one of the first capping layer and the second capping layer may each independently include an amine group-containing compound.

For example, at least one of the first capping layer and the second capping layer may each independently include a compound represented by Formula 201, a compound represented by Formula 202, or any combination thereof.

According to embodiments, at least one of the first capping layer and the second capping layer may each independently include one of Compounds HT28 to HT33, one of Compounds CP1 to CP6, β-NPB, or any combination thereof:

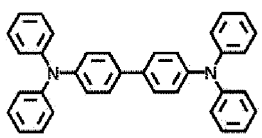
CP1

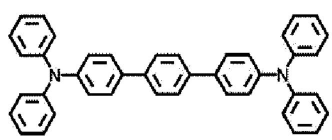
CP2

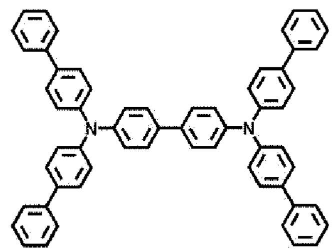
CP3

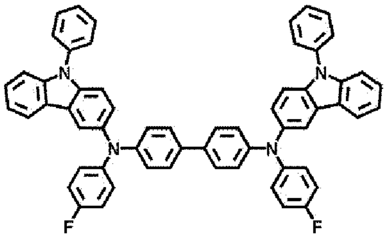

CP4

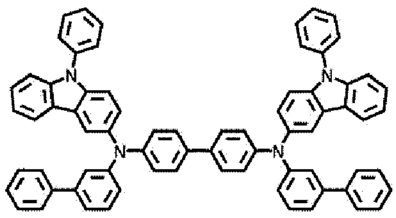

CP5

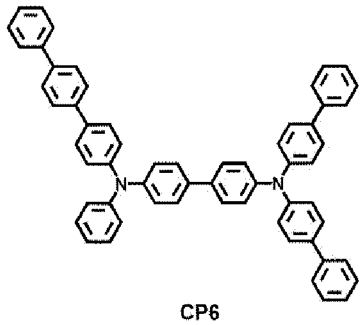

CP6

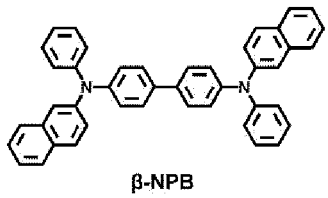

β-NPB

.

[Film]

The compound represented by Formula 1 and/or the compound represented by Formula 2 may be included in various films. Thus, another aspect of the disclosure provides a film including the compound represented by Formula 1 and/or a compound represented by Formula 2. The film may be, for example, an optical member (or a light control means) (for example, a color filter, a color conversion member, a capping layer, a light extraction efficiency enhancement layer, a selective light absorbing layer, a polarizing layer, a quantum dot-containing layer, etc.), a light-blocking member (for example, a light reflective layer, a light absorbing layer, etc.), a protective member (for example, an insulating layer, a dielectric layer, etc.).

[Electronic apparatus]

The light-emitting device may be included in various electronic apparatuses. For example, the electronic apparatus including the light-emitting device may be a light-emitting apparatus, an authentication apparatus, etc.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be located in at least one direction in which light emitted from the light-emitting device travels. For example, the light emitted from the light-emitting device may be blue light or white light. Details on the light-emitting device may be the same as described above. According to an embodiment, the color conversion layer may include a quantum dot. The quantum dot may be, for example, a quantum dot as described herein.

The electronic apparatus may include a first substrate. The first substrate may include multiple subpixel areas, the color filter may include multiple color filter areas respectively corresponding to the subpixel areas, and the color conversion layer may include multiple color conversion areas respectively corresponding to the subpixel areas.

A pixel defining layer may be located between the plurality of subpixel areas to define each of the subpixel areas.

The color filter may further include multiple color filter areas and light blocking patterns located between the color filter areas, and the color conversion layer may further include multiple color conversion areas and light blocking patterns located between the color conversion areas.

The plurality of color filter areas (or the plurality of color conversion areas) may include: a first area emitting first color light; a second area emitting second color light; and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. Specifically, the first area may include a red quantum dot, the second area may include a green quantum dot, and the third area may not include a quantum dot. Details on the quantum dot may be the same as described herein. The first area, the second area, and/or the third area may each further include a scatter.

For example, the light-emitting device may emit first light, the first area may absorb the first light to emit first-first

color light, the second area may absorb the first light to emit second-first color light, and the third area may absorb the first light to emit third-first color light. In this regard, the first-first color light, the second-first color light, and the third-first color light may have different maximum emission wavelengths from one another. Specifically, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, etc.

The activation layer may include crystalline silicon, amorphous silicon, an organic semiconductor, an oxide semiconductor, etc.

The electronic apparatus may further include a sealing portion for sealing the light-emitting device. The sealing portion may be located between the color filter and/or the color conversion layer and the light-emitting device. The sealing portion allows light from the light-emitting device to be extracted to the outside, and simultaneously prevents ambient air and moisture from penetrating into the light-emitting device. The sealing portion may be a sealing substrate including a transparent glass substrate or a plastic substrate. The sealing portion may be a thin-film encapsulation layer including one or more layers of an organic layer and/or an inorganic layer. In case that the sealing portion is a thin-film encapsulation layer, the electronic apparatus may be flexible.

Various functional layers may be additionally located on the sealing portion, in addition to the color filter and/or the color conversion layer, according to the use of the electronic apparatus. The functional layers may include a touch screen layer, a polarizing layer, etc. The touch screen layer may be a pressure-sensitive touch screen layer, a capacitive touch screen layer, or an infrared touch screen layer.

The authentication apparatus may further include, in addition to the light-emitting device as described above, a biometric information collector. The authentication apparatus may be, for example, a biometric authentication apparatus that authenticates an individual by using biometric information of a living body (for example, fingertips, pupils, etc.).

The electronic apparatus may be applied to various displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, etc.

[Description of FIGS. 4 and 5]

FIG. 4 is a schematic cross-sectional view of a light-emitting apparatus according to an embodiment.

A light-emitting apparatus of FIG. 4 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be located on the substrate 100. The buffer layer 210 may prevent penetration of impurities through the substrate 100 and may provide an approximately flat surface on the substrate 100.

A TFT may be located on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be located on the gate electrode 240. The interlayer insulating film 250 may be located between the gate electrode 240 and the source electrode 260 and between the gate electrode 240 and the drain electrode 270, to insulate from one another.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be in contact with the exposed portions of the source region and the drain region of the activation layer 220.

The TFT may be electrically connected to a light-emitting device to drive the light-emitting device, and be covered and protected by a passivation layer 280. The passivation layer 280 may include an inorganic insulating film, an organic insulating film, or any combination thereof. A light-emitting device may be provided on the passivation layer 280. The light-emitting device may include the first electrode 110, the interlayer 150, and the second electrode 190.

The first electrode 110 may be located on the passivation layer 280. The passivation layer 280 may be located to expose a certain region of the drain electrode 270, not fully covering the drain electrode 270, and the first electrode 110 may be located to be electrically connected to the exposed region of the drain electrode 270.

A pixel defining layer 290 including an insulating material may be located on the first electrode 110. The pixel defining layer 290 may expose a certain region of the first electrode 110, and an interlayer 150 may be formed in the exposed region of the first electrode 110. The pixel defining layer 290 may be a polyimide or polyacrylic organic film. Although not shown in FIG. 4, at least some layers of the interlayer 150 may extend beyond the upper portion of the pixel defining layer 290 and may thus be located in the form of a common layer.

A second electrode 190 may be located on the interlayer 150, and a capping layer 170 may be additionally formed on the second electrode 190. The capping layer 170 may be formed to cover the second electrode 190.

The encapsulation portion 300 may be located on the capping layer 170. The encapsulation portion 300 may be located on a light-emitting device to protect the light-emitting device from moisture or oxygen. The encapsulation portion 300 may include: an inorganic film including silicon nitride ($SiN_x$), silicon oxide ($SiO_x$), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic-based resin (for example, polymethyl methacrylate, polyacrylic acid, etc.), an epoxy-based resin (for example, aliphatic glycidyl ether (AGE), etc.), or any combination thereof; or any combination of the inorganic films and the organic films.

FIG. 5 is a schematic cross-sectional view of a light-emitting apparatus according to other embodiments.

The light-emitting device of FIG. 5 may be the same light-emitting device as the light-emitting device of FIG. 4, except that a first subpixel P1 and a second subpixel P2 may be arranged in the interlayer, and a light blocking pattern 500 and a functional area 400 may be additionally located on the upper portion of the encapsulation portion 300. The functional area 400 may be i) a color filter area, ii) a color conversion area, or iii) a combination of the color filter area and the color conversion area. According to an embodiment, the light-emitting device included in the electronic apparatus (e.g. light-emitting apparatus) of FIG. 5 may be a tandem light-emitting device.

[Description of FIG. 6]

FIG. 6 is a perspective view schematically showing electronic equipment 1 including a light-emitting device according to an embodiment. The electronic equipment 1 may be an apparatus that displays a moving image or still image, and may be a portable electronic equipment, such as a mobile phone, a smart phone, a tablet personal computer (PC), a mobile communication terminal, an electronic notebook, an electronic book, a portable multimedia player (PMP), a navigation, or a ultra mobile PC (UMPC) as well as various products, such as a television, a laptop, a monitor, an advertisement board, an Internet of things (IOT) or the like, or a part thereof. The electronic equipment 1 may be a wearable device, such as a smart watch, a watch phone, a glasses-type display, or a head mounted display (HMD), or a part of the wearable device. However, embodiments are not limited thereto. For example, the electron equipment 1 may be a dashboard of a vehicle, and a center fascia of a vehicle, or a center information display arranged on a dashboard of a vehicle, a room mirror display replacing a side mirror of a vehicle, an entertainment display for the rear seat of a vehicle or a display arranged on the back of the front seat, or a head up display (HUD) installed in the front of a vehicle or projected on a front window glass, a computer-generated hologram augmented-reality head up display (CGH AR HUD). FIG. 6 illustrates a case in which the electronic equipment 1 may be a smart phone for convenience of explanation.

The electronic equipment 1 may include a display area DA and a non-display area NDA outside the display area DA. A display device may implement an image through an array of multiple pixels that may be two-dimensionally arranged in the display area DA.

The non-display area NDA may be an area that does not display an image, and may entirely surround the display area DA. On the non-display area NDA, a driver for providing electrical signals or power to display devices arranged on the display area DA may be arranged. On the non-display area NDA, a pad, which may be an area to which an electronic element or a printing circuit board may be electrically connected, may be arranged.

In the electronic equipment 1, a length in the x-axis direction and a length in the y-axis direction may be different from each other. In an embodiment, as shown in FIG. 6, the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

[Descriptions of FIGS. 7 and 8A to 8C]

FIG. 7 is a schematic view of the exterior of a vehicle 1000 as an electronic equipment including a light-emitting device according to an embodiment. FIGS. 8A to 8C are each a schematic view of the interior of the vehicle 1000 according to various embodiments.

Referring to FIGS. 7, 8A, 8B, and 8C, the vehicle 1000 may refer to various apparatuses for moving a subject to be transported, such as a human, an object, an animal, or the like, from a departure point to a destination point. The vehicle 1000 may include a vehicle traveling on a road or track, a vessel moving over a sea or river, an airplane flying in the sky using the action of air, etc.

The vehicle 1000 may travel on a road or a track. The vehicle 1000 may move in a certain direction according to the rotation of at least one wheel. For example, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses desirable for driving may be installed as other parts except for the body. The exterior of the vehicle body may include a front panel, a bonnet, a roof panel, a rear panel, a trunk, and a pillar provided at a boundary between doors. The chassis of the vehicle 1000 may include a power generating device, a power transmitting device, a driving device, a steering device, a braking device, a suspension device, a transmission device, a fuel device, front and rear wheels, left and right wheels, etc.

The vehicle 1000 may include a side window glass 1100, a front window glass 1200, a side mirror 1300, a cluster 1400, a center fascia 1500, a passenger seat dashboard 1600, and a display device 2.

The side window glass 1100 and the front window glass 1200 may be partitioned by a pillar arranged between the side window glass 1100 and the front window glass 1200.

The side window glass 1100 may be installed on the side of the vehicle 1000. In an embodiment, the side window glass 1100 may be installed on a door of the vehicle 1000. Multiple side window glasses 1100 may be provided and may face each other. In an embodiment, the side window glass 1100 may include a first side window glass 1110 and a second side window glass 1120. In an embodiment, the first side window glass 1110 may be arranged adjacent to the cluster 1400. The second side window glass 1120 may be arranged adjacent to the passenger seat dashboard 1600.

In an embodiment, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, an imaginary straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the vehicle body. In an embodiment, multiple side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may include a tachometer, a speedometer, a coolant thermometer, a fuel gauge turn indicator, a high beam indicator, a warning lamp, a seat belt warning lamp, an odometer, a tachograph, an automatic shift selector indicator lamp, a door open warning lamp, an engine oil warning lamp, and/or a low fuel warning light.

The center fascia 1500 may include a control panel on which multiple buttons for adjusting an audio device, an air conditioning device, and a heater of a seat may be arranged. The center fascia 1500 may be arranged on one side of the cluster 1400.

A passenger seat dashboard 1600 may be spaced apart from the cluster 1400 with the center fascia 1500 arranged therebetween. In an embodiment, the cluster 1400 may be arranged to correspond to a driver seat (not shown), and the passenger seat dashboard 1600 may be arranged to correspond to a passenger seat (not shown). In an embodiment, the cluster 1400 may be adjacent to the first side window glass 1110, and the passenger seat dashboard 1600 may be adjacent to the second side window glass 1120.

In an embodiment, the display device 2 may include a display panel 3, and the display panel 3 may display an image. The display device 2 may be arranged inside the vehicle 1000. In an embodiment, the display device 2 may be arranged between the side window glasses 1100 facing each other. The display device 2 may be arranged on at least one of the cluster 1400, the center fascia 1500, and the passenger seat dashboard 1600.

The display device 2 may include an organic light-emitting display device, an inorganic electroluminescent (EL) display device, a quantum dot display device, etc. Hereinafter, as the display device 2 according to an embodiment, an organic light-emitting display device including the light-emitting device according to the disclosure will be described as an example, but various types of display devices as described above may be used in embodiments.

Referring to FIG. 8A, the display device 2 may be arranged on the center fascia 1500. In an embodiment, the display device 2 may display navigation information. In an embodiment, the display device 2 may display audio, video, or information regarding vehicle settings.

Referring to FIG. 8B, the display device 2 may be arranged on a cluster 1400. In case that the display device 2

may be arranged on the cluster 1400, the cluster 1400 may display driving information and the like through the display device 2. That is, the cluster 1400 may be implemented digitally. The digital cluster 1400 may display vehicle information and driving information as images. For example, a needle and a gauge of a tachometer and various warning light icons may be displayed by a digital signal.

Referring to FIG. 8C, the display device 2 may be arranged on the passenger seat dashboard 1600. The display device 2 may be embedded in the passenger seat dashboard 1600 or arranged on the passenger seat dashboard 1600. In an embodiment, the display device 2 arranged on the passenger seat dashboard 1600 may display an image related to information displayed on the cluster 1400 and/or information displayed on the center fascia 1500. In other embodiments, the display device 2 arranged on the passenger seat dashboard 1600 may display information different from information displayed on the cluster 1400 and/or information displayed on the center fascia 1500.

[Manufacturing method]

Respective layers included in the hole transport region, the emission layer, and respective layers included in the electron transport region may be formed in a certain region by using various methods such as vacuum deposition, spin coating, casting, Langmuir-Blodgett (LB) deposition, ink-jet printing, laser-printing, laser-induced thermal imaging (LITI), etc.

In case that respective layers included in the hole transport region, the emission layer, and respective layers included in the electron transport region may be formed by vacuum deposition, the deposition may be performed at a deposition temperature in a range of about 100 °C to about 500 °C, a vacuum degree in a range of about $10^{-8}$ torr to about $10^{-3}$ torr, and a deposition speed in a range of about 0.01 Å/sec (0.001nm/s) to about 100 Å/sec (10nm/s), depending on a material to be included in a layer to be formed and the structure of a layer to be formed.

[Definitions of Terms]

The term "$C_3$-$C_{60}$ carbocyclic group" as used herein may be a cyclic group consisting of carbon atoms as the only ring-forming atoms and having 3 to 60 carbon atoms. The term "$C_1$-$C_{60}$ heterocyclic group" as used herein may be a cyclic group that has 1 to 60 carbon atoms and further includes, in addition to a carbon atom, at least one heteroatom as a ring-forming atom. The $C_3$-$C_{60}$ carbocyclic group and the $C_1$-$C_{60}$ heterocyclic group may each be a monocyclic group consisting of one ring or a polycyclic group in which two or more rings may be condensed with each other. For example, a $C_1$-$C_{60}$ heterocyclic group may have 3 to 61 ring-forming atoms.

The term "cyclic group" as used herein may be a $C_3$-$C_{60}$ carbocyclic group or a $C_1$-$C_{60}$ heterocyclic group.

The term "n electron-rich $C_3$-$C_{60}$ cyclic group" as used herein may be a cyclic group that has 3 to 60 carbon atoms and may not include *-N=*' as a ring-forming moiety. The term "n electron-deficient nitrogen-containing $C_1$-$C_{60}$ cyclic group" as used herein may be a heterocyclic group that has 1 to 60 carbon atoms and may include *-N=*' as a ring-forming moiety.

In embodiments,

a $C_3$-$C_{60}$ carbocyclic group may be a T1 group or a group in which two or more T1 groups may be condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

a $C_1$-$C_{60}$ heterocyclic group may be a T2 group, a group in which two or more T2 groups may be condensed with each other, or a group in which one or more T2 groups and one or more T1 groups may be condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine

group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

a n electron-rich $C_3$-$C_{60}$ cyclic group may be a T1 group, a group in which two or more T1 groups may be condensed with each other, a T3 group, a group in which two or more T3 groups may be condensed with each other, or a group in which one or more T3 groups and one or more T1 groups may be condensed with each other (for example, a $C_3$-$C_{60}$ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.), and

a n electron-deficient nitrogen-containing $C_1$-$C_{60}$ cyclic group may be a T4 group, a group in which two or more T4 groups may be condensed with each other, a group in which one or more T4 groups and one or more T1 groups may be condensed with each other, a group in which one or more T4 groups and one or more T3 groups may be condensed with each other, or a group in which one or more T4 groups, one or more T1 groups, and one or more T3 groups may be condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.), wherein

a T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,

a T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

a T3 group may be a furan group, a thiophene group, a 1H-pyrrole group, a silole group, or a borole group, and

a T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group", "$C_3$-$C_{60}$ carbocyclic group", "$C_1$-$C_{60}$ heterocyclic group", "n electron-rich $C_3$-$C_{60}$ cyclic group", and "n electron-deficient nitrogen-containing $C_1$-$C_{60}$ cyclic group" as used herein may each be a group condensed to any cyclic group, a monovalent group, or a polyvalent group (for example, a divalent group, a trivalent group, a tetravalent group, etc.) according to the structure of a formula for which the corresponding term may be used. For example, a "benzene group" may be a benzo group, a phenyl group, a phenylene group, etc., which may be readily understood by one of ordinary skill in the art according to the structure of a formula including the "benzene group."

Examples of a monovalent $C_3$-$C_{60}$ carbocyclic group or a monovalent $C_1$-$C_{60}$ heterocyclic group may include a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group. Examples of a divalent $C_3$-$C_{60}$ carbocyclic group or a

divalent $C_1$-$C_{60}$ heterocyclic group may include a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a divalent non-aromatic condensed heteropolycyclic group.

The term "$C_1$-$C_{60}$ alkyl group" as used herein may be a linear or branched aliphatic hydrocarbon monovalent group that has 1 to 60 carbon atoms, and examples thereof may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, etc. The term "$C_1$-$C_{60}$ alkylene group" as used herein may include a divalent group having a same structure as the $C_1$-$C_{60}$ alkyl group.

The term "$C_2$-$C_{60}$ alkenyl group" as used herein may be a monovalent hydrocarbon group having one or more carbon-carbon double bonds in the middle or at a terminus of a $C_2$-$C_{60}$ alkyl group, and examples thereof may include an ethenyl group, a propenyl group, a butenyl group, etc. The term "$C_2$-$C_{60}$ alkenylene group" as used herein may be a divalent group having a same structure as the $C_2$-$C_{60}$ alkenyl group.

The term "$C_2$-$C_{60}$ alkynyl group" as used herein may be a monovalent hydrocarbon group having one or more carbon-carbon triple bonds in the middle or at a terminus of a $C_2$-$C_{60}$ alkyl group, and examples thereof may include an ethynyl group, a propynyl group, etc. The term "$C_2$-$C_{60}$ alkynylene group" as used herein may be a divalent group having a same structure as the $C_2$-$C_{60}$ alkynyl group.

The term "$C_1$-$C_{60}$ alkoxy group" as used herein may be a monovalent group represented by -O($A_{101}$) (wherein $A_{101}$ may be a $C_1$-$C_{60}$ alkyl group), and examples thereof may include a methoxy group, an ethoxy group, an isopropyloxy group, etc.

The term "$C_3$-$C_{10}$ cycloalkyl group" as used herein may be a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, etc. The term "$C_3$-$C_{10}$ cycloalkylene group" as used herein may include a divalent group having a same structure as the $C_3$-$C_{10}$ cycloalkyl group.

The term "$C_1$-$C_{10}$ heterocycloalkyl group" as used herein may be a monovalent cyclic group having 1 to 10 carbon atoms, further including, in addition to carbon atoms, at least one heteroatom as ring-forming atoms, and examples thereof may include a 1,2,3,4-oxatriazolidinyl group, a tetrahydrofuranyl group, a tetrahydrothiophenyl group, etc. The term "$C_1$-$C_{10}$ heterocycloalkylene group" as used herein may be a divalent group having a same structure as the $C_1$-$C_{10}$ heterocycloalkyl group.

The term "$C_3$-$C_{10}$ cycloalkenyl group" as used herein may be a monovalent cyclic group that has 3 to 10 carbon atoms and at least one carbon-carbon double bond in the cyclic structure thereof and no aromaticity, and examples thereof may include a cyclopentenyl group, a cyclohexenyl group, a cycloheptenyl group, etc. The term "$C_3$-$C_{10}$ cycloalkenylene group" as used herein may be a divalent group having a same structure as the $C_3$-$C_{10}$ cycloalkenyl group.

The term "$C_1$-$C_{10}$ heterocycloalkenyl group" as used herein may be a monovalent cyclic group having 1 to 10 carbon atoms, further including, in addition to carbon atoms, at least one heteroatom as ring-forming atoms, and having at least one carbon-carbon double bond in the cyclic structure thereof. Examples of a $C_1$-$C_{10}$ heterocycloalkenyl group may include a 4,5-dihydro-1,2,3,4-oxatriazolyl group, a 2,3-dihydrofuranyl group, a 2,3-dihydrothiophenyl group, etc. The term "$C_1$-$C_{10}$ heterocycloalkenylene group" as used herein may be a divalent group having a same structure as the $C_1$-$C_{10}$ heterocycloalkenyl group.

The term "$C_6$-$C_{60}$ aryl group" as used herein may be a monovalent group having a carbocyclic aromatic system of 6 to 60 carbon atoms, and the term "$C_6$-$C_{60}$ arylene group" as used herein may be a divalent group having a carbocyclic aromatic system of 6 to 60 carbon atoms. Examples of a $C_6$-$C_{60}$ aryl group may include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, etc. In case that the $C_6$-$C_{60}$ aryl group and the $C_6$-$C_{60}$ arylene group each include two or more rings, the respective rings may be condensed with each other.

The term "$C_1$-$C_{60}$ heteroaryl group" as used herein may be a monovalent group having a heterocyclic aromatic system of 1 to 60 carbon atoms, further including, in addition to carbon atoms, at least one heteroatom as ring-forming atoms. The term "$C_1$-$C_{60}$ heteroarylene group" as used herein may be a divalent group having a heterocyclic aromatic system of 1 to 60 carbon atoms, further including, in addition to carbon atoms, at least one heteroatom as ring-forming atoms. Examples of a $C_1$-$C_{60}$ heteroaryl group may include a pyridinyl group, a pyrimidinyl group, a pyrazinyl group, a

pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, etc. In case that the $C_1$-$C_{60}$ heteroaryl group and the $C_1$-$C_{60}$ heteroarylene group each include two or more rings, the respective rings may be condensed with each other.

The term "monovalent non-aromatic condensed polycyclic group" as used herein may be a monovalent group (for example, having 8 to 60 carbon atoms) having two or more rings condensed to each other, only carbon atoms as ring-forming atoms, and no aromaticity in its molecular structure as a whole. Examples of a monovalent non-aromatic condensed polycyclic group may include an indenyl group, a fluorenyl group, a spiro-bifluorenyl group, a benzofluorenyl group, an indenophenanthrenyl group, an indeno anthracenyl group, etc. The term "divalent non-aromatic condensed polycyclic group" as used herein may be a divalent group having a same structure as the monovalent non-aromatic condensed polycyclic group.

The term "monovalent non-aromatic condensed heteropolycyclic group" as used herein may be a monovalent group (for example, having 1 to 60 carbon atoms) having two or more rings condensed to each other, further including, in addition to carbon atoms, at least one heteroatom as ring-forming atoms, and having no aromaticity in its molecular structure as a whole. Examples of a monovalent non-aromatic condensed heteropolycyclic group may include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, etc. The term "divalent non-aromatic condensed heteropolycyclic group" as used herein may be a divalent group having a same structure as the monovalent non-aromatic condensed heteropolycyclic group.

The term "$C_6$-$C_{60}$ aryloxy group" as used herein may be a group represented by $-O(A_{102})$ (wherein $A_{102}$ may be a $C_6$-$C_{60}$ aryl group), and the term "$C_6$-$C_{60}$ arylthio group" as used herein may be a group represented by $-S(A_{103})$ (wherein $A_{103}$ may be a $C_6$-$C_{60}$ aryl group).

The term "$C_7$-$C_{60}$ arylalkyl group" as used herein may be a group represented by $-(A_{104})(A_{105})$ (wherein $A_{104}$ may be a $C_1$-$C_{54}$ alkylene group, and $A_{105}$ may be a $C_6$-$C_{59}$ aryl group), and the term $C_2$-$C_{60}$ heteroarylalkyl group" as used herein may be a group represented by $-(A_{106})(A_{107})$ (wherein $A_{106}$ may be a $C_1$-$C_{59}$ alkylene group, and $A_{107}$ may be a $C_1$-$C_{59}$ heteroaryl group).

In the specification, the group "$R_{10a}$" may be:

deuterium, -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{11})(Q_{12})(Q_{13})$, $-N(Q_{11})(Q_{12})$, $-B(Q_{11})(Q_{12})$, $-C(=O)(Q_{11})$, $- S(=O)_2(Q_{11})$, $-P(=O)(Q_{11})(Q_{12})$, or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $- P(=O)(Q_{21})(Q_{22})$, or any combination thereof; or

$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $- P(=O)(Q_{31})(Q_{32})$.

In the specification, $Q_1$ to $Q_3$, $Q_{11}$ to $Q_{13}$, $Q_{21}$ to $Q_{23}$, and $Q_{31}$ to $Q_{33}$ may each independently be: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof; a $C_7$-$C_{60}$ arylalkyl group; or a $C_2$-$C_{60}$ heteroarylalkyl group.

The term "heteroatom" as used herein may be any atom other than a carbon atom or a hydrogen atom. Examples of a heteroatom may include O, S, N, P, Si, B, Ge, Se, or any combination thereof.

In the specification, the term "Ph" refers to a phenyl group, the term "Me" refers to a methyl group, the term "Et" refers to an ethyl group, the terms "tert-Bu" and "$Bu^t$" each refers to a tert-butyl group, and the term "OMe" refers to a methoxy group.

The term "biphenyl group" as used herein may be a "phenyl group substituted with a phenyl group." For example, a "biphenyl group" may be a substituted phenyl group having a $C_6$-$C_{60}$ aryl group as a substituent.

The term "terphenyl group" as used herein may be a "phenyl group substituted with a biphenyl group". For example, a "terphenyl group" may be a substituted phenyl group having, as a substituent, a $C_6$-$C_{60}$ aryl group substituted with a $C_6$-$C_{60}$ aryl group.

In the specification, the terms "x-axis", "y-axis", and "z-axis" may not be limited to three axes in an orthogonal coordinate system (for example, a Cartesian coordinate system), and may be interpreted in a broader sense that the aforementioned three axes in an orthogonal coordinate system. For example, the x-axis, y-axis, and z-axis may be axes that are orthogonal to each other, or may be axes that are in different directions that are not orthogonal to each other.

In the specification, the symbols * and *', unless defined otherwise, each refer to a binding site to a neighboring atom in a corresponding formula or moiety.

Hereinafter, compounds according to embodiments and light-emitting devices according to embodiments will be described in detail with reference to the following synthesis examples and examples. The wording "B was used instead of A" used in describing Synthesis Examples refers to that an identical molar equivalent of B was used in place of A.

**[Examples]**

**Example 1**

A first emitting unit was formed on a first electrode of ITO/Ag/ITO (120 A/500 Å/120 Å). Specifically, Compound M20 doped with CGP59 (2 %) was deposited to a thickness of 10 nm on the first electrode to form a first hole injection layer, and Compound M20 was deposited to a thickness of about 20 nm on the first hole injection layer to form a first hole transport layer as a common layer. Afterwards, a first red emission layer was formed by depositing R1 dopant (2 %, R region) doped on Host1 to a thickness of about 40 nm to overlap a first subpixel area on the first hole transport layer, a first green emission layer was formed by depositing G1 dopant (8 %, G region) doped on a host, which may be mixed with Host2-1 and Host2-2 at a weight ratio of 1:1, to a thickness of about 35 nm to overlap a second subpixel area, and a first blue emission layer was formed by depositing B1 dopant (2 %, B region) doped on Compound BH to a thickness of about 20 nm to overlap a third subpixel area, thereby forming a first light-emitting region as a pattern layer. Afterwards, Compound ET39 was deposited to a thickness of about 10 nm to form a first electron transport layer as a common layer.

Afterwards, a charge generation unit was formed on the upper portion of the first electron transport layer. Specifically, bathophenanthroline (Bphen) doped with Li (2 %) was formed to a thickness of about 10 nm, and Compound M16 doped with CGP1 (5 %) was deposited to a thickness of about 5 nm to form a charge generation layer as a common layer.

Afterwards, a second emitting unit was formed on the charge generation layer. Specifically, Compound M16 was deposited to a thickness of about 40 nm on the charge generation layer to form a second hole transport layer as a common layer. Afterwards, Compound HT18 was deposited to a thickness of about 20 nm on the second hole transport layer to overlap the first subpixel area to form a second red emission auxiliary layer, Compound HT37 was deposited to a thickness of about 10 nm on the second hole transport layer to overlap the second subpixel area to form a second green emission auxiliary layer, and Compound HT22 was deposited to a thickness of about 10 nm on the second hole transport layer to overlap the third subpixel area to form a second blue emission auxiliary layer, thereby forming the second emission auxiliary layer as a pattern layer. Afterwards, a second light-emitting region was formed as a pattern layer on the red, green, and blue emission auxiliary layers, the second light-emitting region and the first emitting unit having a same material and a same structure. Afterwards, Compound ET37 was deposited to a thickness of about 10 nm as a common electron auxiliary layer, and Compound ET33 was deposited to a thickness of about 25 nm to form a second electron transport layer as a common layer.

Then, Mg:Ag (10 %) was deposited on the second emitting unit to form a second electrode with a thickness of about 110 Å (11nm). Afterwards, Compound CP5 was deposited to a thickness of about 60 nm on the second electrode to form a capping layer as a common layer to manufacture a light-emitting device. Each layer was formed by vacuum deposition.

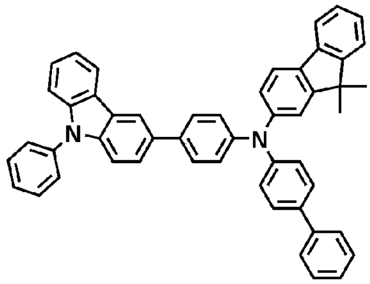

M20

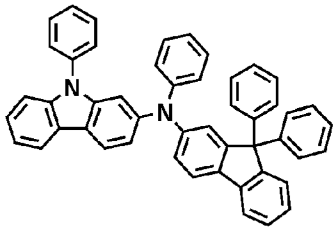

M16

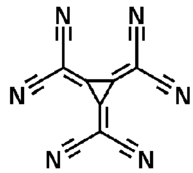

CGP59

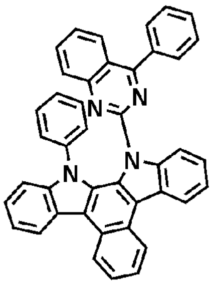

Host1

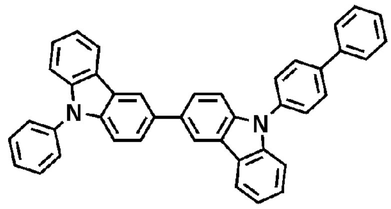

Host2-1

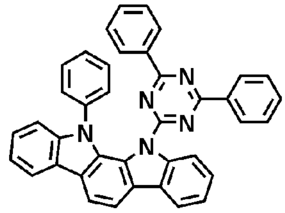

Host2-2

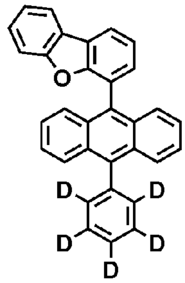

BH

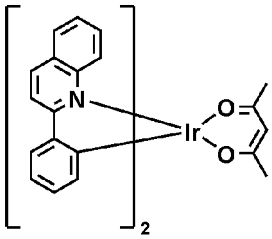

R1

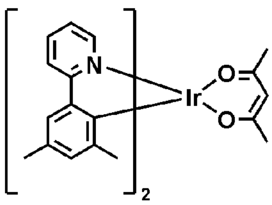

G1

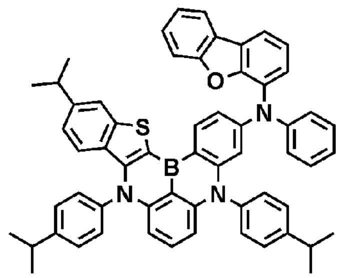

B1

**Examples 2 to 4 and Comparative Examples 1 to 4**

Light-emitting devices of Examples 2 to 4 were manufactured in the same manner as in Example 1, except that the compounds listed in Table 1 below were used as materials for the first hole injection layer and the first p-type charge generation layer.

Light-emitting devices of Comparative Examples 1 to 4 were manufactured in the same manner as in Example 1, except that the compounds listed in Table 1 below were used as materials for the first hole injection layer and the first p-type charge generation layer, and Compound M16 was deposited to the same thickness as the second emission auxiliary layer instead of forming the second emission auxiliary layer in the second emitting unit.

**Evaluation Example 1: Evaluation of characteristics of light-emitting device**

In case that the patterned light-emitting devices manufactured in Examples 1 to 3 and Comparative Examples 1 to 4 were driven in red, green, and blue colors, respectively, the turn-on voltage ($V_{on}$) at 1 nit, the driving voltage at 1,000 nit (V @1,000 nit), luminescence efficiency, electroluminescence (EL) spectrum and lifetime ($T_{95}$) were each measured by using a Keithley SMU 236 and a luminometer PR650 Spectroscan Source Measurement Part. (PhotoResearch), and the results are shown in Table 1 below as relative values. The resistivity in the lateral direction of the first hole injection layer was measured for each of the light-emitting devices of Example 4 and Comparative Example 1, and the results are shown in Table 2 below.

$T_{95}$ lifetime may be a measure of the time it takes for luminance to decrease to 95 % in case that the initial luminance is set to 100 % under a current density of 10 mA/cm$^2$. The measured EL spectrum was normalized to evaluate whether color mixing occurred as follows, and the results are shown in Table 1 below.

Evaluation criteria for whether color mixing occurs

X: No color mixing occurs
△: A weak color mixing peak with an intensity of less than 0.1 occurs
◦: A color mixing peak with an intensity of 0.1 to 0.2 occurs
◎: A strong color mixing peak with an intensity of more than 0.2 occurs

[Table 1]

| No. | | First hole injection layer | First p-type charge generation layer | Von | V @1,000 nit | Luminescence efficiency (relative value) | $T_{95}$ (relative value) | Whether color mixing occurs |
|---|---|---|---|---|---|---|---|---|
| Example 1 | R | M20:CGP 59 | M16:CGP59 | 5.1 | 5.9 | 105 % | 160 % | X |
| | G | | | 5.3 | 6.0 | 110 % | 160 % | X |
| | B | | | 5.9 | 7.0 | 110 % | 180 % | Δ |
| Example 2 | R | M20:CGP 59 | M16:CGP28 | 5.2 | 6.0 | 107 % | 210% | X |
| | G | | | 5.3 | 6.0 | 107 % | 180 % | X |
| | B | | | 6.1 | 6.9 | 105 % | 180 % | Δ |
| Example 3 | R | M20:CGP 28 | M16:CGP59 | 5.2 | 6.0 | 107 % | 180 % | X |
| | G | | | 5.4 | 6.3 | 107 % | 170 % | X |
| | B | | | 6.1 | 7.1 | 105 % | 160 % | Δ |
| Example 4 | R | M20:CGP 28 | M16:CGP28 | 5.1 | 5.9 | 108 % | 210% | X |
| | G | | | 5.2 | 6.2 | 110 % | 180 % | X |
| | B | | | 5.8 | 7.0 | 110 % | 200 % | Δ |
| Comparative Example 1 | R | HATCN | HATCN | 5.7 | 6.7 | 95 % | 80 % | X |
| | G | | | 6.1 | 6.8 | 95 % | 75% | OO |
| | B | | | 7.0 | 7.9 | 93 % | 60 % | ◎ |
| Comparative Example 2 | R | F4-TCNQ | F4-TCNQ | 5.5 | 6.4 | 97 % | 70 % | X |
| | G | | | 5.8 | 6.8 | 96 % | 70 % | OO |
| | B | | | 6.6 | 7.8 | 90 % | 60 % | ◎ |
| Comparative Example 3 | R | NPB:F4-TCNQ | NPB:F4-TCNQ | 5.2 | 5.9 | 100 % | 100 % | X |
| | G | | | 5.6 | 6.5 | 100 % | 100 % | ○ |
| | B | | | 6.7 | 7.5 | 100 % | 100 % | ◎ |
| Comparative Example 4 | R | NPB:CGP 59 | NPB:CGP28 | 5.5 | 6.3 | 100 % | 110 % | X |
| | G | | | 5.8 | 6.5 | 102 % | 100 % | ○ |
| | B | | | 6.6 | 7.3 | 100 % | 120% | ○ |

[Table 2]

| No. | | Resistivity in the lateral direction |
|---|---|---|
| Example 4 | First hole injection layer HT1:CGP28 (10 nm, 2%) | $5.8 \times 10^4$ Ωm |
| | First p-type charge generation layer HT2:CGP28 (5 nm, 5%) | $3.7 \times 10^4$ Ωm |
| Comparative Example 1 | HAT-CN | $>10^2$ Ωm |

Referring to Table 1, it was found that the light-emitting device of Examples 1 to 4 had a driving voltage of the same

level or lower than that of the light-emitting devices of Comparative Examples 1 to 4, had significantly excellent luminescence efficiency and lifetime characteristics, and almost no color mixing between subpixels occurred.

Referring to Table 2, it was confirmed that the light-emitting device of Example 4 had a significantly higher resistivity in the lateral direction compared to that of the light-emitting device of Comparative Example 1, and accordingly, the generation of lateral leakage current was greatly reduced, thereby decreasing the occurrence of color mixing between subpixels.

According to the one or more embodiments, a light-emitting device has reduced leakage current, and excellent efficiency, color purity, and lifetime characteristics, and can be used to manufacture a high-quality electronic apparatus and consumer product.

It should be understood that embodiments described herein should be considered in a descriptive sense only and not for purposes of limitation. Descriptions of features or aspects in each embodiment should typically be considered as available for other similar features or aspects in other embodiments. While one or more embodiments have been described with reference to the figures, it will be understood by those of ordinary skill in the art that various changes in form and details may be made therein without departing from the scope of the invention as defined by the following claims.

## Claims

**1.** A light-emitting device comprising:

a first electrode;
a second electrode facing the first electrode; and
an interlayer located between the first electrode and the second electrode, wherein the interlayer comprises:

m emitting units; and
m-1 charge generation units located between two adjacent emitting units among the m emitting units,

m is an integer of at least 2,
at least one of the m emitting units comprises a first subpixel and a second subpixel, and
the first subpixel and the second subpixel satisfy Inequality 1:

[Inequality 1]

$$V_{on2} - V_{on1} \leq 0.2\ V$$

wherein in Inequality 1,
$V_{on1}$ is a turn-on voltage of the first subpixel,
$V_{on2}$ is a turn-on voltage of the second subpixel,
the turn-on voltage of the first subpixel is a voltage applied to the first subpixel in the case that a luminance of the first subpixel is 1 nit, and
the turn-on voltage of the second subpixel is a voltage applied to the second subpixel in the case that a luminance of the second subpixel is 1 nit.

**2.** The light-emitting device of claim 1, wherein the maximum emission wavelength of the first subpixel is longer than the maximum emission wavelength of the second subpixel.

**3.** The light-emitting device of claim 1 or 2, wherein the first subpixel and the second subpixel satisfy Inequality 2:

[Inequality 2]

$$V_{on2} - V_{on1} < 0.2\ V.$$

**4.** The light-emitting device of claim 1, 2 or 3, wherein the distance between the first subpixel and the second subpixel is in a range of about 10 μm to about 35 μm.

**5.** The light-emitting device of any one of the preceding claims, wherein the at least one of the m emitting units further comprises a third subpixel, and the second subpixel and the third subpixel satisfy Inequality 3:

[Inequality 3]

$$V_{on3} - V_{on2} \leq 0.2\ V$$

wherein in Inequality 3,

$V_{on3}$ is a turn-on voltage of the third subpixel,
and
the turn-on voltage of the third subpixel is a voltage applied to the third subpixel in the case that a luminance of the third subpixel is 1 nit.

**6.** The light-emitting device of claim 5, wherein the maximum emission wavelength of the second subpixel is longer than the maximum emission wavelength of the third subpixel.

**7.** The light-emitting device of claim 5 or 6, wherein

the first subpixel is a red subpixel,
the second subpixel is a green subpixel, and
the third subpixel is a blue subpixel.

**8.** The light-emitting device of any one of the preceding claims, wherein

the m emitting units each comprise a first emitting unit and a second emitting unit,
the first emitting unit comprises a first light-emitting region,
the second emitting unit comprises a second light-emitting region,
the first light-emitting region and the second light-emitting region comprise the first subpixel and the second subpixel, respectively,
the m-1 charge generation units comprise a first charge generation unit, and
the first charge generation unit comprises a first n-type charge generation layer and a first p-type charge generation layer.

**9.** The light-emitting device of claim 8, wherein

the first emitting unit further comprises a first hole transport region located between the first electrode and the first light-emitting region,
the first hole transport region and the first p-type charge generation layer each comprise a charge-generating dopant, and
the charge-generating dopant satisfies Inequality 11:

[Inequality 11]

$$LUMO(CGD) < -5.0\ eV$$

wherein in Inequality 11,
LUMO(CGD) is the lowest unoccupied molecular orbital (LUMO) energy level of the charge-generating dopant.

**10.** The light-emitting device of claim 9, wherein

the first hole transport region comprises a first hole injection layer in direct contact with the first electrode, and the content of the charge-generating dopant in the first hole injection layer is at least twice the content of the charge-generating dopant in the first p-type charge generation layer, or
the thickness of the first hole injection layer is at least twice the thickness of the first p-type charge generation layer of the first charge generation unit.

**11.** The light-emitting device of claim 8, 9 or 10, wherein

the first subpixel of the second light-emitting region comprises a second red emission layer,
the second subpixel of the second light-emitting region comprises a second green emission layer, and

the second light-emitting region further comprises a second emission auxiliary layer in direct contact with the second red emission layer.

**12.** The light-emitting device of claim 12, wherein the second emission auxiliary layer is in direct contact with the first p-type charge generation layer.

**13.** The light-emitting device of any one of the preceding claims, wherein

the first subpixel and the second subpixel each comprise an emission layer,
the emission layer comprises a host and a dopant, and
the content of the host is greater than the content of the dopant based on a weight of the emission layer.

**14.** The light-emitting device of claim 14, wherein the dopant is a fluorescent dopant, a phosphorescent dopant, a delayed fluorescence dopant, or any combination thereof.

**15.** The light-emitting device of any one of the preceding claims, wherein

each of the m emitting units further comprises a hole transport region and/or an electron transport region,
the hole transport region comprises at least one selected from a hole injection layer, a hole transport layer, a buffer layer, an emission auxiliary layer, and an electron blocking layer, and
the electron transport region comprises at least one selected from a hole blocking layer, an electron transport layer, and an electron injection layer.

FIG. 1

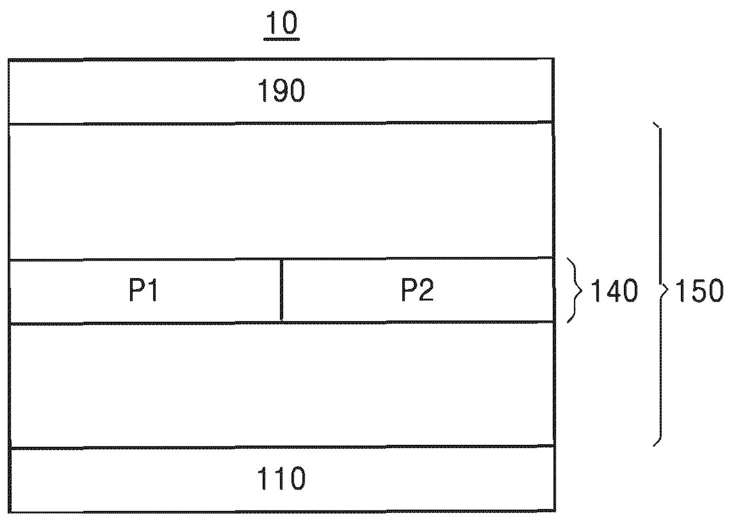
10
190
P1
P2
140
150
110

FIG. 2

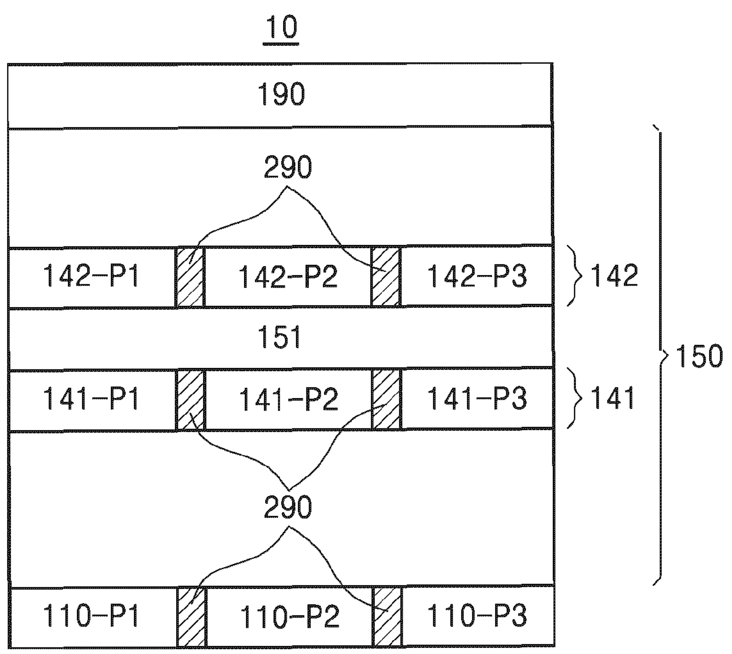
10
190
290
142-P1
142-P2
142-P3
142
151
150
141-P1
141-P2
141-P3
141
290
110-P1
110-P2
110-P3

FIG. 3

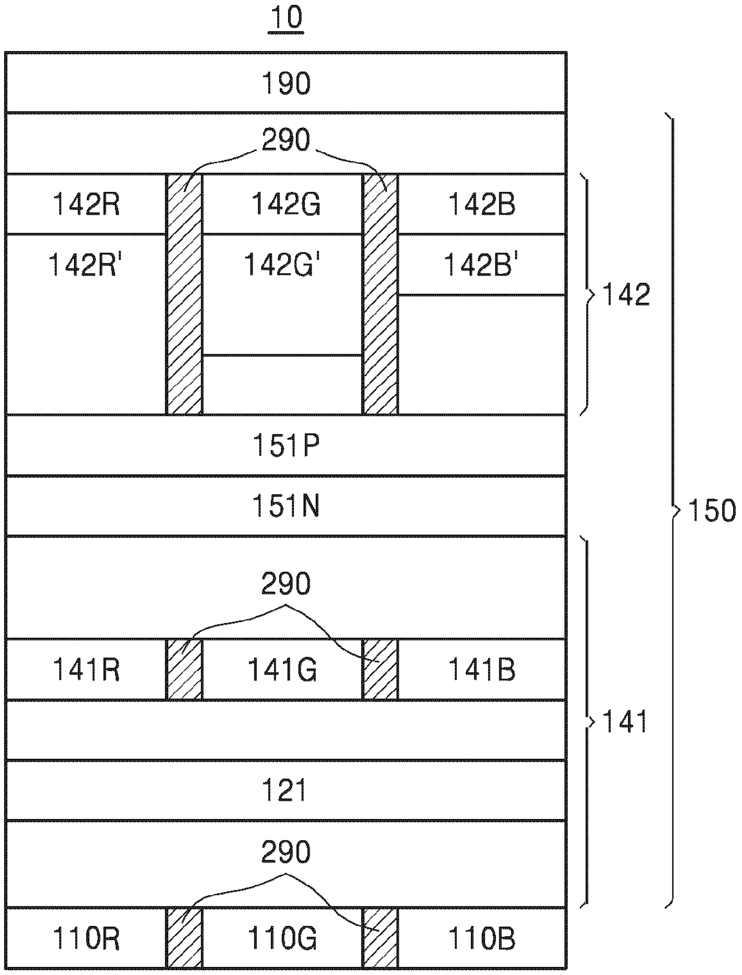
10
190
290
142R
142G
142B
142R'
142G'
142B'
142
151P
151N
150
290
141R
141G
141B
141
121
290
110R
110G
110B

FIG. 4

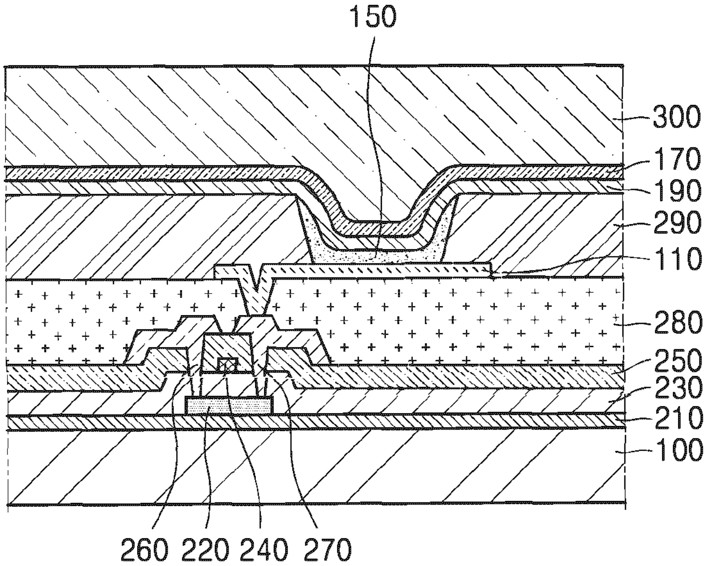

FIG. 5

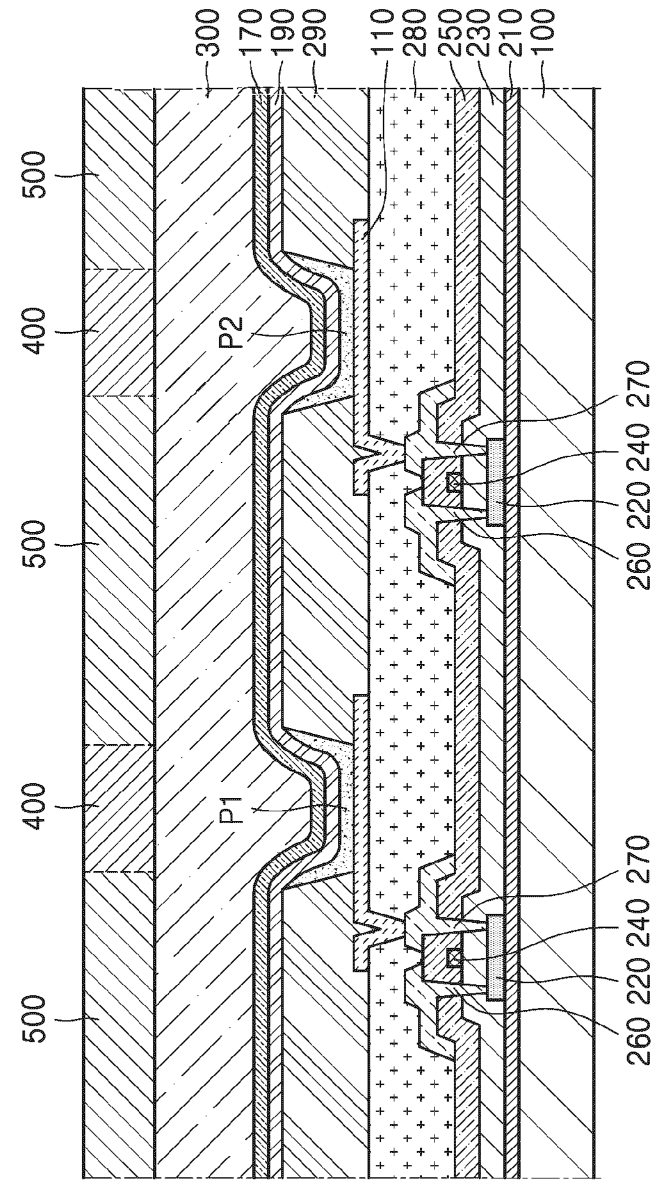

300
170
190
290
110
280
250
230
210
100
500
400
500
400
500
P2
P1
270
240
220
260
270
240
220
260

FIG. 6

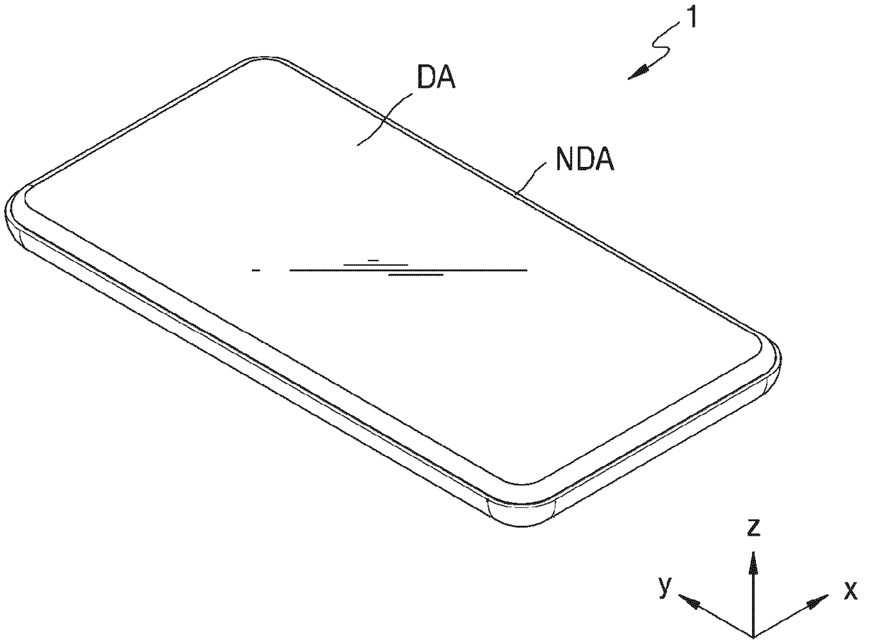


FIG. 7

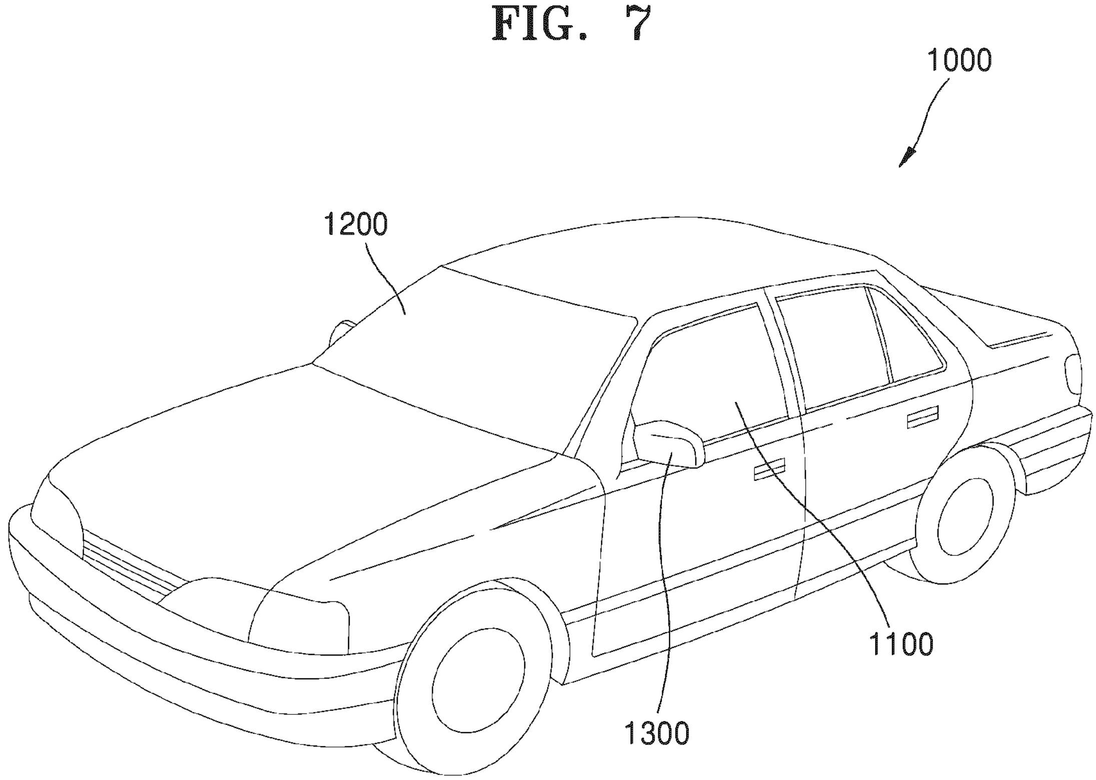

FIG. 8A

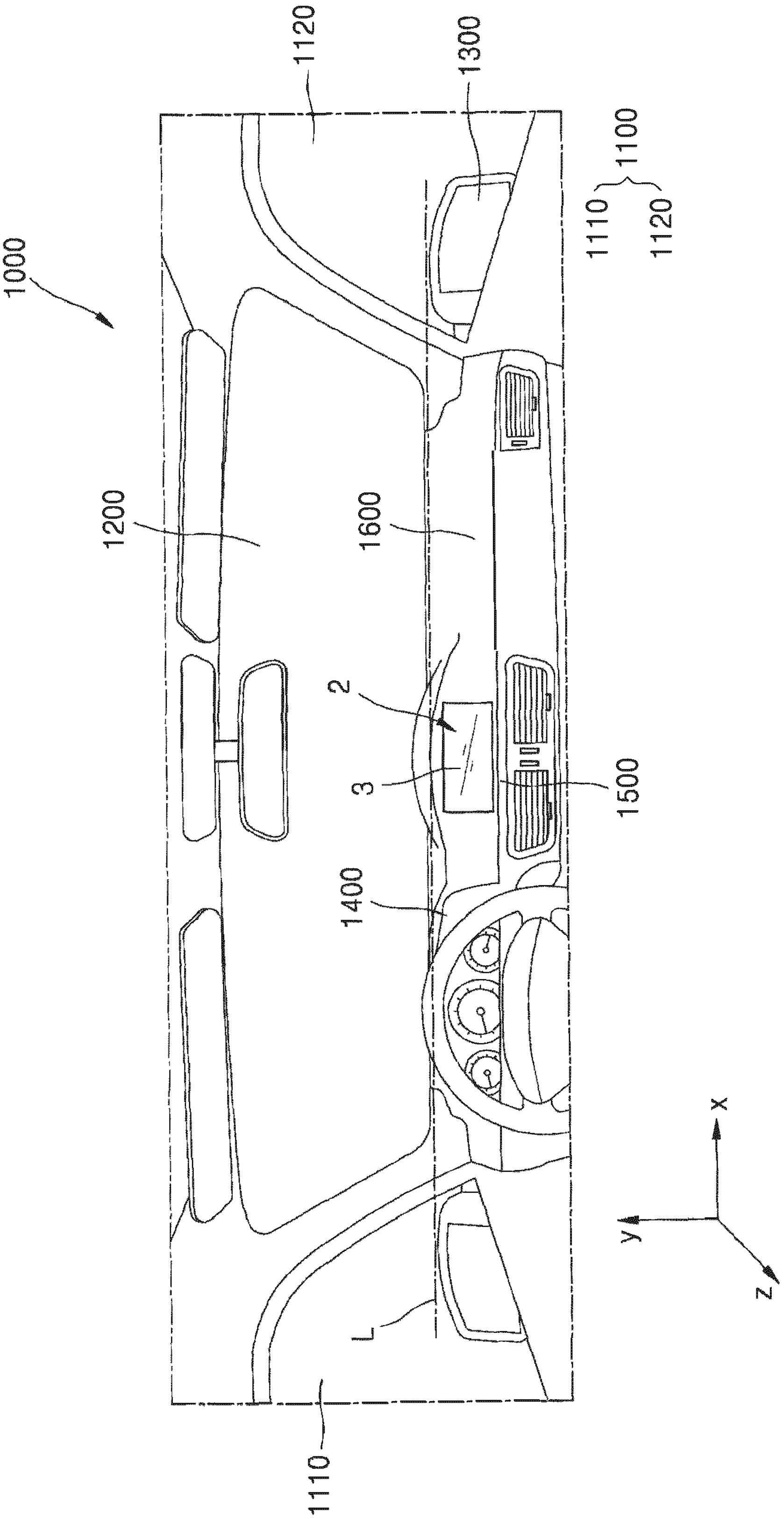
1000
1120
1300
1110
1100
1120
1200
1600
2
3
1500
1400
L
1110
x
y
z

FIG. 8B

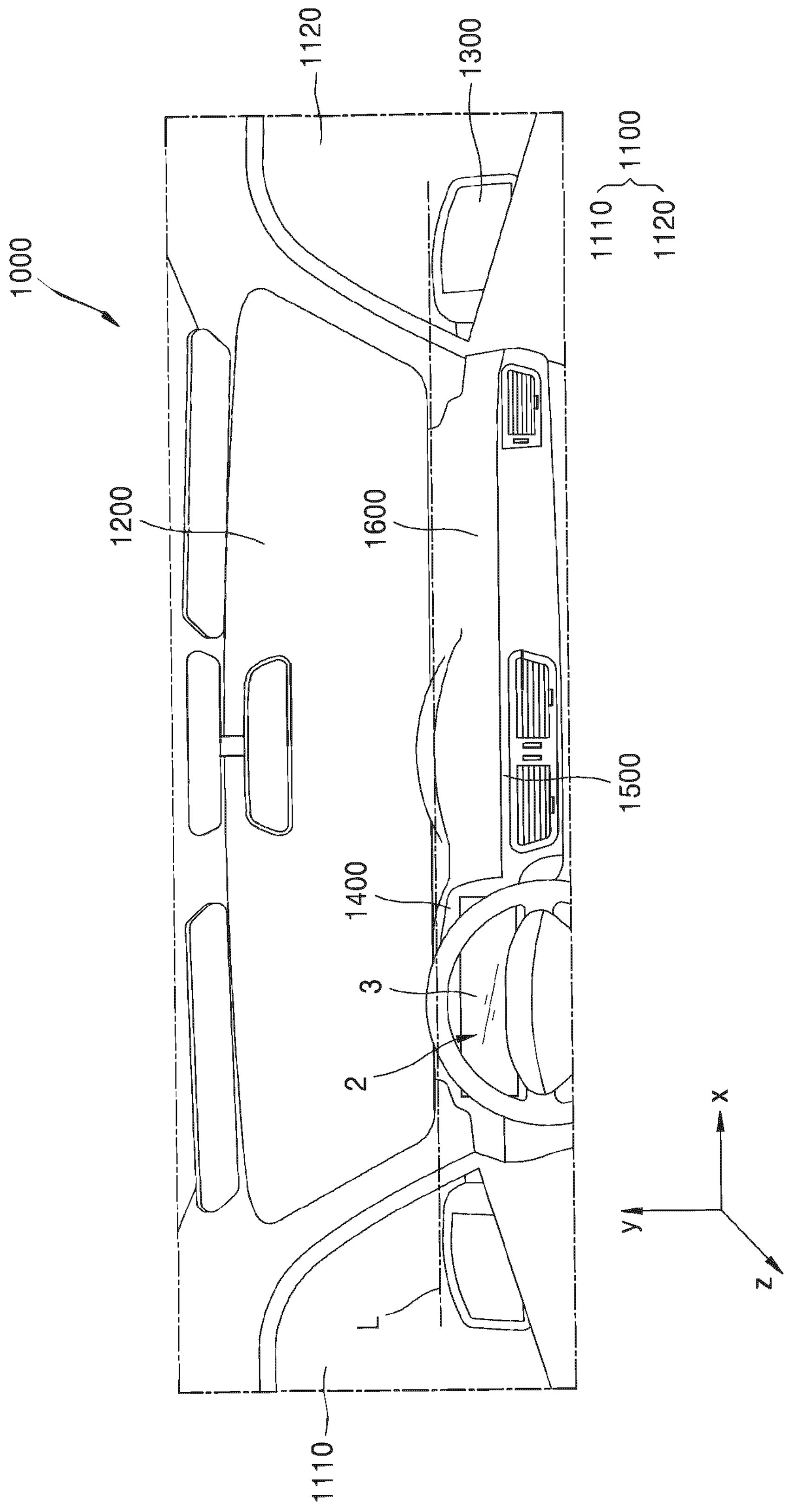
1000
1120
1300
1110
1100
1120
1200
1600
1500
1400
3
2
L
1110
x
y
z

FIG. 8C

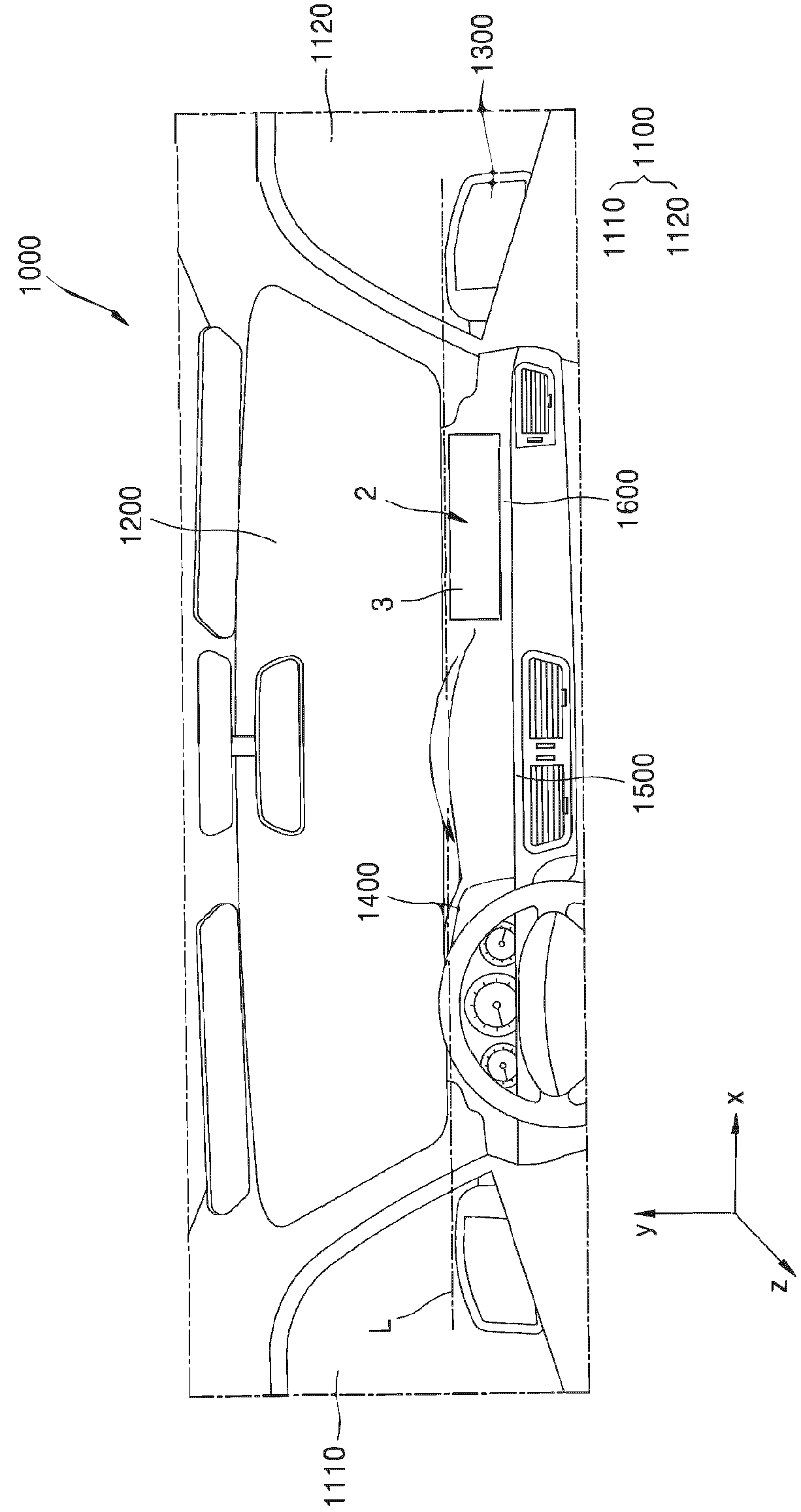
1000
1120
1300
1110
1100
1120
1200
2
3
1600
1500
1400
L
1110
x
y
z

Europäisches Patentamt
European Patent Office
Office européen des brevets

# EUROPEAN SEARCH REPORT

Application Number
EP 24 22 3027

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | CN 115 295 596 A (KUNSHAN GOVISIONOX OPTOELECTRONICS CO LTD) 4 November 2022 (2022-11-04)<br>* paragraph [0061]; figures 2-4, 8-10 * | 1-10, 13-15<br>11,12 | INV.<br>H10K50/19<br>H10K59/32 |
| X<br>Y | US 2017/194386 A1 (XIONG ZHIYONG [CN] ET AL) 6 July 2017 (2017-07-06)<br>* paragraph [0062]; figures 1,3, 12,17 * | 1-10, 13-15<br>11,12 | |
| Y | WO 2023/226796 A1 (BOE TECHNOLOGY GROUP CO LTD [CN]; CHENGDU BOE OPTOELECT TECH CO [CN]) 30 November 2023 (2023-11-30)<br>* page 3 - page 6; figures 1-8 * | 11,12 | |
| Y | US 2015/333296 A1 (LEE SEHEE [KR]) 19 November 2015 (2015-11-19)<br>* paragraph [0079] - paragraph [0213]; figures 3-7 * | 11,12 | |
| | | | TECHNICAL FIELDS SEARCHED (IPC) |
| | | | H10K |

The present search report has been drawn up for all claims

| Place of search | Date of completion of the search | Examiner |
|---|---|---|
| Munich | 13 May 2025 | Bernabé Prieto, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

3

EPO FORM 1503 03.82 (P04C01)

## ANNEX TO THE EUROPEAN SEARCH REPORT ON EUROPEAN PATENT APPLICATION NO. EP 24 22 3027

This annex lists the patent family members relating to the patent documents cited in the above-mentioned European search report. The members are as contained in the European Patent Office EDP file on
The European Patent Office is in no way liable for these particulars which are merely given for the purpose of information.

13-05-2025

| Patent document cited in search report | Publication date | Patent family member(s) | Publication date |
|---|---|---|---|
| CN 115295596 A | 04-11-2022 | CN 115295596 A | 04-11-2022 |
| | | US 2025143070 A1 | 01-05-2025 |
| | | WO 2024036741 A1 | 22-02-2024 |
| US 2017194386 A1 | 06-07-2017 | CN 105428391 A | 23-03-2016 |
| | | DE 102016215715 A1 | 06-07-2017 |
| | | US 2017194386 A1 | 06-07-2017 |
| WO 2023226796 A1 | 30-11-2023 | CN 114975813 A | 30-08-2022 |
| | | US 2024423009 A1 | 19-12-2024 |
| | | WO 2023226796 A1 | 30-11-2023 |
| US 2015333296 A1 | 19-11-2015 | KR 20150131854 A | 25-11-2015 |
| | | US 2015333296 A1 | 19-11-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020230193389